# EUROPÄISCHE PATENTSCHRIFT

(11) **EP 4 205 191 B1**
(45) Veröffentlichungstag und Bekanntmachung des Hinweises auf die Patenterteilung: **22.04.2026**
(21) Anmeldenummer: 21786757.1
(22) Anmeldetag: 31.08.2021
(51) Int. Cl.: H10K 85/30, H10K 85/60, H10K 30/30

(54) **CHEMISCHE VERBINDUNG, VERWENDUNG MINDESTENS EINER SOLCHEN CHEMISCHEN VERBINDUNG IN EINEM OPTOELEKTRONISCHEN BAUELEMENT, UND OPTOELEKTRONISCHES BAUELEMENT MIT MINDESTENS EINER SOLCHEN CHEMISCHEN VERBINDUNG**
CHEMICAL COMPOUND, USE OF AT LEAST ONE SUCH CHEMICAL COMPOUND IN AN OPTOELECTRONIC COMPONENT, AND OPTOELECTRONIC COMPONENT CONTAINING AT LEAST ONE SUCH CHEMICAL COMPOUND
COMPOSÉ CHIMIQUE, UTILISATION D'AU MOINS UN TEL COMPOSÉ CHIMIQUE DANS UN COMPOSANT OPTOÉLECTRONIQUE ET COMPOSANT OPTOÉLECTRONIQUE CONTENANT AU MOINS UN TEL COMPOSÉ CHIMIQUE

(30) Priorität: 31.08.2020 DE 102020122729
(43) Veröffentlichungstag der Anmeldung: 05.07.2023
(73) Patentinhaber: Heliatek GmbH, 01139 Dresden (DE); Technische Universität Dresden, 01062 Dresden (DE)
(72) Erfinder: ANDERNACH, Rolf, 89077 Ulm (DE); COUTABLE, Ludovic, 89077 Ulm (DE); FITZNER, Roland, 89077 Ulm (DE); GUTKOWSKI, Krzysztof, 89077 Ulm (DE); HILDEBRANDT, Dirk, 89077 Ulm (DE); MINDAUGAS, Kirkus, 89077 Ulm (DE); WEISS, Andre, 01139 Dresden (DE); PAPMEYER, Marcus, 01683 Nossen (DE); DOROK, Sascha, 01157 Dresden (DE)
(86) Internationale Anmeldenummer: PCT/DE2021/100721
(87) Internationale Veröffentlichungsnummer: WO 2022/042804

(56) Entgegenhaltungen:
- EP-B1- 3 816 168
- WO-A1-2010/104875
- YANG YONGCHAO ET AL: "Thienopyrrole-expanded BODIPY as a potential NIR photosensitizer for photodynamic therapy", CHEMICAL COMMUNICATIONS, vol. 49, no. 38, 1 January 2013 (2013-01-01), UK, pages 3940, XP055865511, ISSN: 1359-7345, DOI: 10.1039/c3cc40746b
- SHIMOGAWA HIROYUKI ET AL: "Impacts of Dibenzo- and Dithieno-fused Structures at the b , g Bonds in the BODIPY Skeleton", CHEMISTRY LETTERS, vol. 42, no. 9, 5 September 2013 (2013-09-05), JP, pages 986 - 988, XP055865501, ISSN: 0366-7022, Retrieved from the Internet <URL:http://dx.doi.org/10.1246/cl.130360> DOI: 10.1246/cl.130360
- JIONG CHEN ET AL: "4,4-Difluoro-4-bora-3a,4a-diaza-s-indacene (BODIPY) Dyes Modified for Extended Conjugation and Restricted Bond Rotations", THE JOURNAL OF ORGANIC CHEMISTRY, AMERICAN CHEMICAL SOCIETY, vol. 65, 19 May 2000 (2000-05-19), pages 2900 - 2906, XP002580824, ISSN: 0022-3263, [retrieved on 20000418], DOI: 10.1021/JO991927O

## Beschreibung

Die vorliegende Erfindung betrifft eine chemische Verbindung der allgemeinen Formel I, die Verwendung mindestens einer solchen Verbindung in einem optoelektronischen Bauelement, und ein optoelektronisches Bauelement mit mindestens einer solchen Verbindung.

In der organischen Elektronik werden Verschaltungen aus elektrisch leitfähigen Polymeren oder kleinen organischen Molekülen verwendet. Organische Halbleiter können in einem elektronischen Bauelement verschiedene Funktionen erfüllen, wie z.B. Ladungstransport, Strahlungsabsorption oder Strahlungsemission, wobei ein oder mehrere Funktionen gleichzeitig erfüllt werden können. Optoelektronische Bauelemente können beispielsweise Displays, Datenspeicher oder Transistoren sein, aber auch organische optoelektronische Bauelemente, beispielsweise photovoltaische Elemente, insbesondere Solarzellen, und Photodetektoren, die eine photoaktive Schicht aufweisen, in der bei Einfall elektromagnetischer Strahlung Ladungsträger, insbesondere gebundene Elektronen-Loch-Paare (Exzitonen), erzeugt werden. Die Exzitonen gelangen durch Diffusion an eine derartige Grenzfläche, wo Elektronen und Löcher voneinander getrennt werden. Das Material, welches die Elektronen aufnimmt wird als Akzeptor und das Material, welches die Löcher aufnimmt wird als Donor bezeichnet.

Organische optoelektronische Bauelemente ermöglichen die Umwandlung von elektromagnetischer Strahlung unter Ausnutzung des photoelektrischen Effekts in elektrischen Strom. Für eine derartige Umwandlung von elektromagnetischer Strahlung werden Absorbermaterialien benötigt, die gute Absorptionseigenschaften zeigen.

Organische optoelektronische Bauelemente sind aus dem Stand der Technik bekannt. WO2004083958A2 offenbart ein photoaktives Bauelement, insbesondere eine Solarzelle, bestehend aus organischen Schichten aus einer oder mehreren aufeinander gestapelten pi-, ni- und/oder pin-Dioden.

Ein aus dem Stand der Technik bekannter Aufbau einer organischen Solarzelle besteht in einer pin- oder nip-Diode (Martin Pfeiffer, "Controlled doping of organic vacuum deposited dye layers: basics and applications", PhD thesis TU-Dresden, 1999, und WO2011/161108A1). Eine pin-Solarzelle besteht dabei aus einem Substrat mit einer darauf angeordneten meist transparenten Elektrode, p-Schicht(en), i-Schicht(en), n-Schicht(en) und einer Gegenelektrode. Hierbei bedeutet n bzw. p eine n- bzw. p-Dotierung, die zu einer Erhöhung der Dichte freier Elektronen bzw. Löcher im thermischen Gleichgewichtszustand führt. Derartige Schichten sind primär als Transportschichten zu verstehen. Die Bezeichnung i-Schicht bezeichnet eine undotierte Schicht (intrinsische Schicht) mit einem Absorbermaterial oder einer Mischung mehrerer Absorbermaterialien. Eine oder mehrere i-Schichten können dabei aus einer Mischung zweier oder mehrerer Materialien (bulk heterojunctions) bestehen. Unter einem Absorbermaterial, also einem Absorber, wird insbesondere eine Verbindung verstanden, die Licht in einem bestimmten Wellenlängenbereich absorbiert. Unter einer Absorberschicht wird dementsprechend insbesondere eine Schicht in einem optoelektronischen Bauelement verstanden, die mindestens ein Absorbermaterial aufweist.

Aus dem Stand der Technik sind zahlreiche polymere und nicht-polymere Absorbermaterialien für organische photovoltaische Elemente im roten und nahinfraroten (NIR) Bereich zwischen ca. 600 und ca. 1400 nm bekannt. Dabei haben sich im Bereich nichtpolymerer Absorbermaterialien insbesondere Materialien der Stoffklasse der BODIPYs für den nahinfraroten Spektralbereich als geeignet erweisen, insbesondere hat sich die Verwendung meso-CF3 substituierter Derivate bewährt, wodurch geeignete Energielagen und damit hohe Photospannungen bei gleichzeitig langwelligen Abvsorptionsbereichen erzielt werden können.

WO 2015 036 529 A1 offenbart die Verwendung einer Pyrrolopyrrolbasierten Verbindung in einer Vorrichtung der organischen Elektronik.

WO 2010 133 208 A1 offenbart einen organischen Halbleiter, der mehrere Schichten umfasst, wobei zumindest eine der Schichten ein Material mit Azabodipy-Grundgerüst umfasst.

Umezawa et al. (J. Am. Chem. Soc. 2008, 130, 5, 1550-1551) offenbart BODIPY-Strukturen als Fluoreszenz-Farbstoffe, die in der meso-Position unsubstituiert sind, oder eine fluorierte Alkylkette tragen.

Li et al. (Boron dipyrromethene (BODIPY) with meso-perfluorinated alkyl substituents as near infrared donors in organic solar cells, J. Mater. Chem. A, 2018, 6, 18583-18591) offenbart BODIPY Strukturen, die in der meso-Position perfluorierte Alkylketten tragen, und als NIR-Donormaterialien in organischen Solarzellen eingesetzt werden können.

Shimogawa et al. (Chem. Lett. 2013, 42, 986-988) offenbart den Einfluss von Dibenzo- und Dithieno-anellierten Strukturen an der b,g Bindung in BODIPY-Gerüsten. Elektrochemische und photophysikalische Messungen zeigten eine effektive Erhöhung der Elektronen-anziehenden Wirkung der BODIPY-Gerüste mit einer rotverschobenen Absorption.

Chen et al. (J. Org. Chem. 2000, 65, 2900-2906) offenbart modifizierte 4,4-Difluoro-4-Bora-3a,4a-Diaza-s-Indacene (BODIPY) Farbstoffe mit erweiterter Konjugation und eingeschränkter Bindungsrotation.

WO2010104875 A1 offenbart Verbindung BDF-NIR1.

Die aus dem Stand der Technik bekannten Absorber im roten und nahinfraroten Bereich sind nicht zufriedenstellend. Die bekannten Absorbermaterialien sind zwar für photoaktive Schichten in organischen photovoltaischen Elementen, also organischen Solarzellen, geeignet, allerdings bedarf es einer Verbesserung der Absorptionseigenschaften der Absorbermaterialien, insbesondere um organische photovoltaische Elemente gegenüber herkömmlichen Solarzellen auf Siliziumbasis wettbewerbsfähig zu machen. Die Effizienz eines organischen photovoltaischen Elements hängt unter anderem vom Absorptionsverhalten der organischen Materialien, also der Absorbermaterialien, in der photoaktiven Schicht ab. Des Weiteren ist ein grundsätzliches Problem bei der Vakuumprozessierung die eingeschränkte Verdampfbarkeit organischer Materialien, da die thermische Stabilität für eine Verdampfung im Vakuum nicht ausreichend ist, wodurch die Auswahl der Absorber stark eingeschränkt wird. Durch niedrige Schmelz- und Zersetzungspunkte die Verdampfbarkeit und damit die erzielbare Abscheidungsrate eingeschränkt, so dass viele prinzipiell als Absorber geeignete Materialien nicht im industriellen Maßstab einsetzbar sind.

Der Erfindung liegt daher die Aufgabe zugrunde, chemische Verbindungen, die Verwendung mindestens einer solcher chemischen Verbindung in einem optoelektronischen Bauelement, und ein optoelektronisches Bauelement mit mindestens einer solchen Verbindung bereitzustellen, wobei die genannten Nachteile nicht auftreten, und wobei die chemischen Verbindungen insbesondere verbesserte Absorptionseigenschaften aufweisen und gleichzeitig eine verbesserte Verdampfbarkeit zeigen, also hohe Schmelz- und Zersetzungspunkte aufweisen, insbesondere niedrige Verdampfungstemperaturen ohne sich zu zersetzen.

Die Aufgabe wird durch die Gegenstände der unabhängigen Ansprüche gelöst. Vorteilhafte Ausgestaltungen ergeben sich aus den Unteransprüchen.

Die Aufgabe wird insbesondere gelöst, durch eine chemische Verbindung der allgemeinen Formel I, 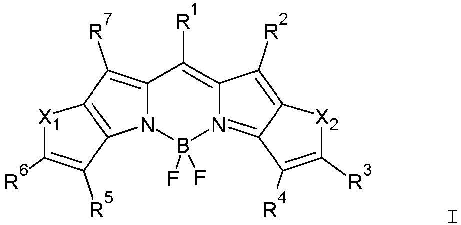 wobei
X1 und X2 unabhängig voneinander O, S oder N-R8 sind mit R8 ausgewählt aus der Gruppe bestehend aus H, Alkyl, Aryl und Heteroaryl, bevorzugt mit R8 ausgewählt aus der Gruppe bestehend aus H, Alkyl, und Aryl,
R1 ein substituierter homocyclischer 6-Ring, wobei mindestens ein H-Atom durch einen elektronenziehenden Substituenten ausgewählt aus der Gruppe bestehend aus F, Cl, CN, CF3, und COR8 mit R8 C1-C4-Alkyl substituiert ist, oder ein substituierter oder nicht-substituierter heterocyclischer 5-Ring oder 6-Ring ist, wobei der heterocyclische 5-Ring oder 6-Ring mindestens ein sp2-hybridisiertes N-Atom mit einem freien Elektronenpaar aufweist und/oder mindestens einem Heteroatom ausgewählt aus O, S, oder N aufweist, wobei mindestens ein H-Atom durch einen elektronenziehenden Substituenten ausgewählt aus der Gruppe bestehend aus F, Cl, CN, CF3, und COR9 mit R9 C1-C4-Alkyl substituiert ist,
R2 und R7 unabhängig voneinander ausgewählt sind aus der Gruppe bestehend aus H, Halogen, CN, Alkyl, fluoriertem oder teilfluoriertem Alkyl, und ungesättigtem Alkyl,
R4 und R5 unabhängig voneinander ausgewählt sind aus der Gruppe bestehend aus H, Halogen, CN, Alkyl, fluoriertem oder teilfluoriertem Alkyl, ungesättigtem Alkyl, und Alkoxy, und R3 und R6 unabhängig voneinander ein substituierter oder nicht-substituierter homocyclischer 6-Ring oder ein substituierter oder nicht-substituierter heterocyclischer 5-Ring oder 6-Ring sind.

Erfindungsgemäß sind Verbindungen der allgemeinen Formel I BODIPY-Farbstoffe, die bevorzugt in meso-Position des BODIPY-Grundgerüsts einen 5- oder 6-gliedrigen Heteroarylring, oder einen 6-gliedrigen Arylring mit mindestens einem Substituenten ausgewählt aus der Gruppe Cl, CN und F aufweisen. Bevorzugt sind die Pyrrolringe des BODIPY-Grundgerüsts mit einem weiteren zyklischen System anneliert.

Unter einer Substitution wird insbesondere der Austausch von H durch einen Substituenten verstanden. Unter einem Substituenten werden insbesondere alle Atome und Atomgruppen außer Wasserstoff verstanden, bevorzugt ein Halogen, eine Alkyl-Gruppe, dabei kann die Alkyl-Gruppe linear oder verzweigt sein, eine Alkenyl-Gruppe, eine Alkinyl-Gruppe, eine Amino-Gruppe, eine Alkoxy-Gruppe, eine Thioalkoxy-Gruppe, eine Aryl-Gruppe, oder eine Heteroaryl-Gruppe. Unter einem Halogen wird insbesondere F, Cl oder Br verstanden, bevorzugt F.

Unter einem Heteroatom, insbesondere einem Heteroatom in der allgemeinen Formel I, wird insbesondere ein Atom ausgewählt aus der Gruppe bestehend aus O, S, Se, Si, B, N oder P verstanden, bevorzugt ausgewählt aus der Gruppe bestehend aus O, S, Se oder N.

Die erfindungsgemäßen chemischen Verbindungen der allgemeinen Formel I weisen Vorteile im Vergleich zum Stand der Technik auf. Vorteilhafterweise können verbesserte Absorber für optoelektronische Bauelemente bereitgestellt werden. Vorteilhafterweise werden Absorbermaterialien für den roten und nah-infraroten Spektralbereich mit einer hohen Absorptionsstärke und besonders guter Verdampfbarkeit bereitgestellt. Verteilhafterweise absorbieren Verbindungen der allgemeinen Formel I rotes und nah-infrarotes Licht in einem Wellenlängenbereich von 600 bis 1000 nm. Vorteilhafterweise sind die Füllfaktoren FF besonders hoch. Vorteilhafterweise sind die erfindungsgemäßen Verbindungen besser für die Vakuumprozessierung zur Bildung photovoltaischer Elemente geeignet. Vorteilhafterweise ist die Verdampfbarkeit erhöht, insbesondere die Verdampfbarkeit ohne Zersetzung, wobei die Verbindungen bei einer Temperatur von 300°C oder mehr thermisch stabil sind. Dadurch sind die Verbindungen im Vakuum ohne Zersetzung prozessierbar. Überraschenderweise wurde gefunden, dass bei der Verwendung eines zumindest teilweise fluorierten Aryl-Substituenten anstelle einer zumindest teilweise fluorierten Alkylkette ein wesentlich höherer Schmelz- und Zersetzungspunkt erreicht werden kann, während die Verdampfungstemperatur nur um einen kleineren Betrag ansteigt. Vorteilhafterweise kann die farbliche Variabilität von organischen photovoltaischen Elementen vergrößert werden. Vorteilhafterweise ist die Absorption von Licht im sichtbaren Bereich unter 650 nm verhältnismäßig gering, weshalb die erfindungsgemäßen Verbindungen zur Herstellung von semitransparenten oder transparenten organischen Solarzellen oder Photodetektoren sehr gut geeignet sind.

Gemäß einer Weiterbildung der Erfindung ist vorgesehen, dass X1 und X2 S sind oder X1 und X2 O sind, und/oder wobei mindestens ein H-Atom in dem homocyclischen 6-Ring und/oder in dem heterocyclischen 5-Ring oder 6-Ring R1 durch F oder CF3 substituiert ist, bevorzugt durch F. Dadurch verwirklichen sich die vorteilhaften Effekte der vorliegenden Erfindung in besonderer Weise.

In einer bevorzugten Ausführungsform der Erfindung ist R3 und/oder R6 ein homocyclischer 6-Ring, wobei mindestens ein H-Atom durch eine Alkyl-Gruppe, eine Alkoxy-Gruppe und/oder ein F-Atom substituiert sind.

Gemäß einer Weiterbildung der Erfindung ist vorgesehen, dass R3 und R4 und/oder R5 und R6 jeweils zusammen einen heterocyclischen 5-Ring oder 6-Ring mit mindestens einem Heteroatom ausgewählt aus o, S oder N, bevorzugt O oder S, bilden, wobei bevorzugt der heterocyclische 5-Ring oder 6-Ring nicht substituiert ist, oder einen homocyclischen 6-Ring bilden. Dadurch verwirklichen sich die vorteilhaften Effekte der vorliegenden Erfindung in besonderer Weise.

In einer bevorzugten Ausführungsform der Erfindung bilden R3 und R4 und/oder R5 und R6 jeweils zusammen keinen heterocyclischen 5-Ring oder 6-Ring.

In einer bevorzugten Ausführungsform der Erfindung bilden X1 und R6, bevorzugt R8 und R6, und/oder X2 und R3, bevorzugt R8 und R3, zusammen einen heterocyclischen Fünf-Ring oder Sechs-Ring mit mindestens einem Heteroatom ausgewählt aus der Gruppe bestehend aus S, O und N, oder einen homocyclischen Sechs-Ring, bevorzugt einen heterocyclischen 5-Ring.

In einer bevorzugten Ausführungsform der Erfindung bilden X1 und R7, bevorzugt R8 und R7, und/oder X2 und R2, bevorzugt R8 und R2, zusammen einen heterocyclischen Fünf-Ring oder Sechs-Ring mit mindestens einem Heteroatom ausgewählt aus der Gruppe bestehend aus O, S und N, oder einen homocyclischen Sechs-Ring, bevorzugt einen heterocyclischen 5-Ring.

Gemäß einer Weiterbildung der Erfindung ist vorgesehen, dass R1 ein homocyclischer 6-Ring mit der Bedingung R1 gleich C₆HₙF₅₋ₙ mit n=0,1,2,3,4 ist. Dadurch verwirklichen sich die vorteilhaften Effekte der vorliegenden Erfindung in besonderer Weise.

Gemäß einer Weiterbildung der Erfindung ist vorgesehen, dass R1 ausgewählt ist aus der Gruppe bestehend aus: 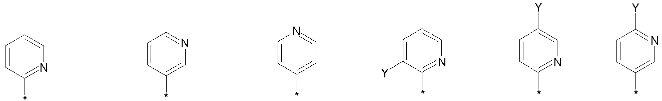 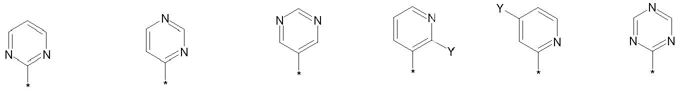 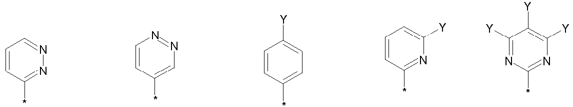 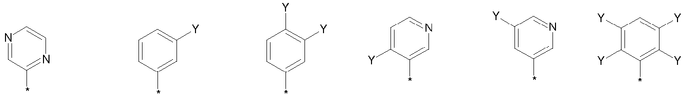 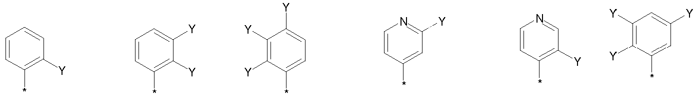 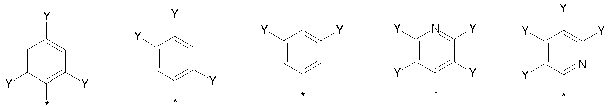 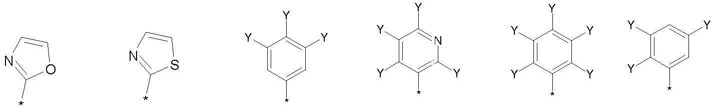 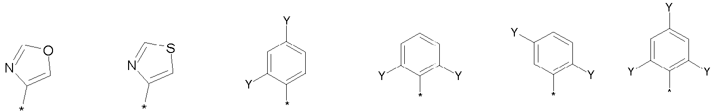 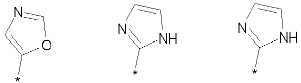 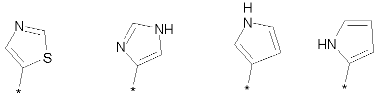 wobei * die Anknüpfung an die Verbindung der allgemeinen Formel I bezeichnet, wobei Y unabhängig voneinander ausgewählt ist aus der Gruppe bestehend aus Cl, CN, F und CF3, bevorzugt ist Y F, und wobei H-Atome substituiert oder nicht-substituiert sind, bevorzugt nicht substituiert sind. Dadurch verwirklichen sich die vorteilhaften Effekte der vorliegenden Erfindung in besonderer Weise.

Gemäß einer Weiterbildung der Erfindung ist vorgesehen, dass R3 und R6 unabhängig voneinander ausgewählt sind aus der Gruppe bestehend aus 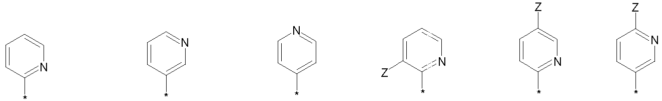 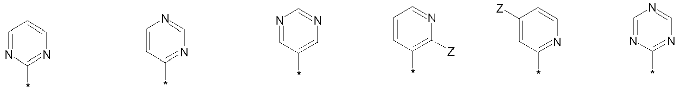 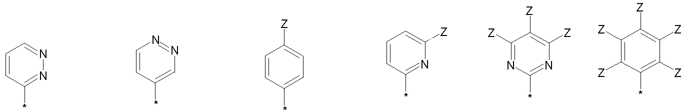 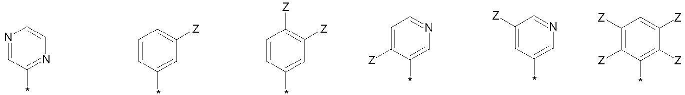 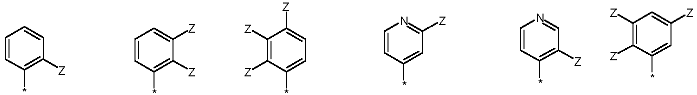 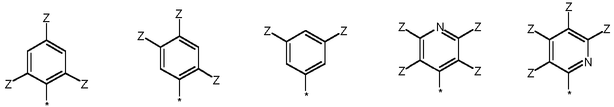 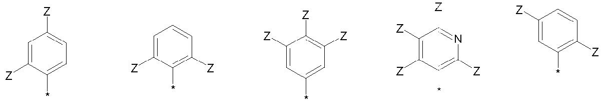 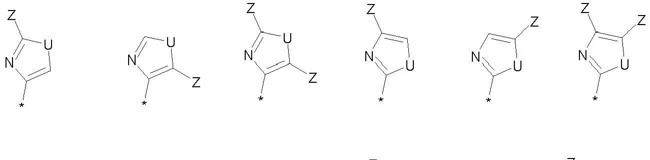 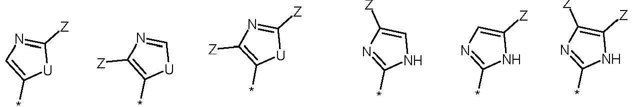 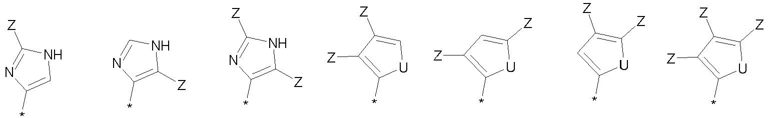 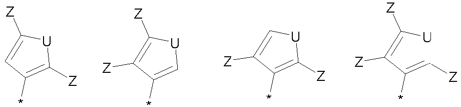
wobei * die Anknüpfung an die Verbindung der allgemeinen Formel I bezeichnet,
wobei U ausgewählt ist aus der Gruppe bestehend aus O, S und NR19, wobei R19 ausgewählt ist aus der Gruppe bestehend aus H, Halogen, Alkyl, fluoriertem Alkyl, teilfluoriertem Alkyl, Alkoxy, Alkenyl, Aryl, und Heteroaryl, bevorzugt ist U O oder S, und wobei Z unabhängig voneinander ausgewählt ist aus der Gruppe bestehend aus H, Halogen, bevorzugt F, CF3, CN, Alkyl, fluoriertem Alkyl, teilfluoriertem Alkyl, Alkenyl, Alkoxy, N-Alkyl, NAlkyl2, Aryl, und Heteroaryl, wobei bevorzugt R3 und R6 gleich sind. Dadurch verwirklichen sich die vorteilhaften Effekte der vorliegenden Erfindung in besonderer Weise.

In einer bevorzugten Ausführungsform der Erfindung ist Z unabhängig voneinander ausgewählt aus der Gruppe bestehend aus Halogen, bevorzugt F, CF3, und CN, insbesondere bevorzugt ist Z F. In einer alternativ bevorzugten Ausführungsform der Erfindung ist Z Methyl, Methoxy, Ethyl oder Ethoxy.

In einer bevorzugten Ausführungsform der Erfindung sind R3 und R6 unabhängig voneinander ausgewählt aus 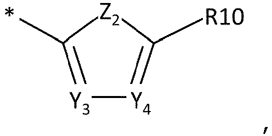
wobei * die Anknüpfung an die Verbindung der allgemeinen Formel I bezeichnet,
Z2 ausgewählt ist aus der Gruppe bestehend aus O, S, und N-R11, wobei R11 ausgewählt ist aus der Gruppe bestehend aus H, Alkoxy, Alkyl, fluoriertem Alkyl, teilfluoriertem Alkyl, und Aryl,
Y3 N oder C-R12 ist, wobei R12 ausgewählt ist aus der Gruppe bestehend aus H, Halogen, Alkoxy, verzweigtem oder linearem, zyklischem oder offenkettigem Alkyl, Alkenyl, und Aryl, wobei bevorzugt mindestens ein H substituiert ist, bevorzugt durch CN oder F substituiert ist,
Y4 N oder C-R13 ist, wobei R13 ausgewählt ist aus der Gruppe bestehend aus H, Halogen, Alkoxy, verzweigtem oder linearem, zyklischem oder offenkettigem Alkyl, Alkenyl, und Aryl, wobei bevorzugt mindestens ein H substituiert ist, bevorzugt durch CN oder F substituiert ist, und wobei bevorzugt R12 und R13 miteinander in Form einer Ringstruktur homocyclisch oder heterocyclisch verbunden sind, und
R10 ausgewählt ist aus der Gruppe bestehend aus H, Halogen, Alkoxy, Alkyl, fluoriertem Alkyl, teilfluoriertem Alkyl, verzweigtem oder linearem, zyklischem oder offenkettigem Alkyl, Amino, Aryl, Heteroaryl, Alkenyl, und einer elektronenziehenden Alkyl-Gruppe mit zumindest einer C=C-Doppelbindung, wobei bevorzugt mindestens ein H durch CN oder F substituiert ist.

In einer bevorzugten Ausführungsform der Erfindung sind die H-Atome in Y3 und/oder Y4 zumindest teilweise durch Alkyl, Alkoxy oder F substituiert.

In einer bevorzugten Ausführungsform sind die Positionen Y3 und Y4 jeweils CH.

In einer bevorzugten Ausführungsform der Erfindung ist die Gruppe R3 gleich der Gruppe R6.

In einer bevorzugten Ausführungsform der Erfindung ist X1 gleich X2, ist R2 gleich R7, ist R4 gleich R5, und ist R3 gleich R6.

In einer bevorzugten Ausführungsform der Erfindung sind X1 und X2 gleich O oder S, sind R2 und R7 H, sind R4 und R5 H, und ist R3 gleich R6.

Gemäß einer Weiterbildung der Erfindung ist vorgesehen, dass R3 und/oder R6 weiter anneliert sind, und/oder R1 ein monocyclischer 5-Ring oder 6-Ring ist.

In einer bevorzugten Ausführungsform der Erfindung ist R3 und/oder R6 mit mindestens einem weiteren 5-Ring oder 6-Ring anneliert, bevorzugt mit zwei weiteren 5-Ringen und/oder 6-Ringen, wobei der mindestens eine 5-Ring und/oder der mindestens eine 6-Ringe ein substituierter oder nicht-substituierter Aryl- oder Heteroarylring ist.

In einer alternativ bevorzugten Ausführungsform der Erfindung sind R3 und/oder R6 nicht weiter anneliert.

Gemäß einer Weiterbildung der Erfindung ist vorgesehen, dass R2 und R7 unabhängig voneinander ausgewählt sind aus der Gruppe bestehend aus H, Halogen, CN, und C1-C4-Alkyl, bevorzugt sind R2 und R7 H, und/oder R4 und R5 unabhängig voneinander ausgewählt sind aus der Gruppe bestehend aus H, Halogen, CN, und C1-C4-Alkyl, bevorzugt sind R4 und R5 H.

Gemäß einer Weiterbildung der Erfindung ist vorgesehen, dass R1 ein heterocyclischer 5-Ring oder 6-Ring mit mindestens einem sp2-hybridisierten N-Atom mit einem freien Elektronenpaar im Ringsystem ist, bevorzugt ist R1 ausgewählt aus der Gruppe bestehend aus substituiertem oder nicht-substituiertem Imidazol, Pyrazol, Triazol, Tetrazol, Pyridin, Pyrimidin, Pyrazin, Pyridazin, Triazin, Oxazol, Isoxazol, Thiazol, und Isothiazol.

In einer besonders bevorzugten Ausführungsform der Erfindung ist R1 kein substituiertes und/oder kein nicht-substituiertes Thiophen, bevorzugt kein nicht-substituiertes Thiophen.

In einer besonders bevorzugten Ausführungsform der Erfindung ist R1 kein substituiertes und/oder nicht-substituiertes Furan, bevorzugt kein nicht-substituiertes Furan.

In einer besonders bevorzugten Ausführungsform der Erfindung ist R1 kein substituiertes und/oder nicht-substituiertes Pyrrol, bevorzugt kein nicht-substituiertes Pyrrol.

In einer bevorzugten Ausführungsform der Erfindung ist der heterocyclische 5-Ring oder 6-Ring, oder der homocyclische 6-Ring nicht weiter anneliert.

Gemäß einer Weiterbildung der Erfindung ist vorgesehen, dass die Verbindung ausgewählt ist aus der Gruppe bestehend aus:

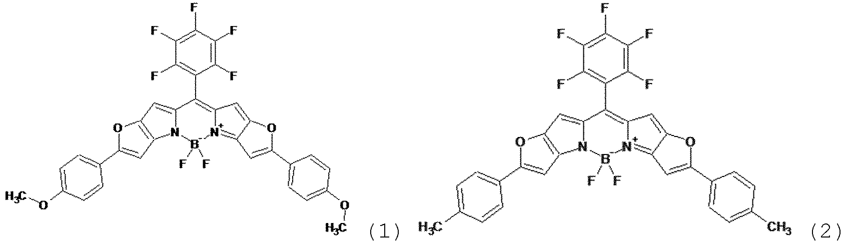

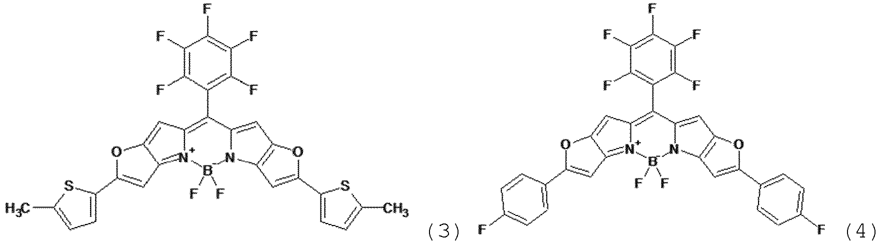

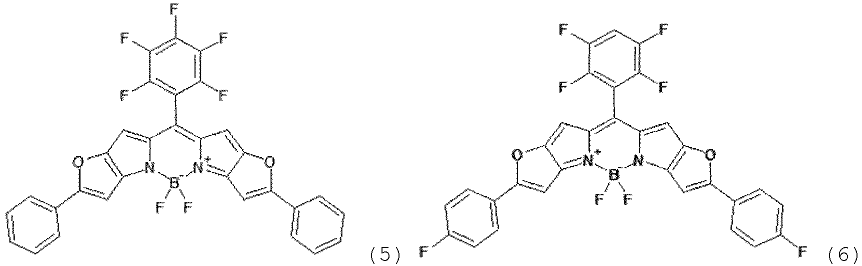

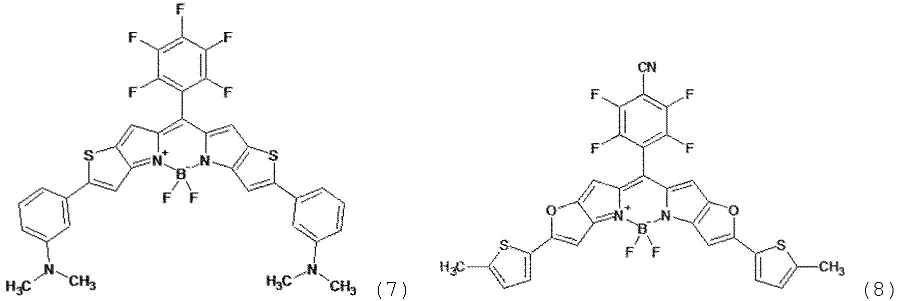

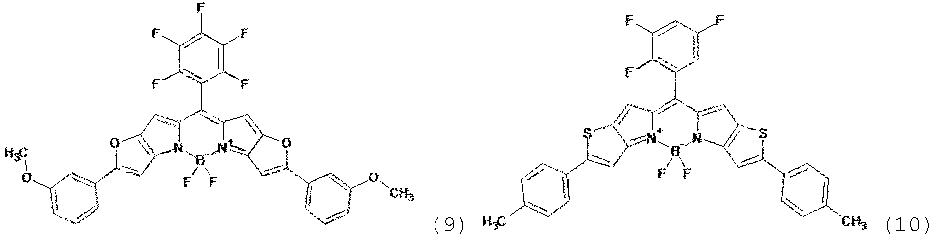

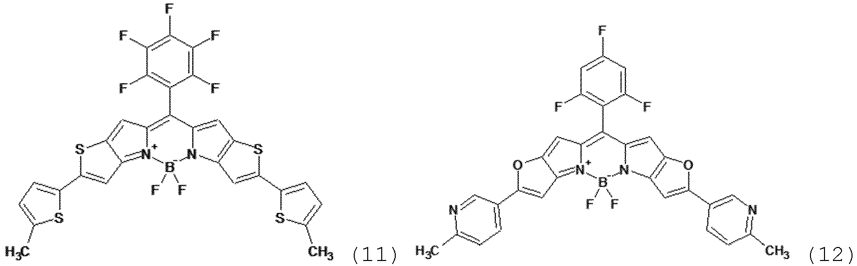

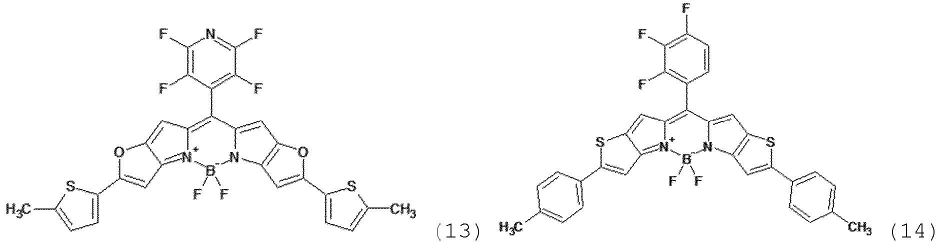

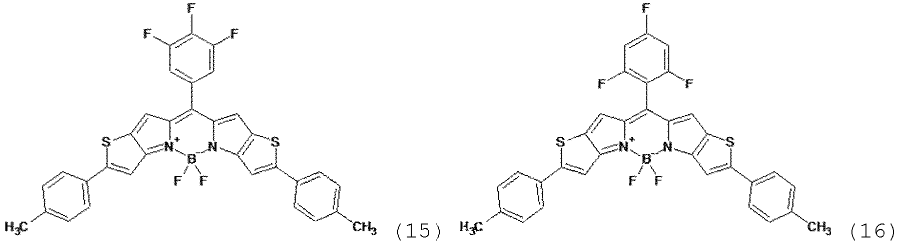

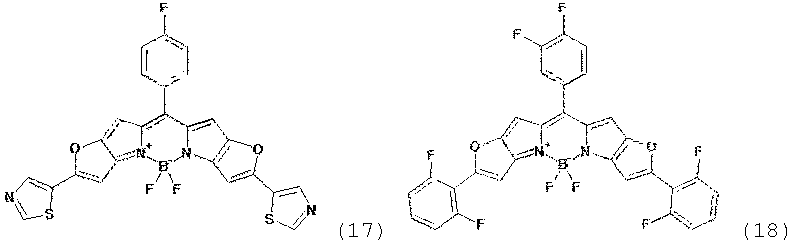

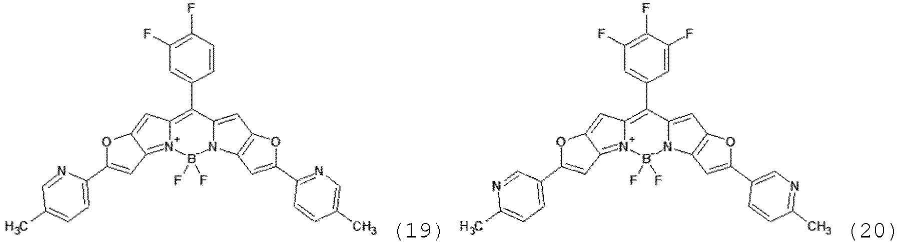

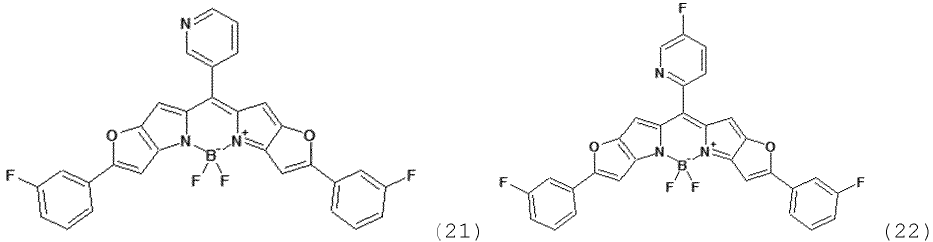

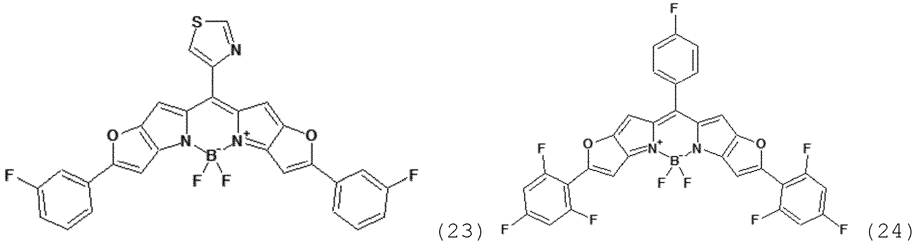

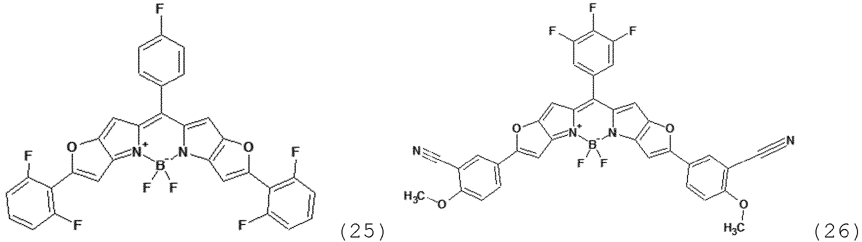

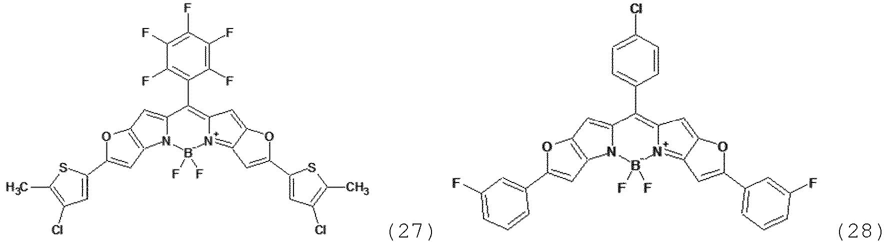

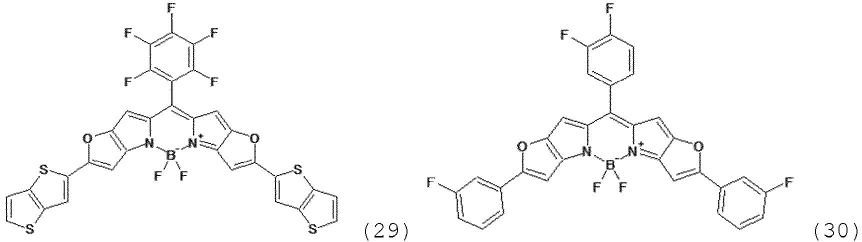

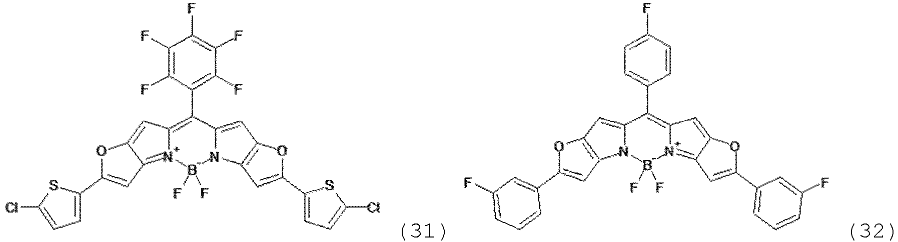

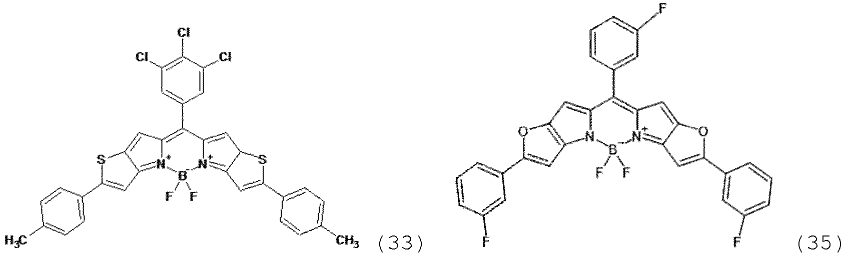

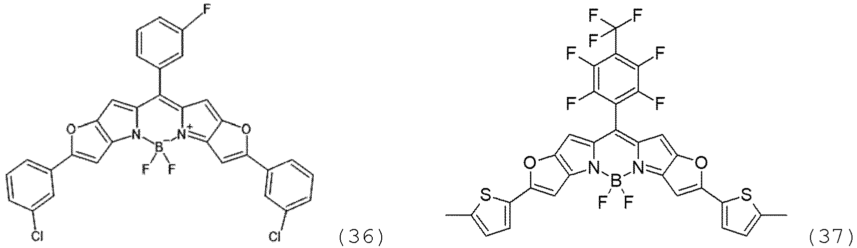

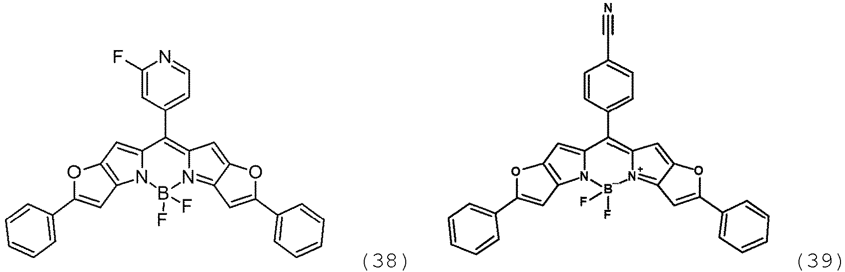

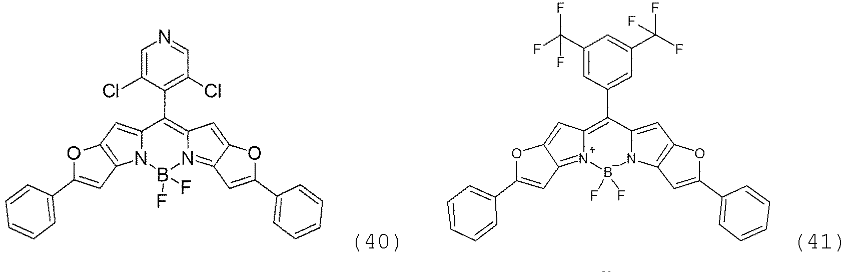

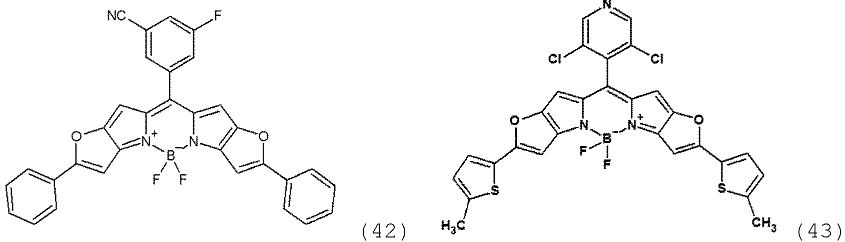

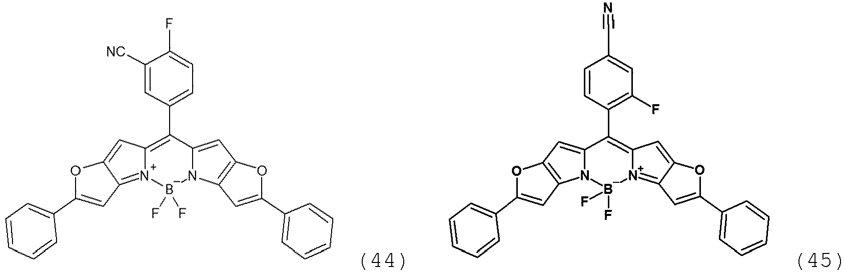

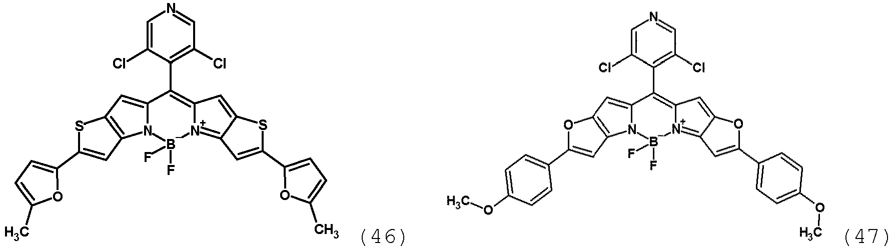

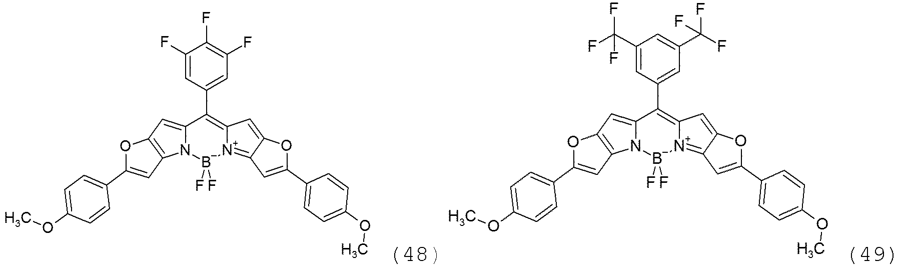

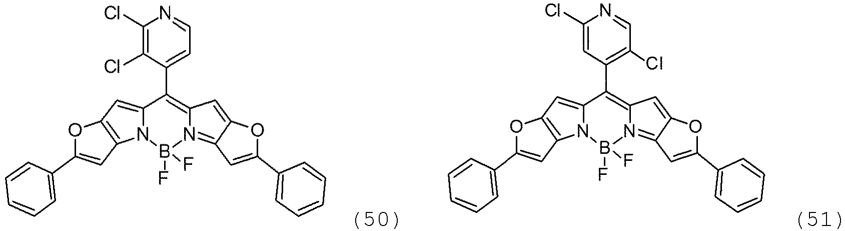

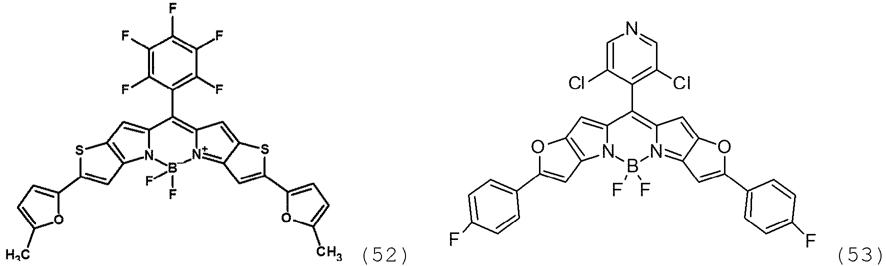

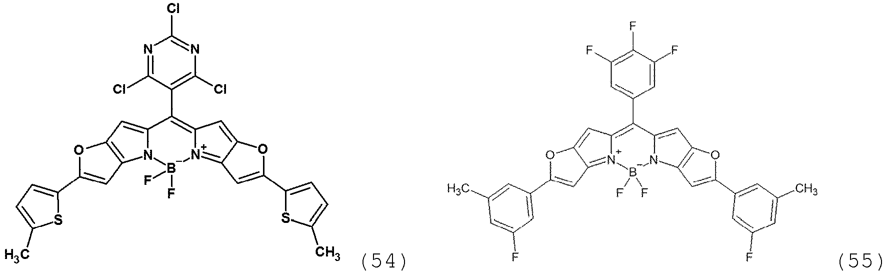

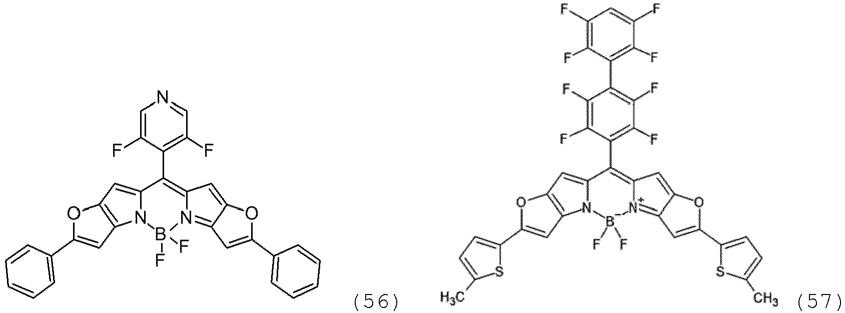

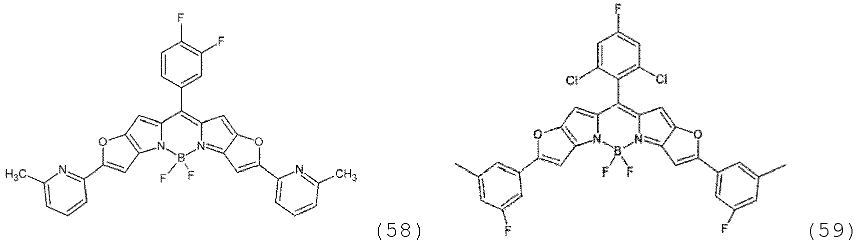

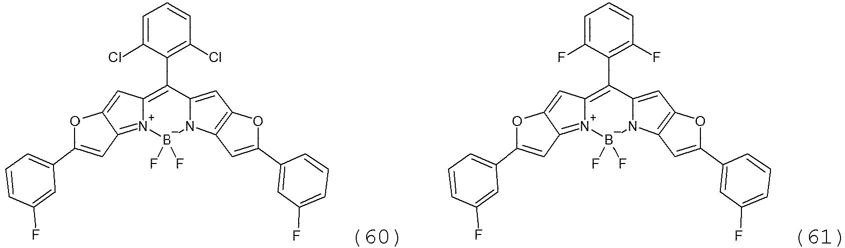

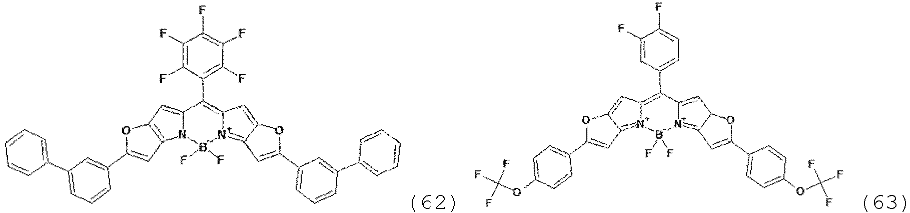

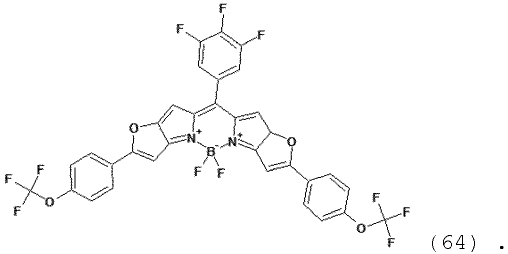

Gemäß einer Weiterbildung der Erfindung ist vorgesehen, dass alle H-Atome in R1 durch ein Halogen, CF3 oder CN substituiert sind, bevorzugt sind alle H-Atome durch F substituiert.

Die erfindungsgemäßen Verbindungen betreffen insbesondere sogenannte kleine Moleküle. Unter kleinen Molekülen werden insbesondere nicht-polymere organische Moleküle mit monodispersen molaren Massen zwischen 100 und 2000 g/mol verstanden, die unter Normaldruck (Luftdruck der uns umgebenden Atmosphäre) und bei Raumtemperatur in fester Phase vorliegen. Insbesondere sind die kleinen Moleküle photoaktiv, wobei unter photoaktiv verstanden wird, dass die Moleküle unter Lichteintrag ihren Ladungszustand und/oder ihren Polarisierungszustand ändern. Die photoaktiven Moleküle zeigen insbesondere eine Absorption elektromagnetischer Strahlung in einem bestimmten Wellenlängenbereich, wobei absorbierte elektromagnetische Strahlung, also Photonen, in Exzitonen umgewandelt werden.

Gemäß einer Weiterbildung der Erfindung ist vorgesehen, dass die Verbindung ein Molgewicht von 300-1500 g/mol aufweist.

In einer bevorzugten Ausführungsform der Erfindung weisen die erfindungsgemäßen Verbindungen keine Ringstruktur zwischen R3 und R4 und/oder zwischen R5 und R6 auf.

In einer bevorzugten Ausführungsform der Erfindung ist die Verbindung spiegelsymmetrisch gegenüber der Achse durch R1 und B gebildet.

Die Aufgabe der vorliegenden Erfindung wird auch gelöst, indem eine Verwendung mindestens einer erfindungsgemäßen Verbindung in einem optoelektronischen Bauelement bereitgestellt wird, insbesondere nach einem der zuvor beschriebenen Ausführungsbeispiele. Dabei ergeben sich für die Verwendung der mindestens einen Verbindung in dem optoelektronischen Bauelement insbesondere die Vorteile, die bereits in Zusammenhang mit der erfindungsgemäßen Verbindung erläutert wurden.

Gemäß einer Weiterbildung der Erfindung ist vorgesehen, dass die erfindungsgemäße Verbindung in einem organischen optoelektronischen Bauelement verwendet wird, bevorzugt einer organischen Solarzelle, einer OLED, einem OFET, oder einem organischen Photodetektor.

In einer bevorzugten Ausführungsform der Erfindung wird die mindestens eine erfindungsgemäße Verbindung als Absorbermaterial in einer photoaktiven Schicht des optoelektronischen Bauelements verwendet. In einer bevorzugten Ausführungsform der Erfindung wird die erfindungsgemäße Verbindung als Donor in einem Donor-Akzeptor-Heteroübergang eingesetzt.

Die Aufgabe der vorliegenden Erfindung wird auch gelöst, indem ein optoelektronisches Bauelement mit einem Schichtsystem bereitgestellt wird, insbesondere nach einem der zuvor beschriebenen Ausführungsbeispiele, wobei zumindest eine Schicht des Schichtsystems eine erfindungsgemäße Verbindung aufweist. Dabei weist mindestens eine Schicht des Schichtsystems mindestens eine erfindungsgemäße Verbindung auf. Dabei ergeben sich für das optoelektronische Bauelement insbesondere die Vorteile, die bereits in Zusammenhang mit der erfindungsgemäßen Verbindung und der Verwendung der mindestens einen erfindungsgemäßen Verbindung in einem optoelektronischen Bauelement erläutert wurden. Das optoelektronische Bauelement umfasst eine erste Elektrode, eine zweite Elektrode und ein Schichtsystem, wobei das Schichtsystem zwischen der ersten Elektrode und der zweiten Elektrode angeordnet ist.

Gemäß einer Weiterbildung der Erfindung ist vorgesehen, dass das optoelektronische Bauelement ein organisches optoelektronisches Bauelement ist, bevorzugt eine organische Solarzelle, ein OFET, eine OLED oder ein organischer Photodetektor.

Gemäß einer Weiterbildung der Erfindung ist vorgesehen, dass das optoelektronische Bauelement ein Schichtsystem mit mindestens einer photoaktiven Schicht aufweist, bevorzugt eine lichtabsorbierende photoaktive Schicht, wobei die mindestens eine photoaktive Schicht die mindestens eine erfindungsgemäße Verbindung aufweist.

In einer bevorzugten Ausführungsform der Erfindung ist die mindestens eine photoaktive Schicht eine Absorberschicht, bevorzugt ist die mindestens eine Verbindung ein Absorbermaterial.

In einer bevorzugten Ausführungsform der Erfindung ist die photoaktive Schicht zwischen der ersten Elektrode und der zweiten Elektrode angeordnet.

In einer bevorzugten Ausführungsform der Erfindung weist das Schichtsystem mindestens zwei photoaktive Schichten, bevorzugt mindestens drei photoaktive Schichten, oder bevorzugt mindestens vier photoaktive Schichten auf.

Unter einem organischen optoelektronischen Bauelement wird insbesondere ein photovoltaisches Element mit mindestens einer organischen photoaktiven Schicht verstanden, wobei die organische photoaktive Schicht mindestens eine erfindungsgemäße Verbindung aufweist. Ein organisches photovoltaisches Element ermöglicht es elektromagnetische Strahlung, insbesondere im Wellenlängenbereich des sichtbaren Lichts, unter Ausnutzung des photoelektrischen Effekts in elektrischen Strom umzuwandeln. In diesem Sinne wird der Begriff "photoaktiv" als Umwandlung von Lichtenergie in elektrische Energie verstanden. Im Gegensatz zu anorganischen Solarzellen werden bei organischen photovoltaischen Elementen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in einem photoaktiven Donor-Akzeptor Übergang freie Ladungsträger getrennt, die dann zum elektrischen Stromfluss beitragen.

In einer bevorzugten Ausführungsform der Erfindung ist die photoaktive Schicht als Mischschicht aus mindestens einer erfindungsgemäßen Verbindung und mindestens einer weiteren Verbindung, oder als Mischschicht mindestens einer erfindungsgemäßen Verbindung und mindestens zwei weiteren Verbindungen ausgebildet ist, wobei die Verbindungen bevorzugt Absorbermaterialien sind.

In einer bevorzugten Ausführungsform der Erfindung weist das Schichtsystem des optoelektronischen Bauelements mindestens eine Transportschicht auf, wobei die mindestens eine Transportschicht dotiert, teilweise dotiert oder undotiert ist. Unter einer Transportschicht wird insbesondere eine Schicht eines Schichtsystems verstanden, die Ladungsträger einer Art transportiert und bevorzugt elektromagnetische Strahlung weitgehend nur in einem Bereich von < 450nm absorbiert.

In einer bevorzugten Ausführungsform der Erfindung weist das optoelektronische Bauelement ein Substrat auf, wobei die erste Elektrode oder die zweite Elektrode auf dem Substrat angeordnet ist, insbesondere kann eine der Elektroden des optoelektronischen Bauelements direkt auf dem Substrat aufgebracht sein, wobei das Schichtsystem zwischen der ersten Elektrode und der zweiten Elektrode angeordnet ist.

In einer bevorzugten Ausführungsform der Erfindung ist die Verbindung und/oder eine Schicht mit der mindestens einen Verbindung mittels Vakuumprozessierung, Gasphasenabscheidung oder Lösungsmittel-Prozessierung abgeschieden, insbesondere bevorzugt mittels Vakuumprozessierung.

Die Erfindung wird im Folgenden anhand der Zeichnungen näher erläutert. Dabei zeigen:
Fig. 1 eine schematische Darstellung eines Ausführungsbeispiels eines optoelektronischen Bauelements im Querschnitt;
Fig. 2 eine grafische Darstellung des Absorptionsspektrums der Verbindung (1);
Fig. 3 eine grafische Darstellung der Strom-Spannungskurve, der spektralen externen Quantenausbeute und des Füllfaktors einer BHJ-Zelle mit der Verbindung (1), gemessen an einem organischen optoelektronischen Bauelement;
Fig. 4 eine grafische Darstellung des Absorptionsspektrums der Verbindung (3);
Fig. 5 eine grafische Darstellung der Strom-Spannungskurve, der spektralen externen Quantenausbeute und des Füllfaktors einer BHJ-Zelle mit der Verbindung (3), gemessen an einem organischen optoelektronischen Bauelement;
Fig. 6 eine grafische Darstellung des Absorptionsspektrums der Verbindung (5);
Fig. 7 eine grafische Darstellung der Strom-Spannungskurve, der spektralen externen Quantenausbeute und des Füllfaktors einer BHJ-Zelle mit der Verbindung (5), gemessen an einem organischen optoelektronischen Bauelement;
Fig. 8 eine grafische Darstellung des Absorptionsspektrums der Verbindung (8);
Fig. 9 eine grafische Darstellung der Strom-Spannungskurve, der spektralen externen Quantenausbeute und des Füllfaktors einer BHJ-Zelle mit der Verbindung (8), gemessen an einem organischen optoelektronischen Bauelement;
Fig. 10 eine grafische Darstellung des Absorptionsspektrums der Verbindung (10);
Fig. 11 eine grafische Darstellung der Strom-Spannungskurve, der spektralen externen Quantenausbeute und des Füllfaktors einer BHJ-Zelle mit der Verbindung (10), gemessen an einem organischen optoelektronischen Bauelement;
Fig. 12 eine grafische Darstellung des Absorptionsspektrums der Verbindung (14);
Fig. 13 eine grafische Darstellung der Strom-Spannungskurve, der spektralen externen Quantenausbeute und des Füllfaktors einer BHJ-Zelle mit der Verbindung (14), gemessen an einem organischen optoelektronischen Bauelement;
Fig. 14 eine grafische Darstellung des Absorptionsspektrums der Verbindung (15);
Fig. 15 eine grafische Darstellung der Strom-Spannungskurve, der spektralen externen Quantenausbeute und des Füllfaktors einer BHJ-Zelle mit der Verbindung (15), gemessen an einem organischen optoelektronischen Bauelement;
Fig. 16 eine grafische Darstellung des Absorptionsspektrums der Verbindung (29);
Fig. 17 eine grafische Darstellung der Strom-Spannungskurve, der spektralen externen Quantenausbeute und des Füllfaktors einer BHJ-Zelle mit der Verbindung (29), gemessen an einem organischen optoelektronischen Bauelement;
Fig. 18 eine grafische Darstellung des Absorptionsspektrums der Verbindung (32); und
Fig. 19 eine grafische Darstellung der Strom-Spannungskurve, der spektralen externen Quantenausbeute und des Füllfaktors einer BHJ-Zelle mit der Verbindung (32), gemessen an einem organischen optoelektronischen Bauelement.

### Ausführungsbeispiele

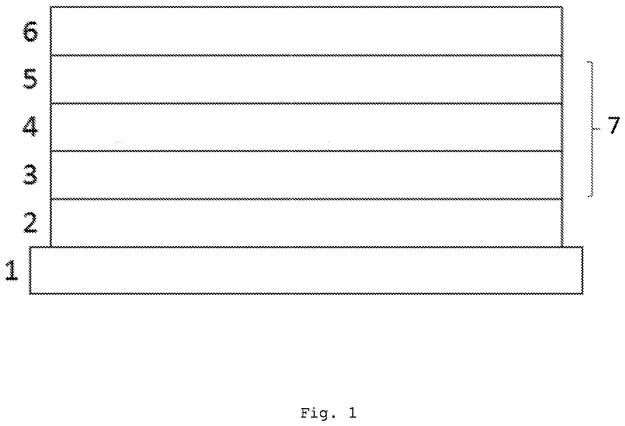

Fig. 1 zeigt eine schematische Darstellung eines Ausführungsbeispiels eines optoelektronischen Bauelements im Querschnitt. Das optoelektronische Bauelement weist dabei mindestens eine chemische Verbindung der allgemeinen Formel I auf.

Das erfindungsgemäße optoelektronische Bauelement weist ein Schichtsystem 7 auf, wobei zumindest eine Schicht des Schichtsystems 7 eine erfindungsgemäße Verbindung aufweist.

In einer Ausgestaltung der Erfindung ist das optoelektronische Bauelement ein organisches optoelektronisches Bauelement, bevorzugt eine organische Solarzelle, ein OFET, eine OLED oder ein organischer Photodetektor. In diesem Ausführungsbeispiel ist das optoelektronische Bauelement eine organische Solarzelle.

Das optoelektronische Bauelement umfasst eine erste Elektrode 2, eine zweite Elektrode 6 und ein Schichtsystem 7, wobei das Schichtsystem 7 zwischen der ersten Elektrode 2 und der zweiten Elektrode 6 angeordnet ist. Dabei weist mindestens eine Schicht des Schichtsystems 7 mindestens eine erfindungsgemäße Verbindung auf.

In einer weiteren Ausgestaltung der Erfindung weist das optoelektronische Bauelement ein Schichtsystem 7 mit mindestens einer photoaktiven Schicht 4 auf, bevorzugt eine lichtabsorbierende photoaktive Schicht 4, wobei die mindestens eine photoaktive Schicht 4 die mindestens eine erfindungsgemäße Verbindung aufweist.

In einer weiteren Ausgestaltung der Erfindung weist das Schichtsystem 7 mindestens zwei photoaktive Schichten 4 auf, bevorzugt mindestens drei photoaktive Schichten 4, oder bevorzugt mindestens vier photoaktive Schichten 4.

In einem Ausführungsbeispiel weist die organische Solarzelle ein Substrat 1 auf, z. B. aus Glas, auf dem sich eine Elektrode 2 befindet, die z. B. ITO umfasst. Darauf angeordnet ist das Schichtsystem 7 mit einer elektronentransportierenden Schicht 3 (ETL) sowie einer photoaktiven Schicht 4 mit mindestens einer erfindungsgemäßen Verbindung, einem p-leitenden Donor-Material, und einem n-leitenden Akzeptor-Material, z. B. C60 Fulleren, entweder als flacher Heteroübergang oder als Volumenheteroübergang. Darüber angeordnet befindet sich eine p-dotierte Lochtransportschicht 5 (HTL), und eine Elektrode 6 aus Gold oder Aluminium, ausgebildet als Volumenheteroübergang (bulk heterojunctions).

In einer weiteren Ausgestaltung der Erfindung ist die photoaktive Schicht 4 als Mischschicht aus der mindestens einen erfindungsgemäßen Verbindung und mindestens einer weiteren Verbindung, oder als Mischschicht der mindestens einen erfindungsgemäßen Verbindung und mindestens zwei weiteren Verbindungen ausgebildet, wobei die Verbindungen Absorbermaterialien sind.

In einer weiteren Ausgestaltung der Erfindung ist das optoelektronische Bauelement als Tandemzelle, Tripelzelle oder Mehrfachzelle ausgebildet. Dabei sind wobei zwei oder mehr photoaktive Schichten 4 übereinandergestapelt, wobei die photoaktiven Schichten 4 aus gleichen oder aus unterschiedlichen Materialien oder Materialmischungen aufgebaut sind.

Die Herstellung der einzelnen eines erfindungsgemäßen Bauelements kann durch Verdampfen im Vakuum, mit oder ohne Trägergas oder prozessieren einer Lösung oder Suspension, wie zum Beispiel beim Coaten oder Drucken geschehen. Einzelne Schichten können ebenso durch Sputtern aufgetragen werden. Dies ist vor allem für den Grundkontakt möglich. Vorteilhaft ist die Herstellung der Schichten durch Verdampfen im Vakuum, wobei das Trägersubstrat erwärmt sein kann.

In einer weiteren Ausgestaltung der Erfindung ist das optoelektronische Bauelement ein flexibles optoelektronisches Bauelement. Unter einem flexiblen optoelektronischen Bauelement wird im Sinne der vorliegenden Erfindung ein Bauelement verstanden, welches infolge einer äußeren Krafteinwirkung teilweise verformbar ist. Dadurch sind solche flexiblen Bauelemente zur Anordnung auf gekrümmten Oberflächen geeignet.

Die allgemeine Herstellung der erfindungsgemäßen Verbindungen ist dem Fachmann aus dem Stand der Technik bekannt. In diesem Zusammenhang wird insbesondere auf die internationalen Anmeldungen WO2007126052A1 und EP3617214A1 verwiesen.

Die chemische Verbindung der allgemeinen Formel I weist folgende Struktur auf:

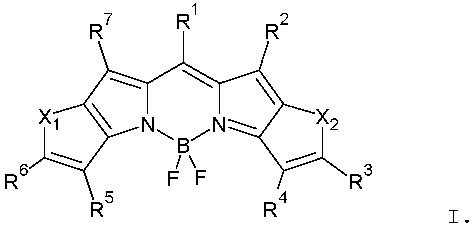

X1 und X2 sind unabhängig voneinander O, S oder N-R8 mit R8 ausgewählt aus der Gruppe bestehend aus H, Alkyl, Aryl, und Heteroaryl, R1 ist ein substituierter homocyclischer 6-Ring, wobei mindestens ein H-Atom durch einen elektronenziehenden Substituenten ausgewählt aus der Gruppe bestehend aus F, Cl, CN, CF3, und COR8 mit R8 C1-C4-Alkyl substituiert ist, oder ein substituierter oder nicht-substituierter heterocyclischer 5-Ring oder 6-Ring, wobei der heterocyclische 5-Ring oder 6-Ring mindestens ein sp2-hybridisiertes N-Atom mit einem freien Elektronenpaar aufweist und/oder mindestens einem Heteroatom ausgewählt aus O, S, oder N aufweist, wobei mindestens ein H-Atom durch einen elektronenziehenden Substituenten ausgewählt aus der Gruppe bestehend aus F, Cl, CN, CF3, und COR9 mit R9 C1-C4-Alkyl substituiert ist. R2 und R7 sind unabhängig voneinander ausgewählt aus der Gruppe bestehend aus H, Halogen, CN, Alkyl, fluoriertem oder teilfluoriertem Alkyl, und ungesättigtem Alkyl. R4 und R5 sind unabhängig voneinander ausgewählt aus der Gruppe bestehend aus H, Halogen, CN, Alkyl, fluoriertem oder teilfluoriertem Alkyl, ungesättigtem Alkyl, und Alkoxy. R3 und R6 sind unabhängig voneinander ein substituierter oder nicht-substituierter homocyclischer 6-Ring oder ein substituierter oder nicht-substituierter heterocyclischer 5-Ring oder 6-Ring.

In einer Ausgestaltung der Erfindung sind X1 und X2 S oder X1 und X2 O, und/oder ist mindestens ein H-Atom in dem homocyclischen 6-Ring und/oder in dem heterocyclischen 5-Ring oder 6-Ring R1 durch F oder CF3 substituiert, bevorzugt durch F.

In einer weiteren Ausgestaltung der Erfindung bilden R3 und R4 und/oder R5 und R6 jeweils zusammen einen heterocyclischen 5-Ring oder 6-Ring mit mindestens einem Heteroatom ausgewählt aus O, S oder N, bevorzugt O oder S, wobei bevorzugt der heterocyclische 5-Ring oder 6-Ring nicht substituiert ist, oder bilden einen homocyclischen 6-Ring.

In einer weiteren Ausgestaltung der Erfindung ist R1 ein homocyclischer 6-Ring mit der Bedingung R1 gleich C₆HₙF₅₋ₙ mit n=0,1,2,3,4.

In einer weiteren Ausgestaltung der Erfindung ist R1 ausgewählt aus der Gruppe bestehend aus: 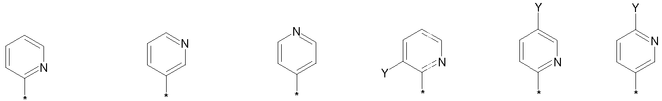 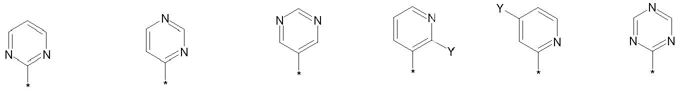 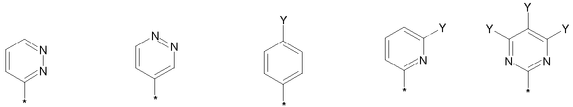 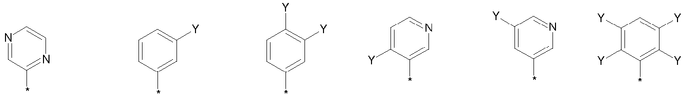 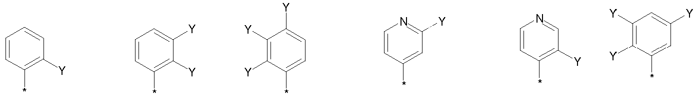 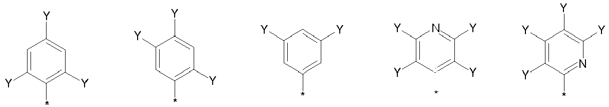 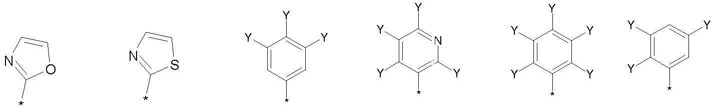 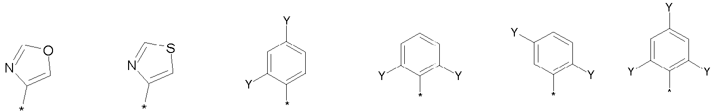 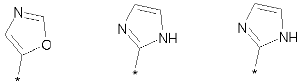 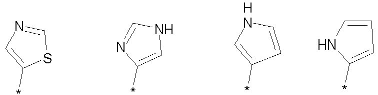 wobei * die Anknüpfung an die Verbindung der allgemeinen Formel I bezeichnet, wobei Y unabhängig voneinander ausgewählt ist aus der Gruppe bestehend aus Cl, CN, F und CF3, bevorzugt ist Y F, und wobei H-Atome substituiert oder nicht-substituiert sind.

In einer weiteren Ausgestaltung der Erfindung sind R3 und R6 unabhängig voneinander ausgewählt aus der Gruppe bestehend aus 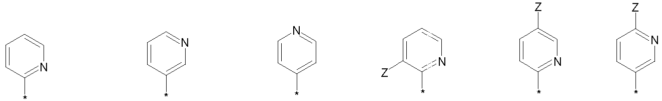 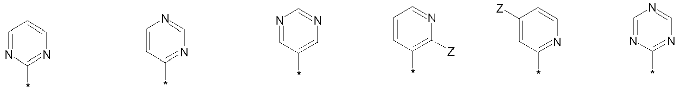 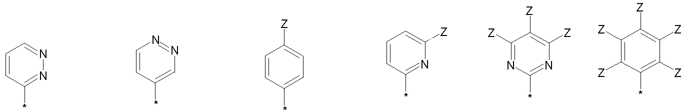 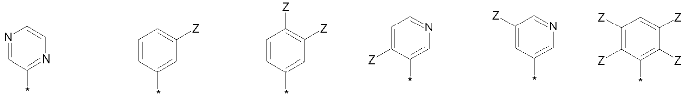 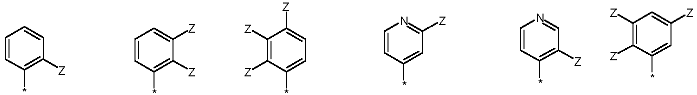 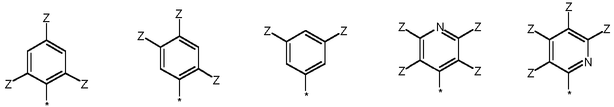 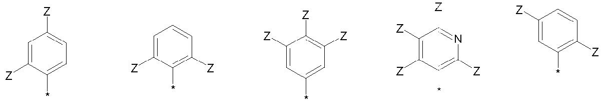 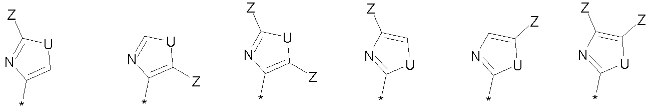 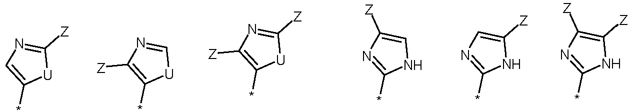 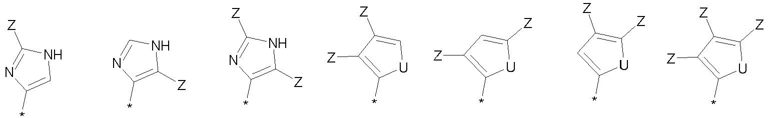 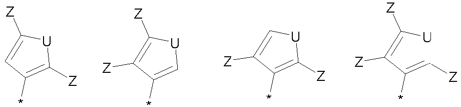
wobei * die Anknüpfung an die Verbindung der allgemeinen Formel I bezeichnet,
wobei U ausgewählt ist aus der Gruppe bestehend aus O, S und NR19, wobei R19 ausgewählt ist aus der Gruppe bestehend aus H, Halogen, Alkyl, fluoriertem Alkyl, teilfluoriertem Alkyl, Alkoxy, Alkenyl, Aryl, und Heteroaryl, bevorzugt ist U O oder S, und wobei Z unabhängig voneinander ausgewählt ist aus der Gruppe bestehend aus H, Halogen, bevorzugt F, CF3, CN, Alkyl, fluoriertem Alkyl, teilfluoriertem Alkyl, Alkenyl, Alkoxy, N-Alkyl, NAlkyl2, Aryl, und Heteroaryl, wobei bevorzugt R3 und R6 gleich sind.

In einer weiteren Ausgestaltung der Erfindung sind R3 und/oder R6 weiter anneliert, und/oder ist R1 ein monocyclischer 5-Ring oder 6-Ring.

In einer weiteren Ausgestaltung der Erfindung sind R2 und R7 unabhängig voneinander ausgewählt aus der Gruppe bestehend aus H, Halogen, CN, und C1-C4-Alkyl, bevorzugt sind R2 und R7 H, und/oder sind R4 und R5 unabhängig voneinander ausgewählt aus der Gruppe bestehend aus H, Halogen, CN, und C1-C4-Alkyl, bevorzugt sind R4 und R5 H.

In einer weiteren Ausgestaltung der Erfindung ist R1 ein heterocyclischer 5-Ring oder 6-Ring mit mindestens einem sp2-hybridisierten N-Atom mit einem freien Elektronenpaar im Ringsystem, bevorzugt ist R1 ausgewählt aus der Gruppe bestehend aus substituiertem oder nicht-substituiertem Imidazol, Pyrazol, Triazol, Tetrazol, Pyridin, Pyrimidin, Pyrazin, Pyridazin, Triazin, Oxazol, Isoxazol, Thiazol, und Isothiazol.

In einer weiteren Ausgestaltung der Erfindung ist die Verbindung ausgewählt aus der Gruppe bestehend aus:

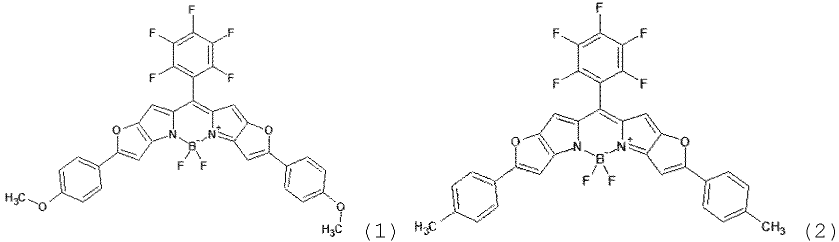

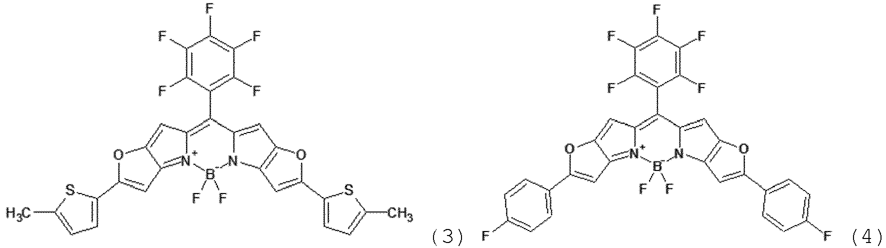

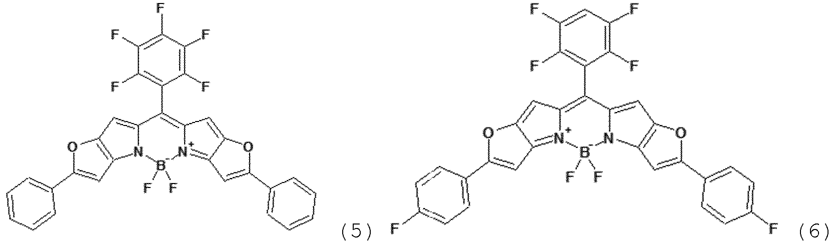

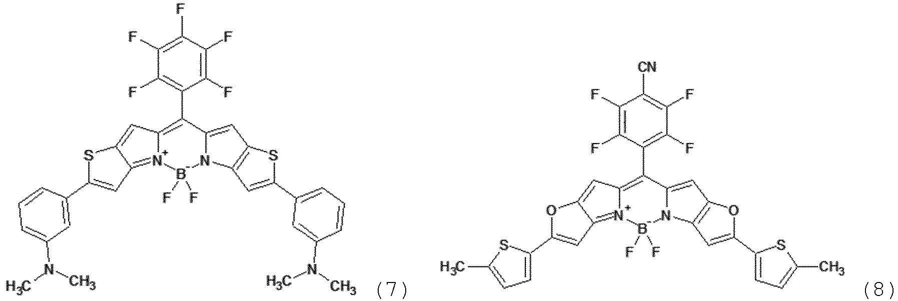

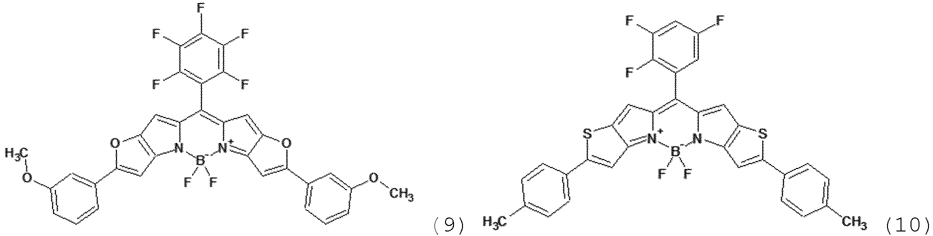

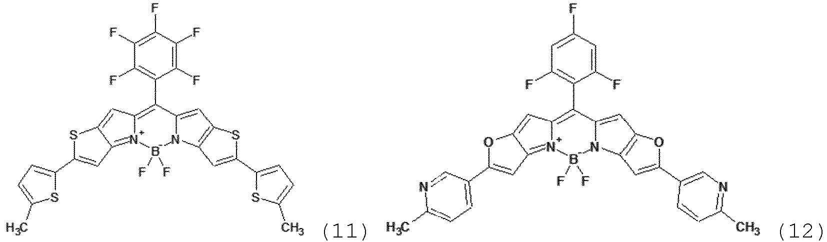

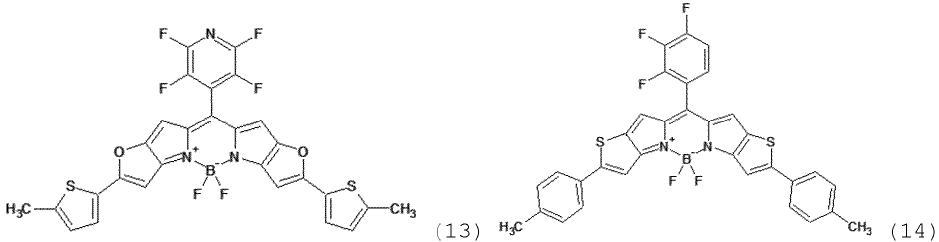

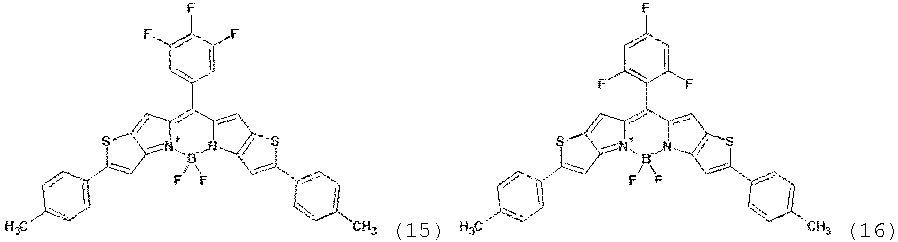

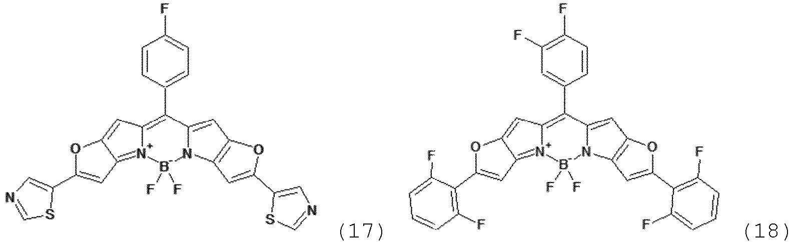

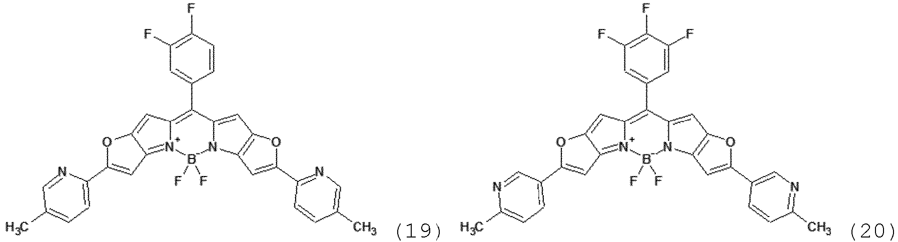

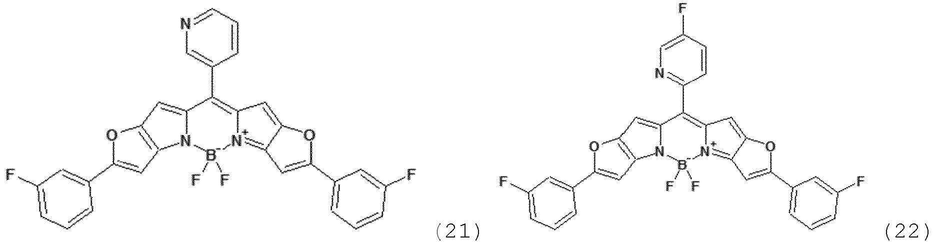

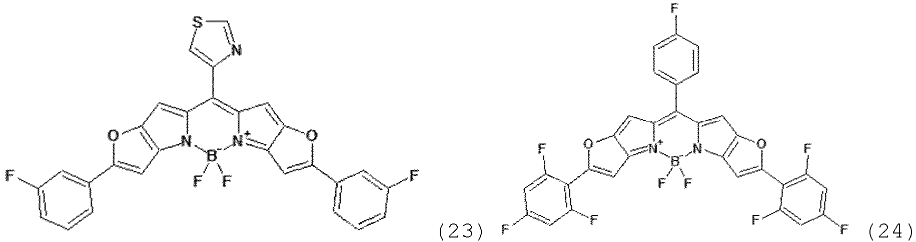

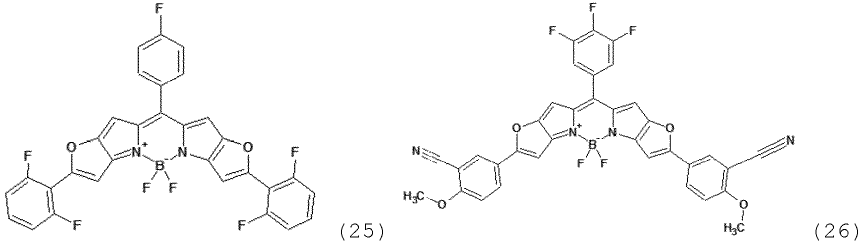

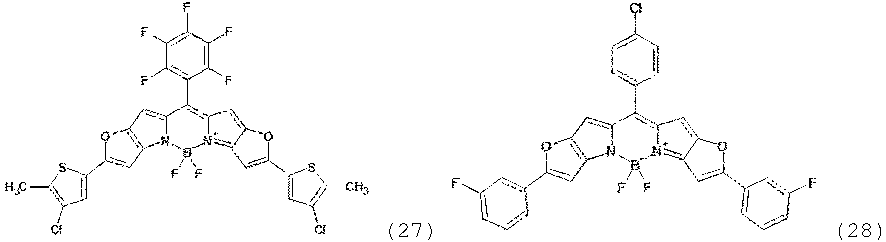

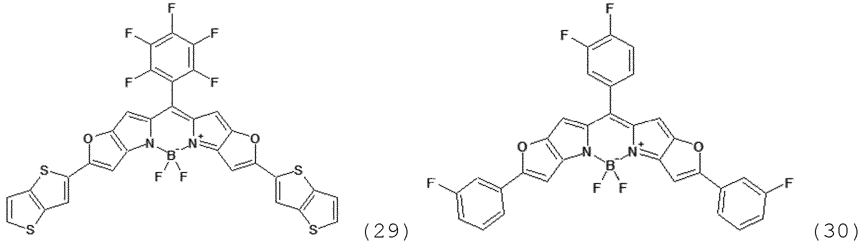

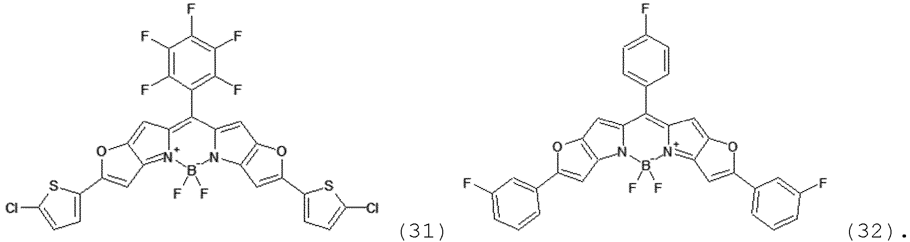

In einer weiteren Ausgestaltung der Erfindung sind alle H-Atome in R1 durch ein Halogen oder CN substituiert, bevorzugt sind alle H-Atome durch F substituiert.

In einer weiteren Ausgestaltung der Erfindung weist die Verbindung ein Molgewicht von 300-1500 g/mol auf.

Die erfindungsgemäße Verbindung wird in einer Ausgestaltung der Erfindung in einem optoelektronischen Bauelement, bevorzugt einem organischen optoelektronischen Bauelement, insbesondere bevorzugt einer organischen Solarzelle, einer OLED, einem OFET, oder einem organischen Photodetektor, verwendet.

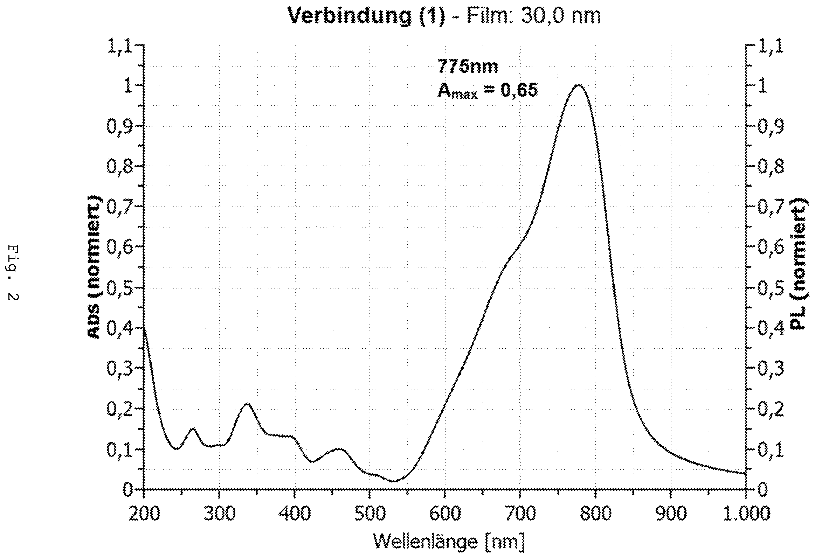

In den folgenden Figuren 2 bis 21 werden konkrete Ausführungsbeispiele der erfindungsgemäßen chemischen Verbindung mit der allgemeinen Formel I sowie deren optische Eigenschaften aufgezeigt. Die Parameter Leerlaufspannung Uoc, Kurzschlussstrom Jsc und Füllfaktor FF beziehen sich jeweils auf den gleichen Aufbau des photovoltaischen Elements.

Fig. 2 zeigt eine grafische Darstellung des Absorptionsspektrums der Verbindung (1).

Die Absorptionsspektren (optische Dichte über Wellenlänge in nm) der Verbindungen (1) bis (32) wurden jeweils für 30 nm dicke vakuumaufgedampfte Schichten auf Quarzglas und in einer Lösung aus Dichlormethan gemessen.

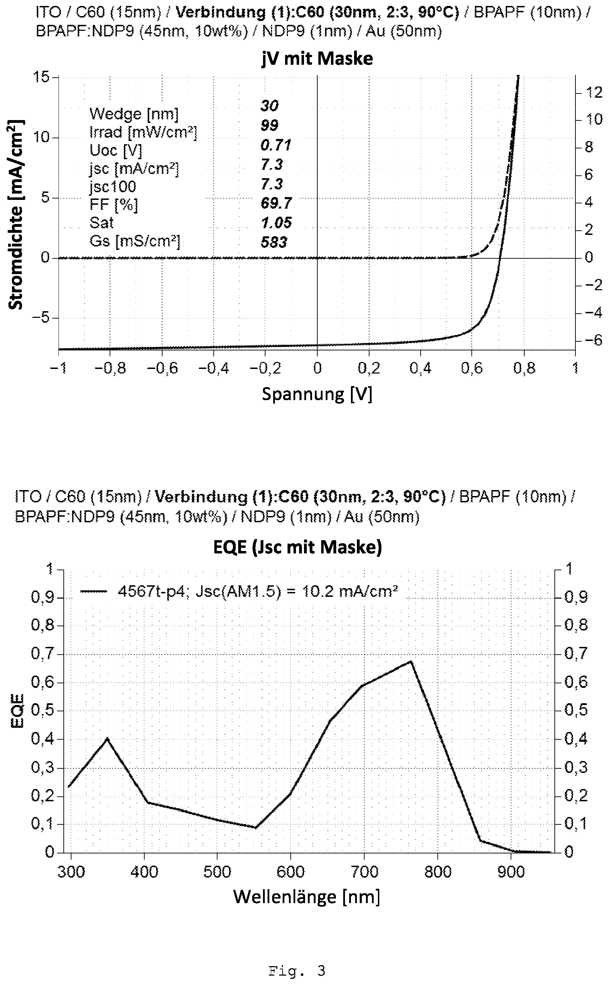

Fig. 3 zeigt eine grafische Darstellung der Strom-Spannungskurve, der spektralen externen Quantenausbeute und des Füllfaktors einer BHJ-Zelle mit der Verbindung (1), gemessen an einem organischen optoelektronischen Bauelement. In diesem Ausführungsbeispiel ist das optoelektronische Bauelement eine organische Solarzelle.

Die Strom-Spannungskurve enthält Kennzahlen, welche die organische Solarzelle kennzeichnen. Die wichtigsten Kennzahlen sind hierbei der Füllfaktor FF, die Leerlaufspannung Uoc und der Kurzschlussstrom Jsc.

Zur Untersuchung der Verbindungen, also deren Einsatz als Absorbermaterialien in organischen optoelektronischen Bauelementen, wurde die Strom-Spannungskurve einer BHJ-Zelle gemessen. In diesem Ausführungsbeispiel weist die BHJ-Zelle auf der ITO-Schicht eine Schicht von C60 mit einer Schichtdicke von 15 nm auf. Auf diese Schicht wurde die Verbindung (1) zusammen mit C60 in einer Dicke von 30 nm aufgetragen. Dieser Schicht folgt eine Schicht aus BPAPF (9,9-bis[4-(N,N-bis-biphenyl-4-yl-amino)phenyl]-9H-fluoren) in einer Schichtdicke von 10 nm. Darauf befindet sich eine weitere Schicht umfassend BPAPF und NDP9 in einer Schichtdicke von 45 nm. An diese Schicht schließt sich eine weitere Schicht mit NDP9 in einer Dicke von 1 nm an, worauf eine Gold-Schicht in einer Dicke von 50 nm folgt. ITO dient dabei als Elektrode 2, und das benachbarte Fulleren C60 als Elektronentransportschicht (ETL) 3, daran schließt sich die photoaktive Schicht 4 mit C60 als Elektronenakzeptormaterial und dem jeweiligen Absorber an, gefolgt von BPAPF (9,9-bis[4-(N,N-bis-biphenyl-4-yl-amino)phenyl]-9H-fluoren) als Lochtransportschicht (HTL) 5 und mit NDP9 (Novaled AG) dotiertem BPAPF, gefolgt von einer Elektrode 6 aus Gold. Erfindungsgemäß enthält ein halbleitendes Bauelement zumindest eine Schicht in einem Schichtsystem eine Verbindung der allgemeinen Formel I.

Die Strom-Spannungskurve einer BHJ-Zelle mit dem Aufbau: ITO / C60 (15 nm) / Verbindung (1) :C60 (30nm, 3:2, 90°C) / BPAPF (10nm) / BPAPF:NDP9 (45nm, 10 wt% NDP9) / NDP9 (1nm) / Au (50nm) wurde bestimmt. Die Parameter der Zelle wurden unter AM1.5 Beleuchtung gemessen (AM = Air Mass; AM = 1,5 bei diesem Spektrum beträgt die globale Strahlungsleistung 1000 W/m²; AM = 1,5 als Standardwert für die Vermessung von Solarmodulen), wobei die photoaktive Schicht ein Volumenheteroübergang (bulk heterojunction - BHJ) umfasst.

In dem optoelektronischen Bauelement mit Verbindung (1) beträgt der Füllfaktor FF 69,7 %, die Leerlaufspannung Uoc 0,71 V und der Kurzschlussstrom Jsc 10,2 mA/cm2. Der Zellwirkungsgrad eines solchen optoelektronischen Bauelements, insbesondere einer Solarzelle, mit der Verbindung (1) beträgt 5,05%.

Die Verbindung (1) zeigt eine gute Verdampfbarkeit im Vakuum. Die Verdampfungstemperatur der Verbindung (1) liegt bei 230°C während die Zersetzungstemperatur bei 377°C liegt. Im Vergleich dazu zeigt eine entsprechende Vergleichsverbindung (1), die statt einer C6F5-Gruppe in meso-Position der Verbindung (1) eine CF3-Gruppe aufweist, eine Verdampfungstemperatur von 215°C und eine um 60°C geringere Zersetzungstemperatur von bereits 317°C.

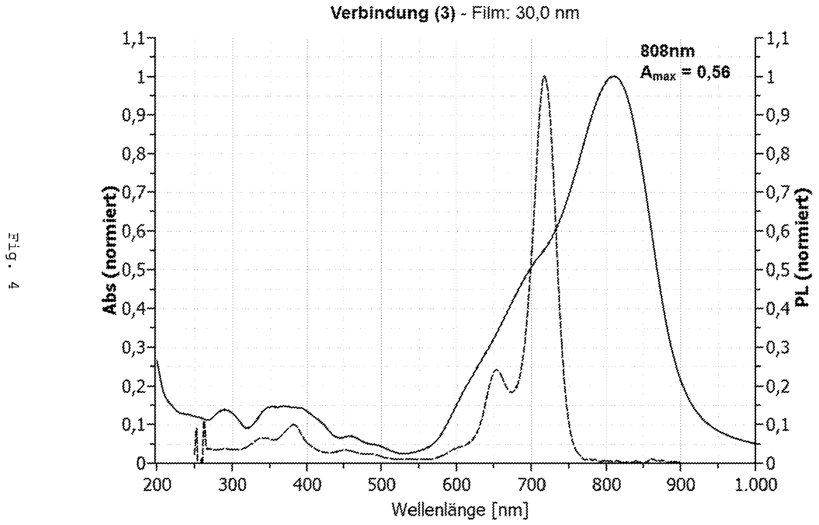

Fig. 4 zeigt eine grafische Darstellung des Absorptionsspektrums der Verbindung (3).

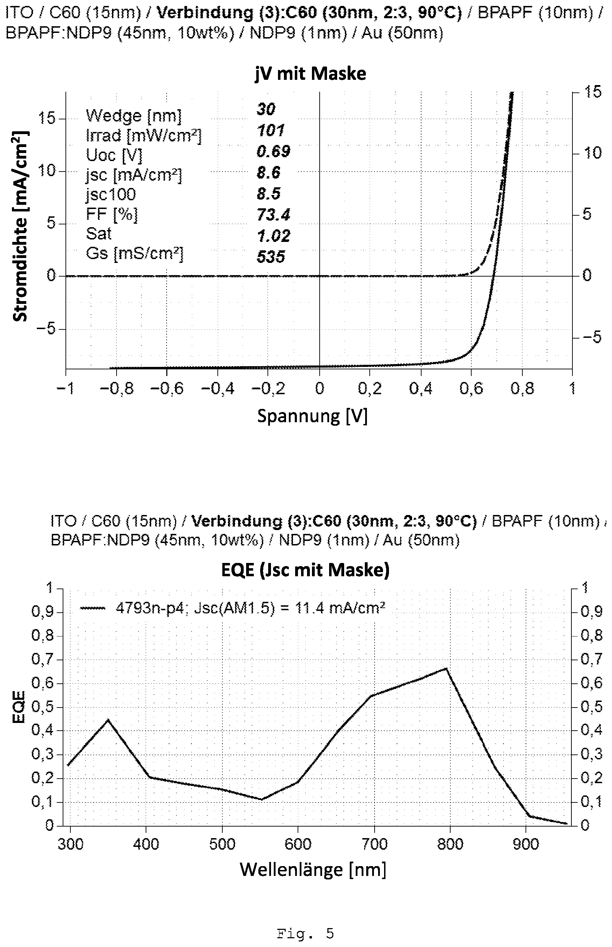

Fig. 5 zeigt eine grafische Darstellung der Strom-Spannungskurve, der spektralen externen Quantenausbeute und des Füllfaktors einer BHJ-Zelle mit der Verbindung (3), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung(3):C60 (30nm, 3:2, 90°C) / BPAPF (10nm) / BPAPF:NDP9 (45nm, 10 wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (3) beträgt der Füllfaktor FF 73,4 %, die Leerlaufspannung Uoc 0,69 V und der Kurzschlussstrom Jsc 11,4 mA/cm2. Der Zellwirkungsgrad eines solchen optoelektronischen Bauelements, insbesondere einer Solarzelle, mit der Verbindung (3) beträgt 5,77%.

Die Verbindung (3) zeigt eine gute Verdampfbarkeit im Vakuum.

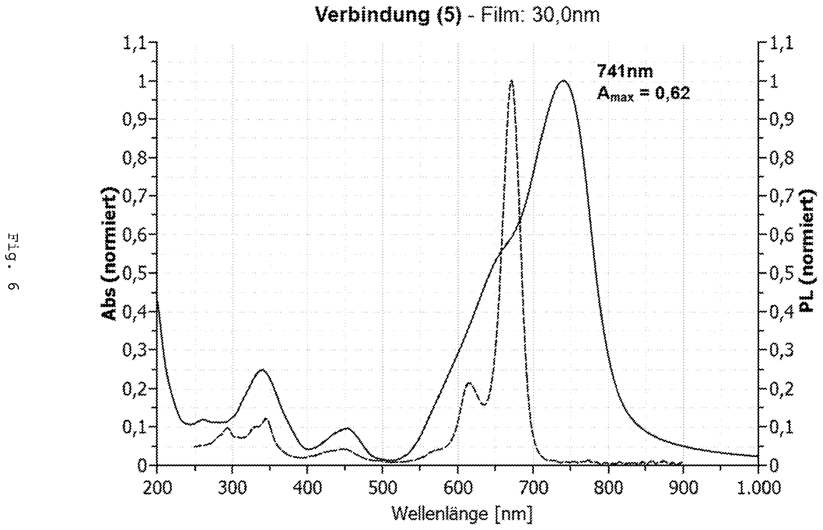

Fig. 6 zeigt eine grafische Darstellung des Absorptionsspektrums der Verbindung (5).

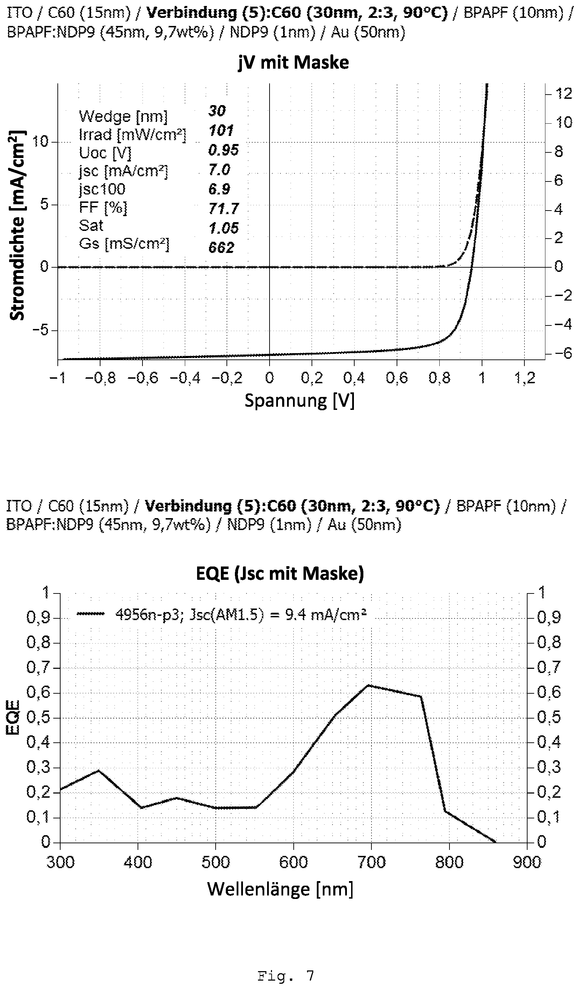

Fig. 7 zeigt eine grafische Darstellung der Strom-Spannungskurve, der spektralen externen Quantenausbeute und des Füllfaktors einer BHJ-Zelle mit der Verbindung (5), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung(5):C60 (30nm, 3:2, 90°C) / BPAPF (10nm) / BPAPF:NDP9 (45nm, 10wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (5) beträgt der Füllfaktor FF 71,7 %, die Leerlaufspannung Uoc 0,95 V und der Kurzschlussstrom Jsc 9,4 mA/cm2. Der Zellwirkungsgrad eines solchen optoelektronischen Bauelements, insbesondere einer Solarzelle, mit der Verbindung (5) beträgt 6,40%.

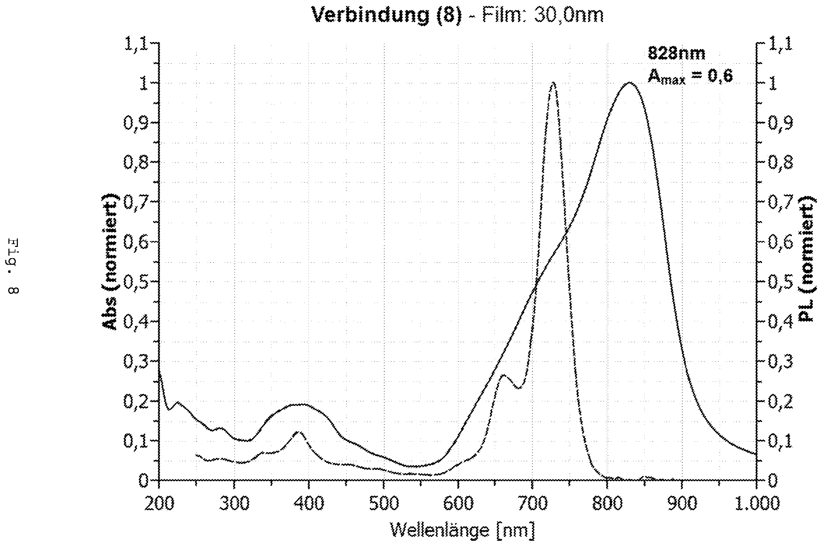

Fig. 8 zeigt eine grafische Darstellung des Absorptionsspektrums der Verbindung (8).

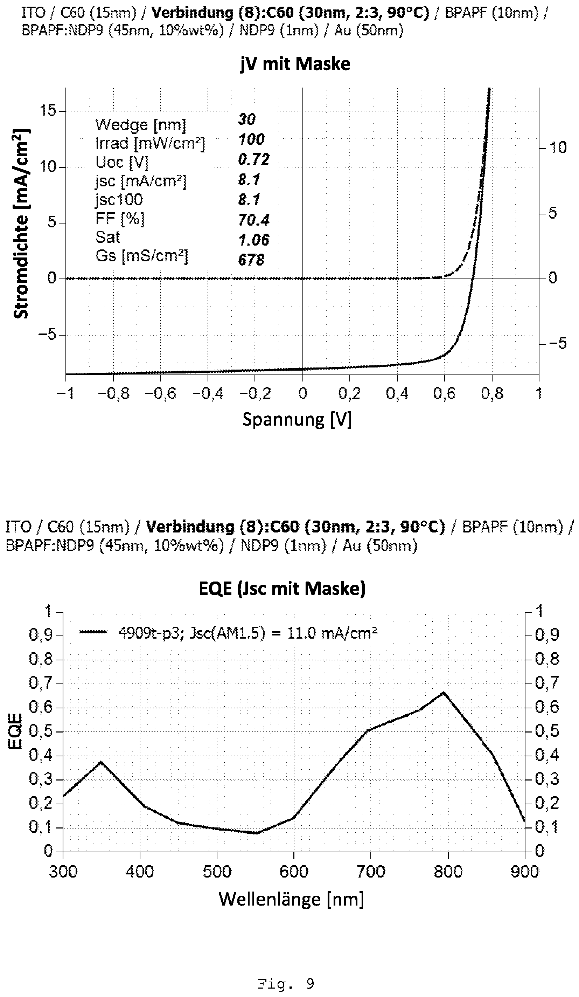

Fig. 9 zeigt eine grafische Darstellung der Strom-Spannungskurve, der spektralen externen Quantenausbeute und des Füllfaktors einer BHJ-Zelle mit der Verbindung (8), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung(8):C60 (30nm, 3:2, 90°C) / BPAPF (10nm) / BPAPF:NDP9 (45nm, 10wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (8) beträgt der Füllfaktor FF 70,4 %, die Leerlaufspannung Uoc 0,72 V und der Kurzschlussstrom Jsc 11,0 mA/cm2. Der Zellwirkungsgrad eines solchen optoelektronischen Bauelements, insbesondere einer Solarzelle, mit der Verbindung (8) beträgt 5,58%.

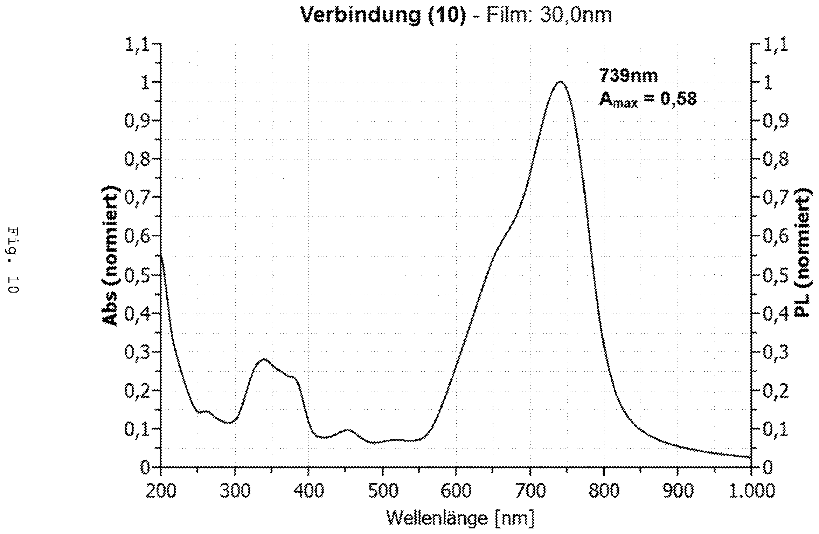

Fig. 10 zeigt eine grafische Darstellung des Absorptionsspektrums der Verbindung (10).

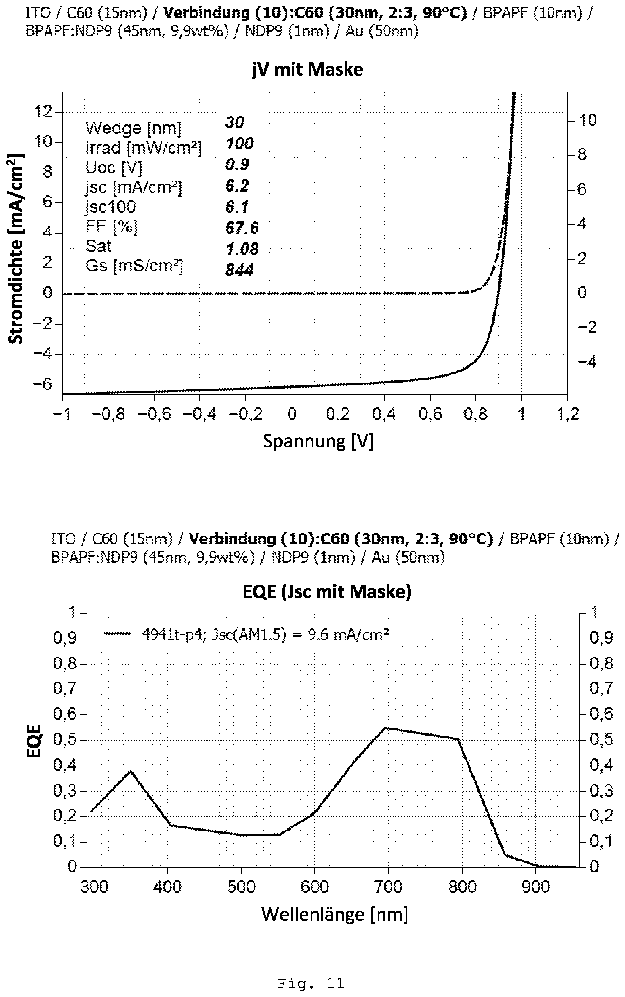

Fig. 11 zeigt eine grafische Darstellung der Strom-Spannungskurve, der spektralen externen Quantenausbeute und des Füllfaktors einer BHJ-Zelle mit der Verbindung (10), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung (10) :C60 (30nm, 3:2, 90°C) / BPAPF (10nm) / BPAPF:NDP9 (45nm, 10wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (10) beträgt der Füllfaktor FF 67,6 %, die Leerlaufspannung Uoc 0,90 V und der Kurzschlussstrom Jsc 9,6 mA/cm2. Der Zellwirkungsgrad eines solchen optoelektronischen Bauelements, insbesondere einer Solarzelle, mit der Verbindung (10) beträgt 5,84%.

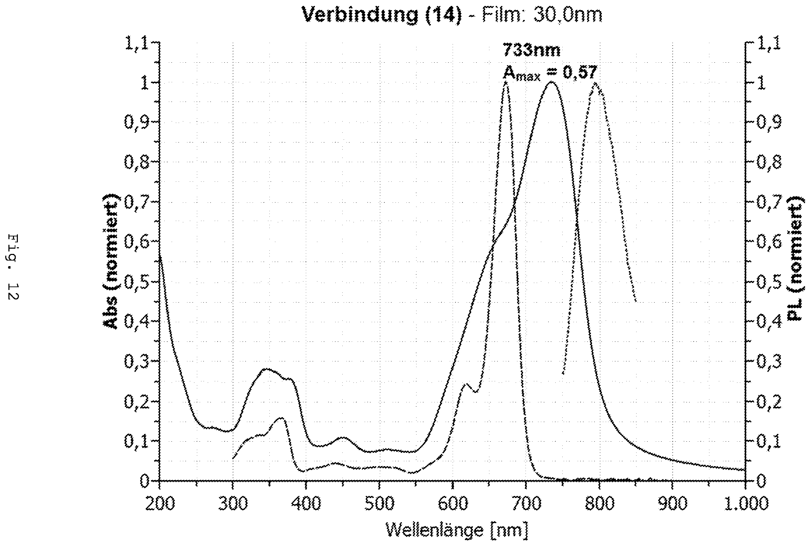

Fig. 12 zeigt eine grafische Darstellung des Absorptionsspektrums der Verbindung (14).

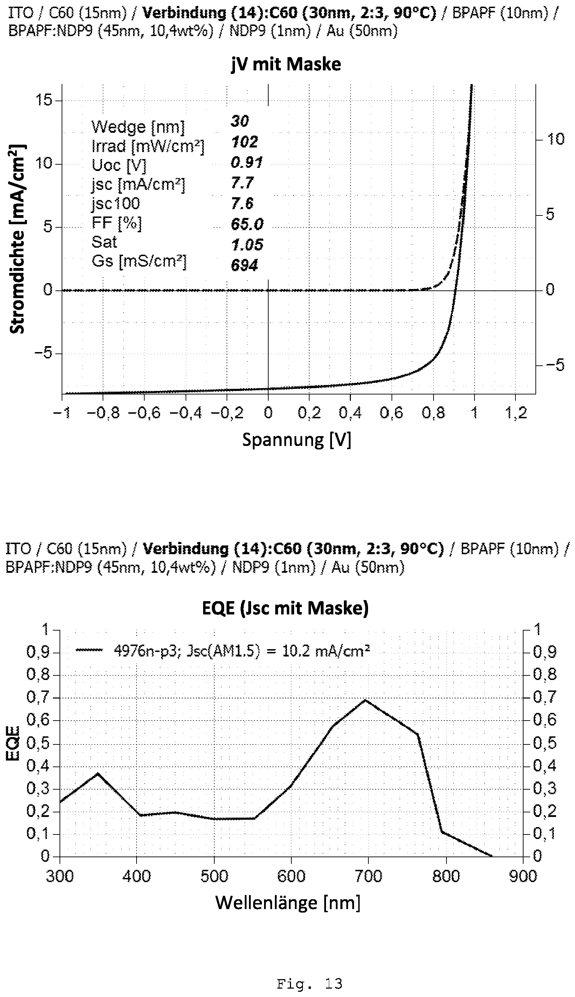

Fig. 13 zeigt eine grafische Darstellung der Strom-Spannungskurve, der spektralen externen Quantenausbeute und des Füllfaktors einer BHJ-Zelle mit der Verbindung (14), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung (14) :C60 (30nm, 3:2, 90°C) / BPAPF (10nm) / BPAPF:NDP9 (45nm, 10wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (14) beträgt der Füllfaktor FF 65,0 %, die Leerlaufspannung Uoc 0,91 V und der Kurzschlussstrom Jsc 10,2 mA/cm2. Der Zellwirkungsgrad eines solchen optoelektronischen Bauelements, insbesondere einer Solarzelle, mit der Verbindung (14) beträgt 6,03%.

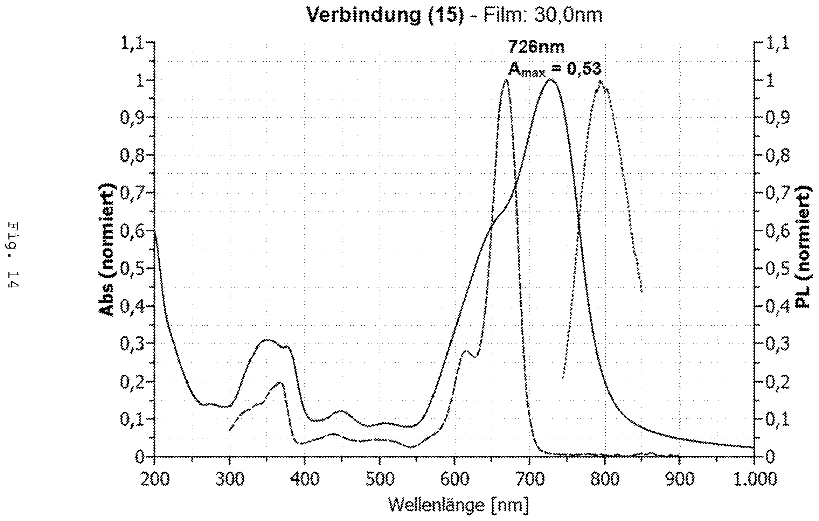

Fig. 14 zeigt eine grafische Darstellung des Absorptionsspektrums der Verbindung (15).

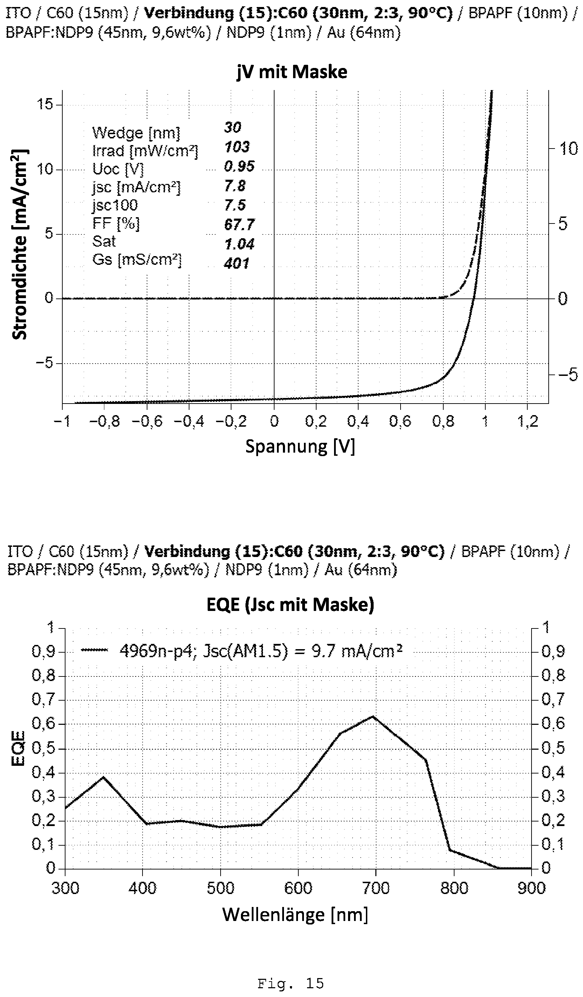

Fig. 15 zeigt eine grafische Darstellung der Strom-Spannungskurve, der spektralen externen Quantenausbeute und des Füllfaktors einer BHJ-Zelle mit der Verbindung (15), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung (15) :C60 (30nm, 3:2, 90°C) / BPAPF (10nm) / BPAPF:NDP9 (45nm, 10wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (15) beträgt der Füllfaktor FF 67,7 %, die Leerlaufspannung Uoc 0,95 V und der Kurzschlussstrom Jsc 9,7 mA/cm2. Der Zellwirkungsgrad eines solchen optoelektronischen Bauelements, insbesondere einer Solarzelle, mit der Verbindung (15) beträgt 6,24%.

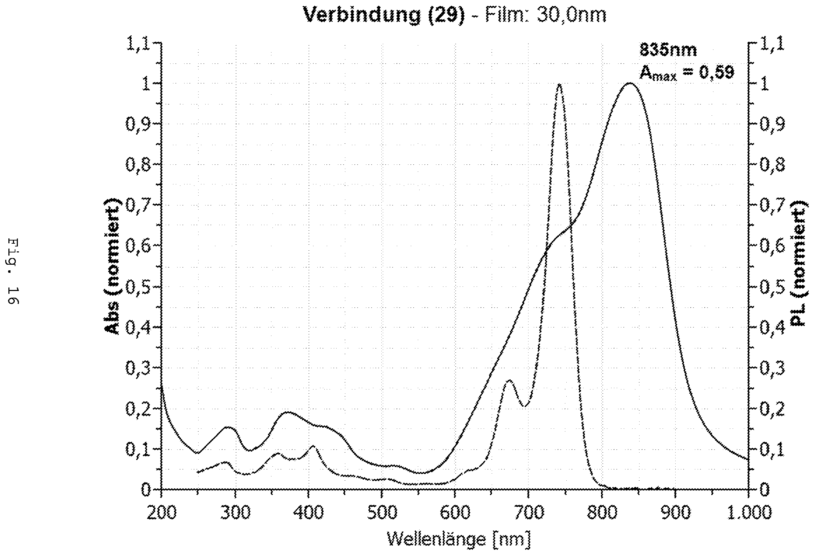

Fig. 16 zeigt eine grafische Darstellung des Absorptionsspektrums der Verbindung (29).

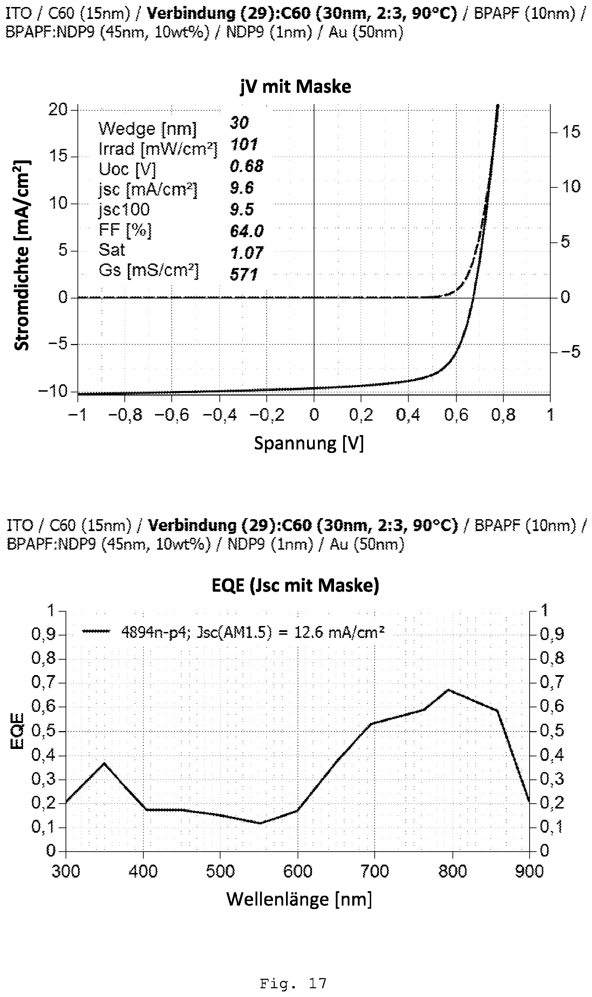

Fig. 17 zeigt eine grafische Darstellung der Strom-Spannungskurve, der spektralen externen Quantenausbeute und des Füllfaktors einer BHJ-Zelle mit der Verbindung (29), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung(29):C60 (30nm, 3:2, 90°C) / BPAPF (10nm) / BPAPF:NDP9 (45nm, 10wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (29) beträgt der Füllfaktor FF 64,0 %, die Leerlaufspannung Uoc 0,68 V und der Kurzschlussstrom Jsc 12,6 mA/cm2. Der Zellwirkungsgrad eines solchen optoelektronischen Bauelements, insbesondere einer Solarzelle, mit der Verbindung (29) beträgt 5,48%.

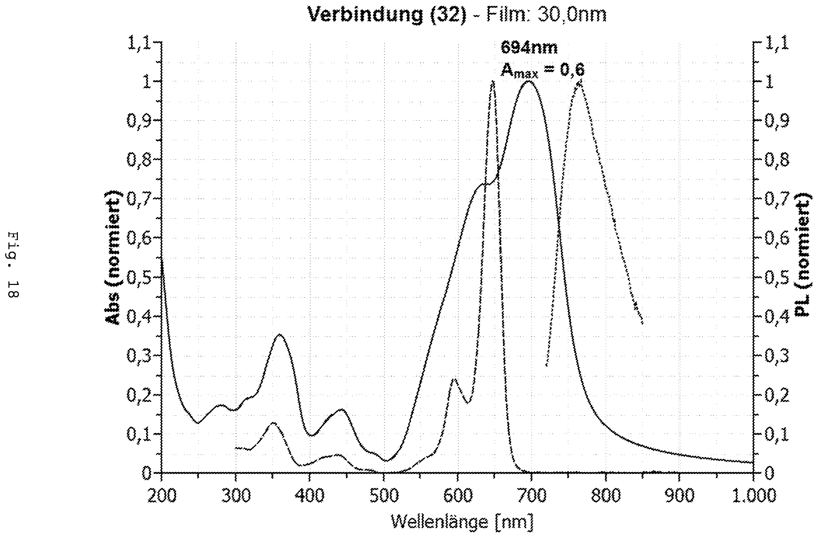

Fig. 18 zeigt eine grafische Darstellung des Absorptionsspektrums der Verbindung (32).

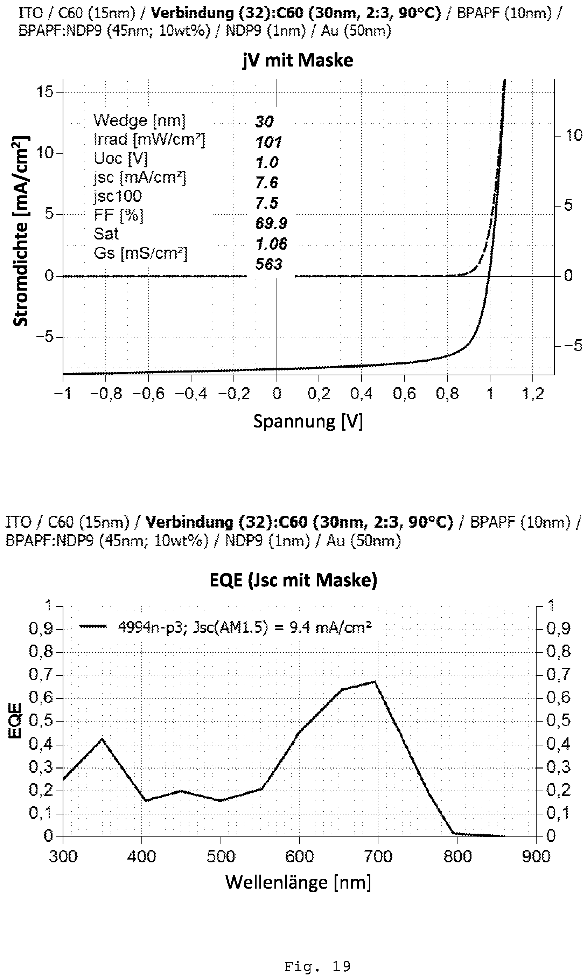

Fig. 19 zeigt eine grafische Darstellung der Strom-Spannungskurve, der spektralen externen Quantenausbeute und des Füllfaktors einer BHJ-Zelle mit der Verbindung (32), gemessen an einem organischen optoelektronischen Bauelement. In diesem Ausführungsbeispiel ist das optoelektronische Bauelement eine organische Solarzelle.

Die Strom-Spannungskurve einer BHJ-Zelle mit dem Aufbau: ITO / C60 (15 nm) / Verbindung(32):C60 (30nm, 3:2, 90°C) / BPAPF (10nm) / BPAPF:NDP9 (45nm, 10wt% NDP9) / NDP9 (1nm) / Au (50nm) wurde bestimmt, wobei die photoaktive Schicht 4 einen Volumenheteroübergang (bulk heterojunction - BHJ) umfasst. In dem optoelektronischen Bauelement mit Verbindung (32) beträgt der Füllfaktor FF 69,9 %, die Leerlaufspannung Uoc 1,0 V und der Kurzschlussstrom Jsc 9,4 mA/cm2. Der Zellwirkungsgrad eines solchen optoelektronischen Bauelements, insbesondere einer Solarzelle, mit der Verbindung (32) beträgt 6,57%.

Die vorteilhaften Eigenschaften der erfindungsgemäßen Verbindungen zeigen sich bei identischem Aufbau der Solarzellen auch in den Parametern Leerlaufspannung Uoc, Kurzschlussstrom Jsc und Füllfaktor FF. Die erfindungsgemäßen Verbindungen weisen nicht nur verbesserte Absorptionseigenschaften auf, sondern auch geeignete Ladungstransporteigenschaften. Die experimentellen Daten der Verbindungen (1), (3), (5), (8), (10), (14), (15), (29) und (32) mit den Absorptionseigenschaften und den in organischen Solarzellen gemessenen Strom-Spannungsverläufen belegen, dass diese Verbindungen für die Anwendung in organischen Solarzellen sowie anderen organischen optoelektronischen Bauelementen sehr gut geeignet sind.

In Tabelle 1 sind die Absorptionsmaxima der Verbindungen (1) bis (32) in Lösung und im Film dargestellt.

**Tabelle 1**

| **Verbindung** | **Absorptionsmaximum [nm] in Lösung** | **Absorptionsmaximum [nm] im Film** | **Schmelzpunkt [°C]** |
|---|---|---|---|
| 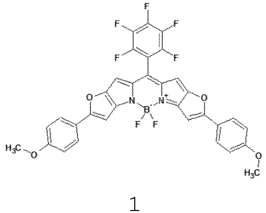 | 700 | 775 | 378 |
| 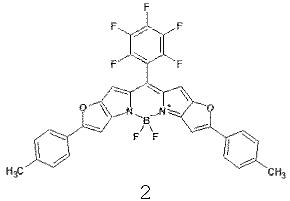 | 682 | 754 | |
| 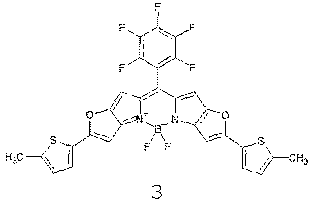 | 718 | 808 | |
| 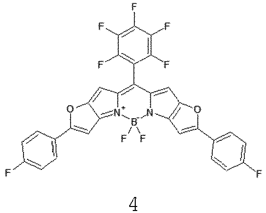 | 671 | 738 | 314 |
| 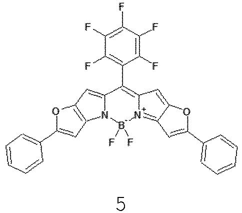 | 672 | 741 | 302 |
| 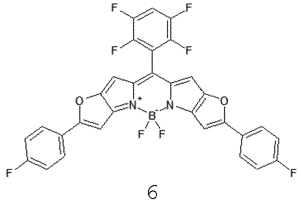 | 669 | 735 | 310 |
| 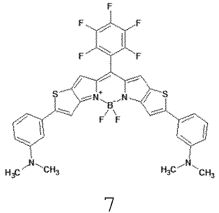 | 693 | 743 | |
| 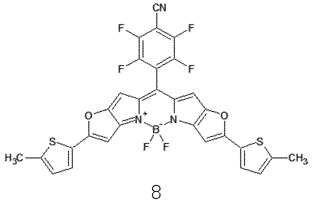 | 728 | 828 | |
| 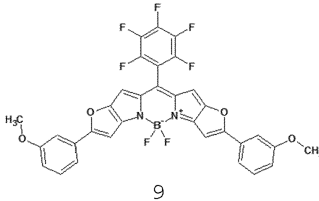 | 677 | 746 | 233 |
| 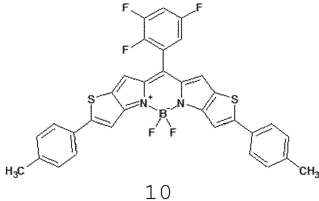 | 678 | 739 | 271 |
| 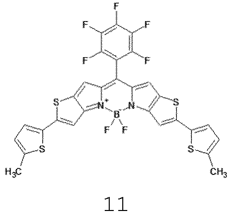 | 730 | 821 | |
| 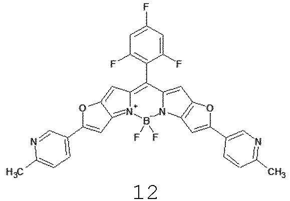 | 666 | 614 | |
| 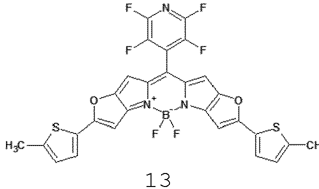 | 727 | 827 | 308 |
| 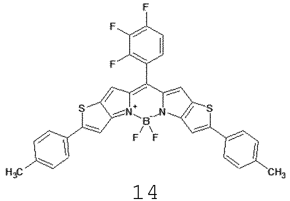 | 673 | 733 | 290 |
| 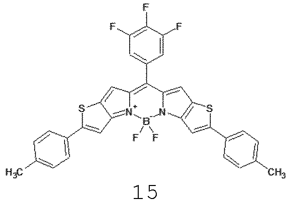 | 669 | 726 | 315 |
| 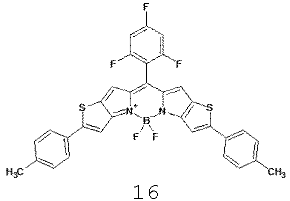 | 680 | 742 | 234 |
| 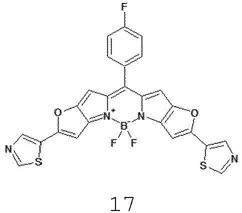 | | | |
| 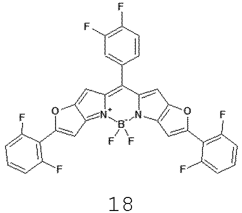 | | | |
| 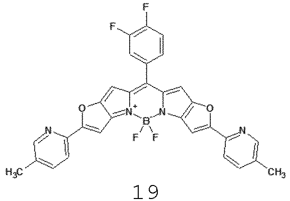 | 652 | 704 | 307 |
| 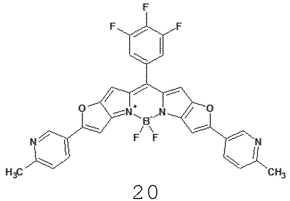 | | | |
| 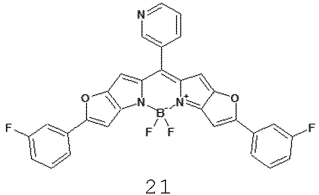 | | | |
| 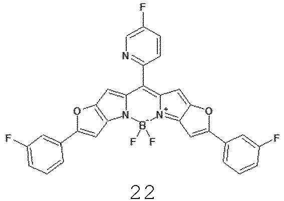 | | | |
| 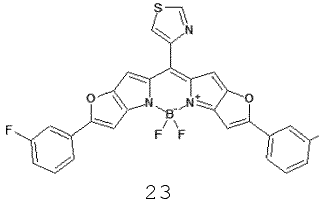 | | | |
| 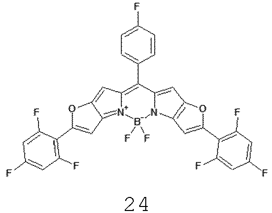 | | | |
| 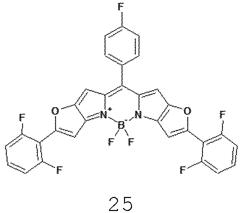 | | | |
| 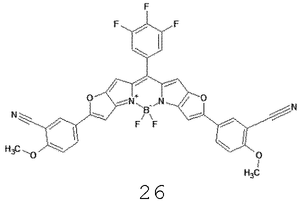 | 671 | 731 | 352 |
| 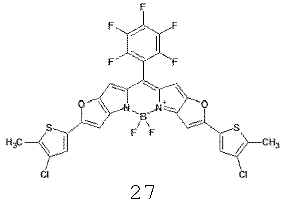 | 715 | 797 | 306 |
| 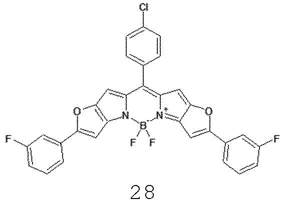 | 650 | 698 | 277 |
| 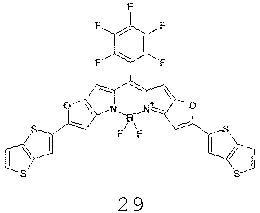 | 742 | 835 | |
| 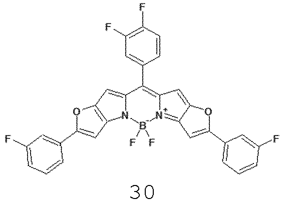 | 651 | 701 | 332 |
| 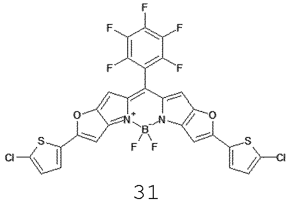 | 711 | 787 | 311 |
| 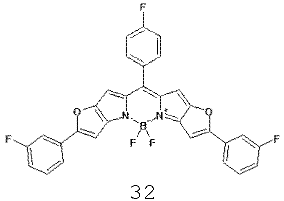 | 650 | 694 | 338 |
| 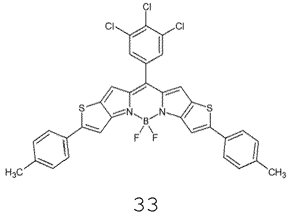 | 670 | 732 | 312 |
| 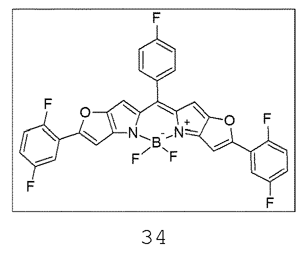 | 648 | 700 | 318 |
| 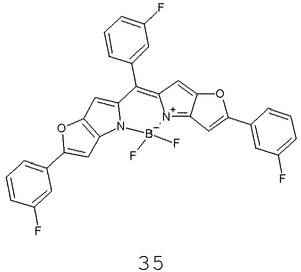 | 651 | 702 | 329 |
| 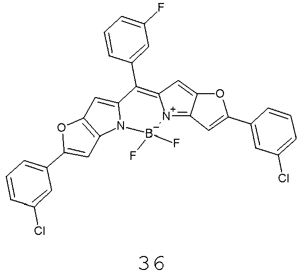 | 652 | 702 | 303 |
| 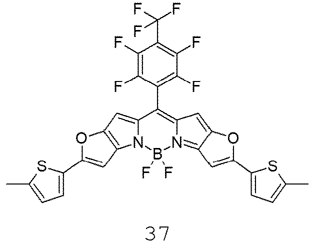 | 724 | 816 | 299 |
| 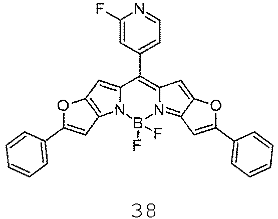 | 660 | 720 | 303 |
| 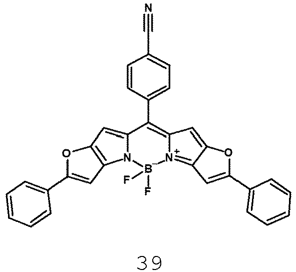 | 659 | 713 | 310 |
| 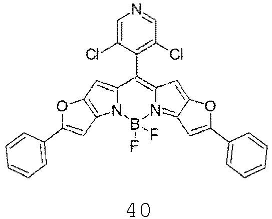 | 670 | 743 | |
| 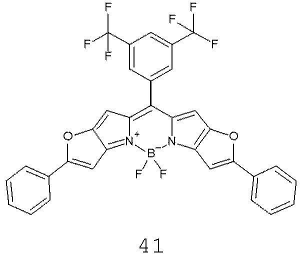 | 660 | 707 | 323 |
| 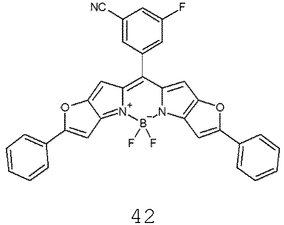 | 661 | 717 | 306 |
| 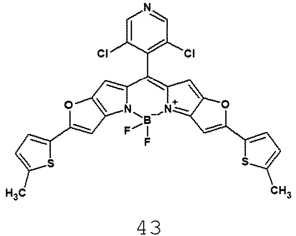 | 715 | 815 | |
| 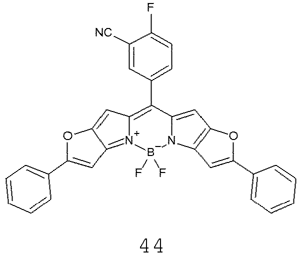 | 659 | 711 | 297 |
| 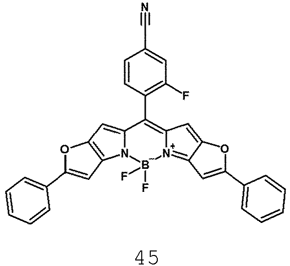 | 665 | 726 | 316 |
| 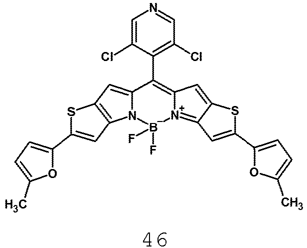 | 731 | 823 | 349 |
| 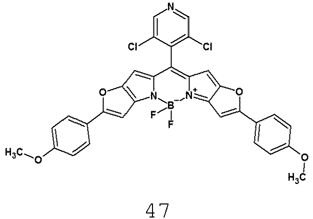 | 697 | 776 | 334 |
| 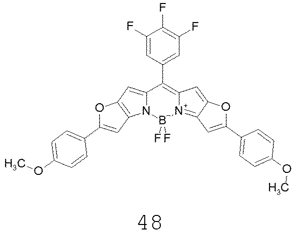 | | 750 | 298 |
| 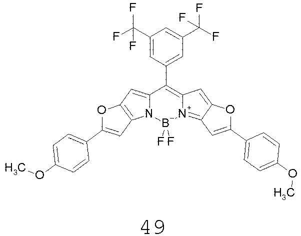 | | 738 | 301 |
| 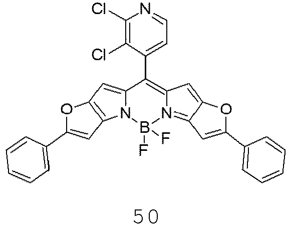 | 665 | 729 | 364 |
| 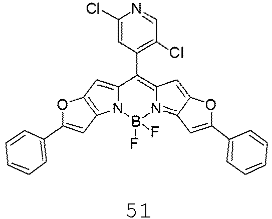 | 667 | 731 | 348 |
| 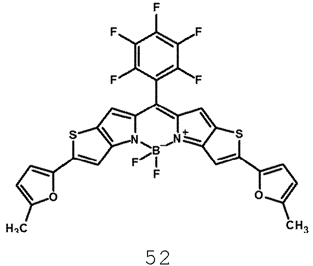 | 735 | 832 | 306 |
| 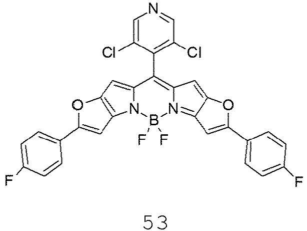 | 668 | 742 | 397 |
| 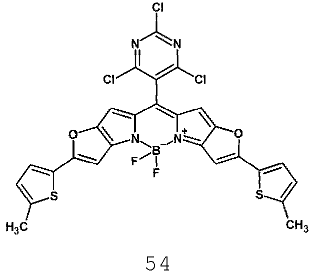 | 725 | 821 | 307 |
| 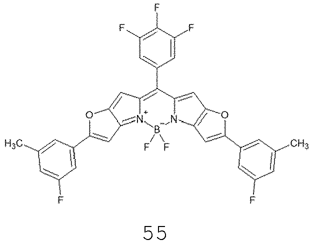 | 659 | 707 | 324 |
| 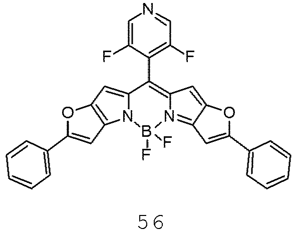 | 671 | 744 | 371 |
| 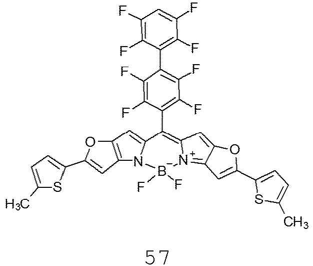 | 718 | 808 | 314 |
| 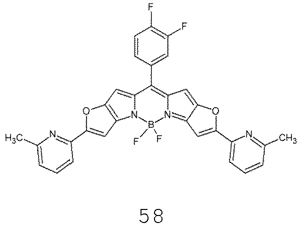 | 652 | 704 | 304 |
| 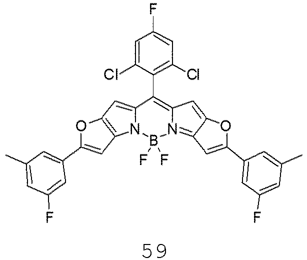 | 667 | 738 | 350 |
| 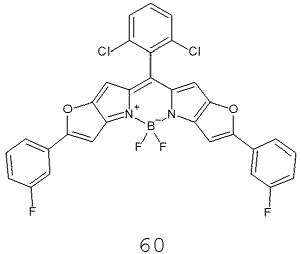 | 661 | | 314 |
| 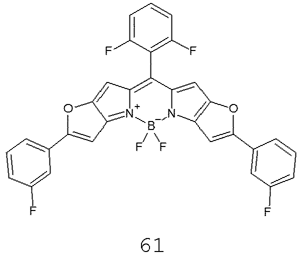 | 661 | | 295 |

Die optischen Eigenschaften wurden experimentell bestimmt. Die Absorptionsmaxima Amax wurden in einer Küvette mit Dichlormethan und aus 30nm dicken Vakuumaufdampfschichten auf Quarzglas mittels eines Photometers bestimmt. Überraschenderweise wurde gefunden, dass die Verbindungen (1) bis (32) im Film besonders breit im nahinfraroten, für das menschliche Auge nicht mehr sichtbaren Bereich, oberhalb von 650 nm absorbieren. Es konnte zudem gezeigt werden, dass die Verbindungen (1) bis (32) eine hohe thermische Stabilität aufweisen und im Vakuum ohne Zersetzung verdampfbar sind. Ergänzend sind in Tabelle 1 die Schmelztemperaturen DSC dargestellt.

Tabelle 2 zeigt die photovoltaischen Parameter Voc, Jsc und FF Parameter der erfindungsgemäßen Verbindungen (1) bis (32) im direkten Vergleich. Die Zellen haben folgenden Aufbau: Glas mit ITO / C60 (15 nm) / Absorber:C60 (30nm, 3:2, 90°C) / BPAPF (10nm) / BPAPF:NDP9 (45nm, 10wt% NDP9) / NDP9 (1nm) / Au (50nm) und wurde unter AM1.5 Beleuchtung gemessen (AM = Air Mass; AM = 1,5 bei diesem Spektrum beträgt die globale Strahlungsleistung 1000 W/m²; AM = 1,5 als Standardwert für die Vermessung von Solarmodulen).

**Tabelle 2**

| **Verbindung** | **Voc [V]** | **Jsc [mA/cm² ]** | **FF [%]** | **Eff [%]** |
|---|---|---|---|---|
| (1) | 0,71 | 10,2 | 69,7 | 5,05 |
| (2) | 0,87 | 9,6 | 70,3 | 5,87 |
| (3) | 0,69 | 11,4 | 73,4 | 5,77 |
| (5) | 0,95 | 9,4 | 71,7 | 6,40 |
| (8) | 0,72 | 11,0 | 70,4 | 5,58 |
| (10) | 0,90 | 9,6 | 67,6 | 5,84 |
| (13) | 0,74 | 12,0 | 70,0 | 6,22 |
| (14) | 0,91 | 10,2 | 65,0 | 6,03 |
| (15) | 0,95 | 9,7 | 67,7 | 6,24 |
| (29) | 0,68 | 12,6 | 64,0 | 5,48 |
| (32) | 1,0 | 9,4 | 69,9 | 6,57 |
| (37) | 0,70 | 11,7 | 67,5 | 5,53 |
| (38) | 0,97 | 9,6 | 67,3 | 6,27 |
| (41) | 0,98 | 8,5 | 69,3 | 5,77 |
| (43) | 0,72 | 11,0 | 62,4 | 4,94 |
| (45) | 0,97 | 8,8 | 63,5 | 5,42 |
| (47) | 0,76 | 10,3 | 63,8 | 4,99 |
| (48) | 0,76 | 10,5 | 69,8 | 5,57 |
| (49) | 0,76 | 10,3 | 73,1 | 5,73 |
| (54) | 0,79 | 11,3 | 63,6 | 5,68 |

Die experimentellen Daten erfindungsgemäßer Verbindungen mit den Absorptionseigenschaften der Verbindungen und den in organischen Solarzellen gemessenen Strom-Spannungsverläufen belegen, dass die erfindungsgemäßen Verbindungen für die Anwendung in organischen Solarzellen sowie anderen organischen optoelektronischen Bauelementen sehr gut geeignet sind.

## Patentansprüche

1. Chemische Verbindung gemäß der allgemeinen Formel I, 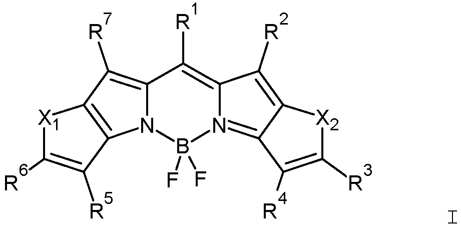 wobei
X1 und X2 unabhängig voneinander O, S oder N-R8 sind mit R8 ausgewählt aus der Gruppe bestehend aus H, Alkyl, Aryl, und Heteroaryl,
R1 ein substituierter homocyclischer 6-Ring, wobei mindestens ein H-Atom durch einen elektronenziehenden Substituenten ausgewählt aus der Gruppe bestehend aus F, Cl, CN, CF3, und COR8 mit R8 C1-C4-Alkyl substituiert ist, oder ein substituierter oder nicht-substituierter heterocyclischer 5-Ring oder 6-Ring ist, wobei der heterocyclische 5-Ring oder 6-Ring mindestens ein sp2-hybridisiertes N-Atom mit einem freien Elektronenpaar aufweist und/oder mindestens ein Heteroatom ausgewählt aus O, S, oder N aufweist, wobei im substituierten heterocyclischen 5-Ring oder 6-Ring mindestens ein H-Atom durch einen elektronenziehenden Substituenten ausgewählt aus der Gruppe bestehend aus F, Cl, CN, CF3, und COR9 mit R9 C1-C4-Alkyl substituiert ist,
R2 und R7 unabhängig voneinander ausgewählt sind aus der Gruppe bestehend aus H, Halogen, CN, Alkyl, fluoriertem oder teilfluoriertem Alkyl, und ungesättigtem Alkyl,
R4 und R5 unabhängig voneinander ausgewählt sind aus der Gruppe bestehend aus H, Halogen, CN, Alkyl, fluoriertem oder teilfluoriertem Alkyl, ungesättigtem Alkyl, und Alkoxy, und
R3 und R6 unabhängig voneinander ein substituierter oder nicht-substituierter homocyclischer 6-Ring oder ein substituierter oder nicht-substituierter heterocyclischer 5-Ring oder 6-Ring sind.

2. Chemische Verbindung nach Anspruch 1, wobei X1 und X2 S sind oder X1 und X2 O sind, und/oder wobei mindestens ein H-Atom in dem homocyclischen 6-Ring und/oder in dem heterocyclischen 5-Ring oder 6-Ring R1 durch F oder CF3 substituiert ist, bevorzugt durch F.

3. Chemische Verbindung nach Anspruch 1 oder 2, wobei R3 und R4 und/oder R5 und R6 jeweils zusammen einen heterocyclischen 5-Ring oder 6-Ring mit mindestens einem Heteroatom ausgewählt aus O, S oder N, bevorzugt O oder S, bilden, wobei bevorzugt der heterocyclische 5-Ring oder 6-Ring nicht substituiert ist, oder einen homocyclischen 6-Ring bilden.

4. Chemische Verbindung nach einem der vorhergehenden Ansprüche, wobei R1 ein homocyclischer 6-Ring mit der Bedingung R1 gleich C₆HₙF₅₋ₙ mit n=0,1,2,3,4 ist.

5. Chemische Verbindung nach einem der vorhergehenden Ansprüche, wobei R1 ausgewählt ist aus der Gruppe bestehend aus: 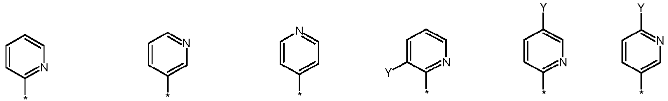 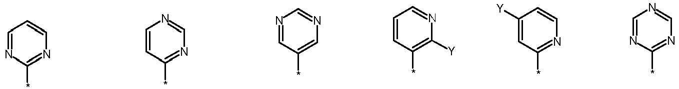 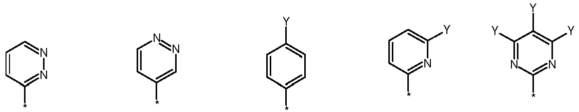 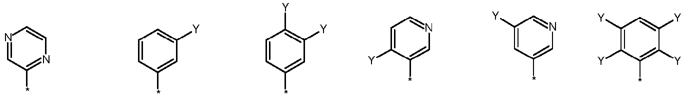 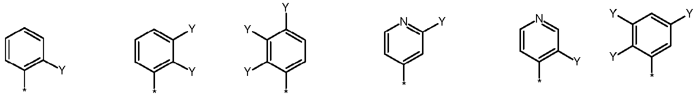 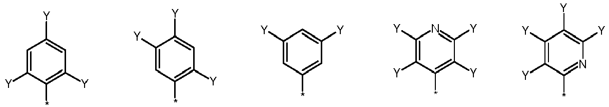 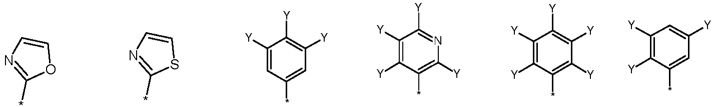 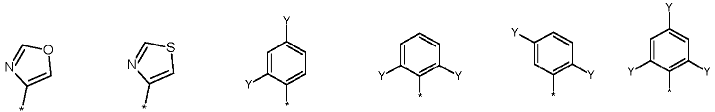 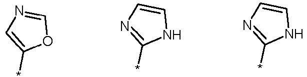 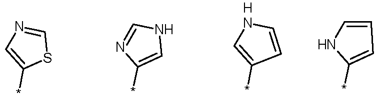 wobei * die Anknüpfung an die Verbindung der allgemeinen Formel I bezeichnet, wobei Y unabhängig voneinander ausgewählt ist aus der Gruppe bestehend aus Cl, CN, F und CF3, bevorzugt ist Y F, und wobei H-Atome substituiert oder nicht-substituiert sind.

6. Chemische Verbindung nach einem der vorhergehenden Ansprüche, wobei R3 und R6 unabhängig voneinander ausgewählt sind aus der Gruppe bestehend aus 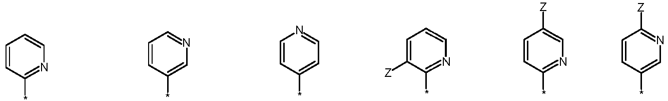 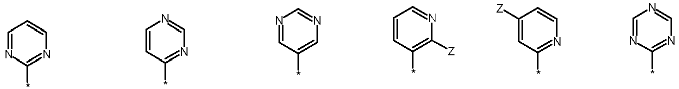 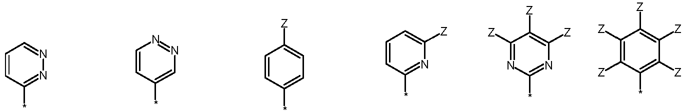 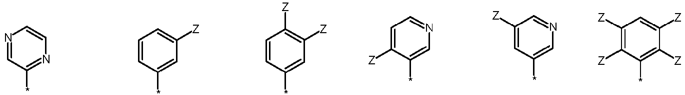 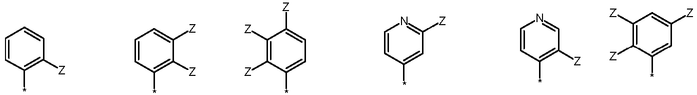 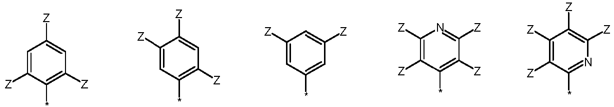 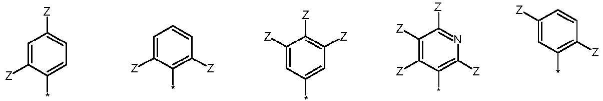 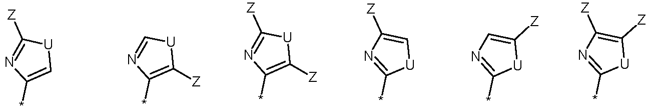 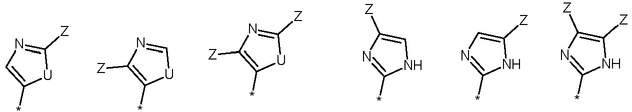 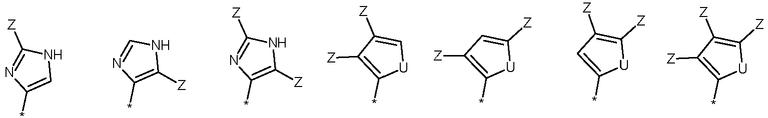 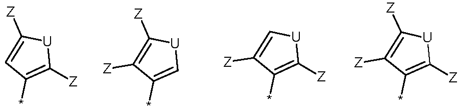
wobei * die Anknüpfung an die Verbindung der allgemeinen Formel I bezeichnet,
wobei U ausgewählt ist aus der Gruppe bestehend aus O, S und NR19, wobei R19 ausgewählt ist aus der Gruppe bestehend aus H, Halogen, Alkyl, fluoriertem Alkyl, teilfluoriertem Alkyl, Alkoxy, Alkenyl, Aryl, und Heteroaryl, bevorzugt ist U O oder S, und wobei Z unabhängig voneinander ausgewählt ist aus der Gruppe bestehend aus H, Halogen, bevorzugt F, CF3, CN, Alkyl, fluoriertem Alkyl, teilfluoriertem Alkyl, Alkenyl, Alkoxy, N-Alkyl, NAlkyl2, Aryl, und Heteroaryl,
wobei bevorzugt R3 und R6 gleich sind.

7. Chemische Verbindung nach einem der vorhergehenden Ansprüche, wobei R3 und/oder R6 weiter anneliert sind, und/oder R1 ein monocyclischer 5-Ring oder 6-Ring ist.

8. Chemische Verbindung nach einem der vorhergehenden Ansprüche, wobei R2 und R7 unabhängig voneinander ausgewählt sind aus der Gruppe bestehend aus H, Halogen, CN, und C1-C4-Alkyl, bevorzugt sind R2 und R7 H, und/oder R4 und R5 unabhängig voneinander ausgewählt sind aus der Gruppe bestehend aus H, Halogen, CN, und C1-C4-Alkyl, bevorzugt sind R4 und R5 H.

9. Chemische Verbindung nach einem der vorhergehenden Ansprüche, wobei R1 ein heterocyclischer 5-Ring oder 6-Ring mit mindestens einem sp2-hybridisierten N-Atom mit einem freien Elektronenpaar im Ringsystem ist, bevorzugt ist R1 ausgewählt aus der Gruppe bestehend aus substituiertem oder nicht-substituiertem Imidazol, Pyrazol, Triazol, Tetrazol, Pyridin, Pyrimidin, Pyrazin, Pyridazin, Triazin, Oxazol, Isoxazol, Thiazol, und Isothiazol.

10. Chemische Verbindung nach einem der vorhergehenden Ansprüche, wobei die Verbindung ausgewählt ist aus der Gruppe bestehend aus:

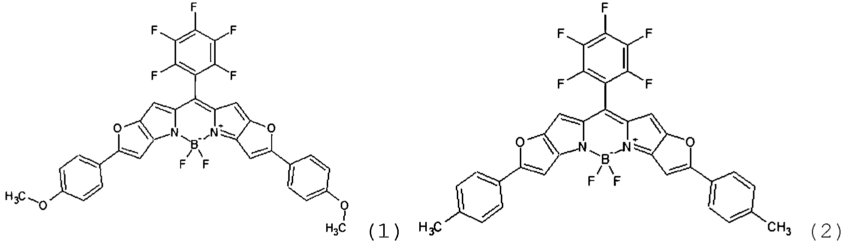

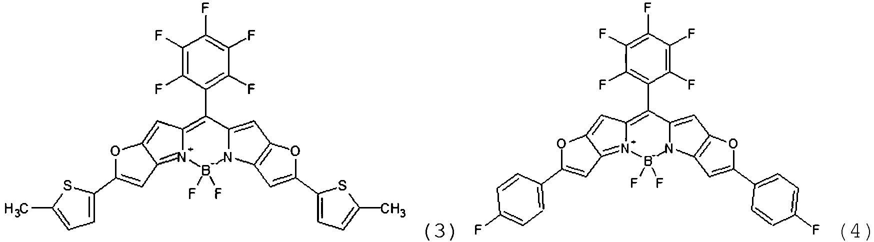

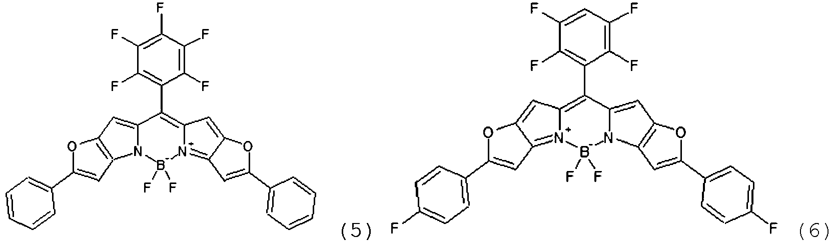

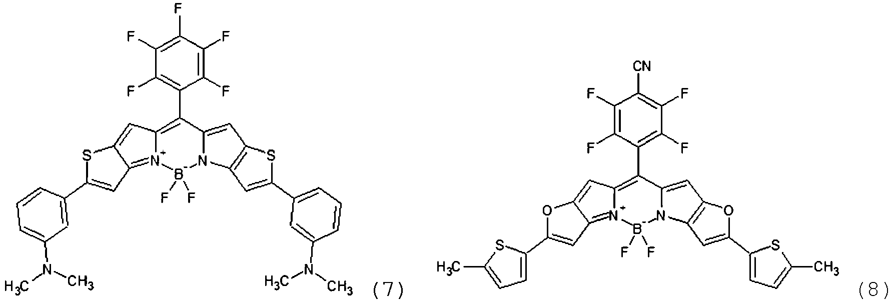

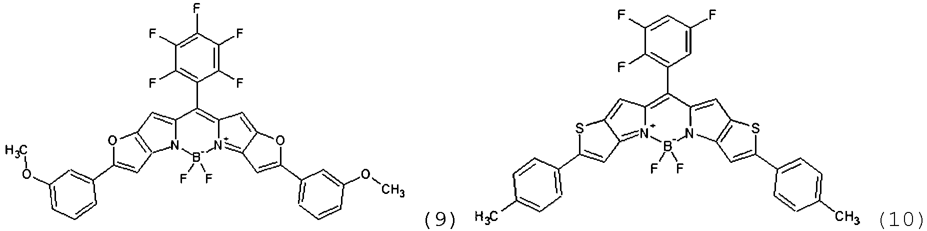

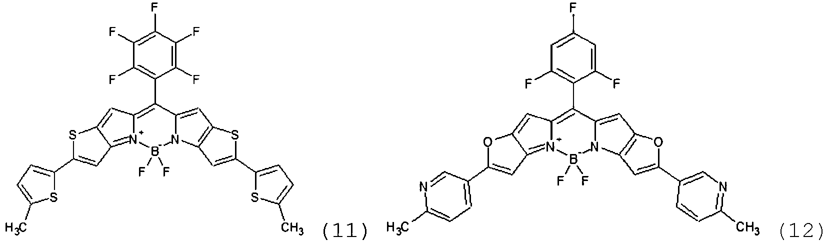

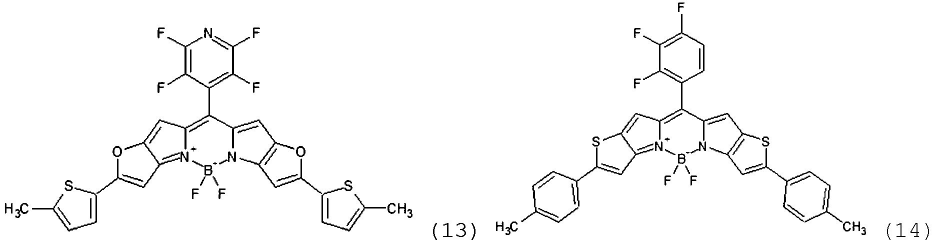

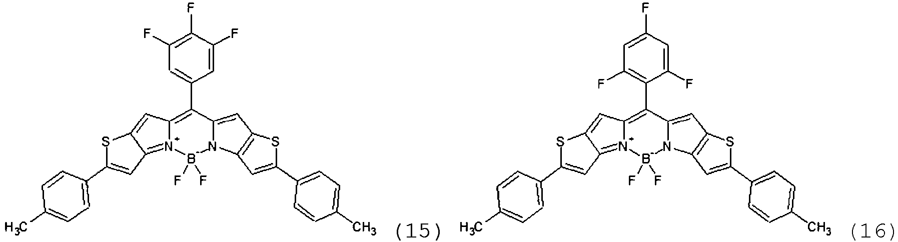

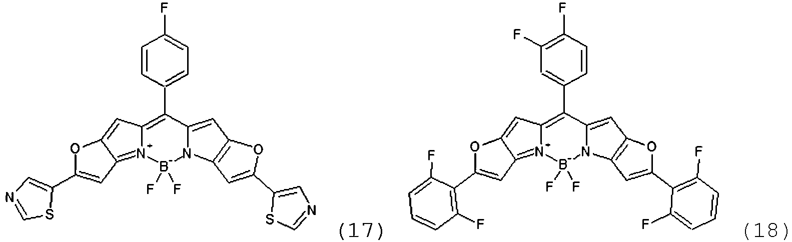

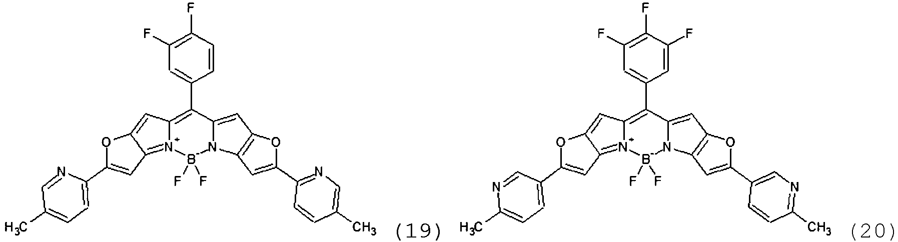

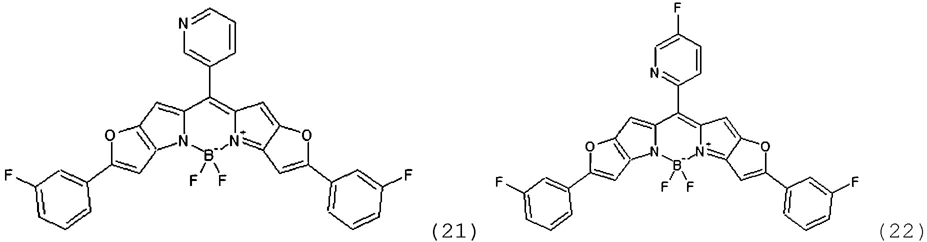

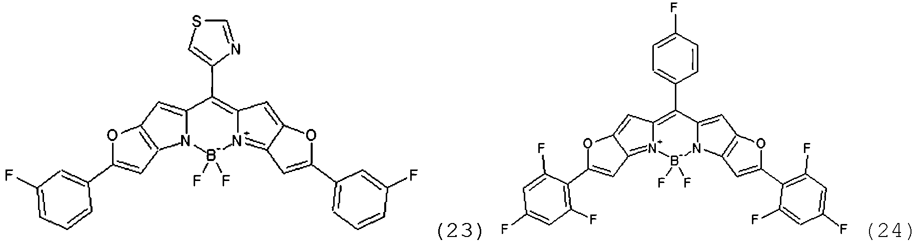

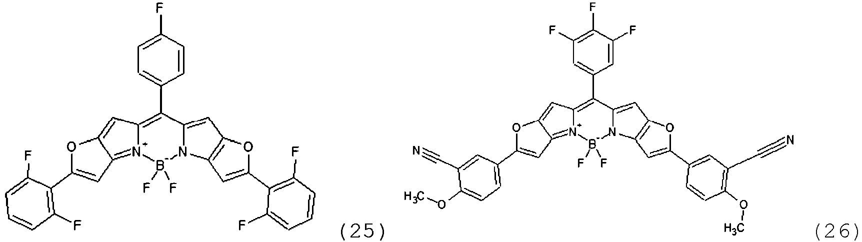

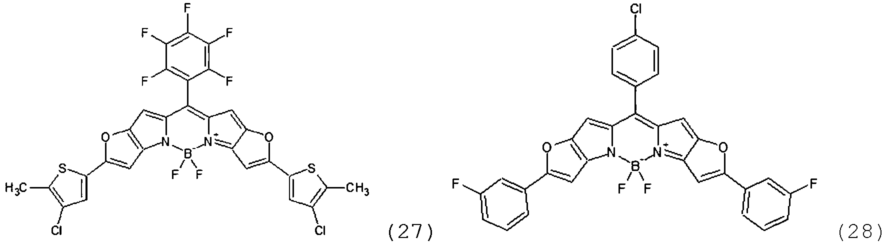

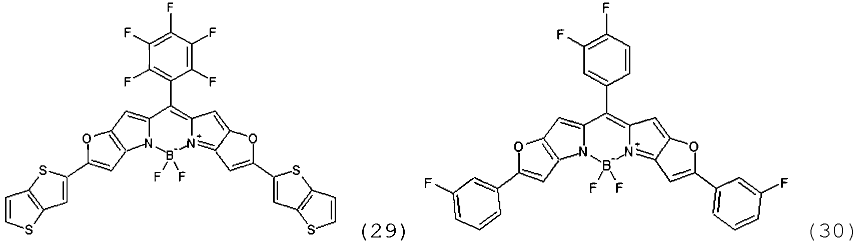

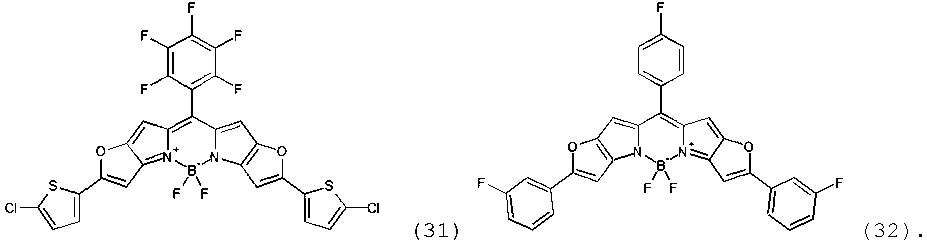

11. Chemische Verbindung nach einem der vorhergehenden Ansprüche, wobei alle H-Atome in R1 durch ein Halogen oder CN substituiert sind, bevorzugt sind alle H-Atome durch F substituiert.

12. Chemische Verbindung nach einem der vorhergehenden Ansprüche, wobei die Verbindung ein Molgewicht von 300-1500 g/mol aufweist.

13. Verwendung mindestens einer Verbindung nach einem der Ansprüche 1 bis 12 in einem optoelektronischen Bauelement, bevorzugt einem organischen optoelektronischen Bauelement, insbesondere bevorzugt einer organischen Solarzelle, einer OLED, einem OFET, oder einem organischen Photodetektor.

14. Optoelektronisches Bauelement mit einem Schichtsystem wobei zumindest eine Schicht des Schichtsystems eine Verbindung nach einem der Ansprüche 1 bis 12 aufweist, wobei das optoelektronische Bauelement bevorzugt ein organisches optoelektronisches Bauelement ist, insbesondere bevorzugt eine organische Solarzelle, ein OFET, eine OLED oder ein organischer Photodetektor.

15. Optoelektronisches Bauelement nach Anspruch 14, wobei das optoelektronische Bauelement ein Schichtsystem mit mindestens einer photoaktiven Schicht aufweist, bevorzugt eine lichtabsorbierende photoaktive Schicht, wobei die mindestens eine photoaktive Schicht die mindestens eine Verbindung nach einem der Ansprüche 1 bis 12 aufweist.

## Claims

1. Chemical compound according to general formula I, 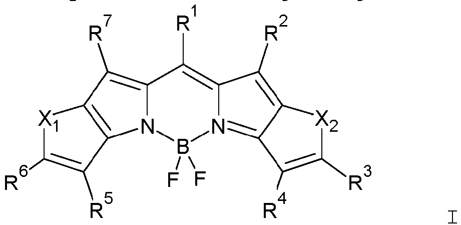 where
X1 and X2 independently of one another are O, S or N-R8, with R8 selected from the group consisting of H, alkyl, aryl, and heteroaryl,
R1 is a substituted homocyclic 6-membered ring, where at least one H atom is substituted by an electron-withdrawing substituent selected from the group consisting of F, Cl, CN, CF3, and COR8, with R8 being C1-C4 alkyl, or is a substituted or unsubstituted heterocyclic 5-membered ring or 6-membered ring, where the heterocyclic 5-membered ring or 6-membered ring has at least one sp2 hybridized N atom with a free electron pair and/or has at least one heteroatom selected from O, S, or N, where in the substituted heterocyclic 5-membered ring or 6-membered ring at least one H atom is substituted by an electron-withdrawing substituent selected from the group consisting of F, Cl, CN, CF3, and COR9, with R9 being C1-C4 alkyl,
R2 and R7 independently of one another are selected from the group consisting of H, halogen, CN, alkyl, fluorinated or part-fluorinated alkyl, and unsaturated alkyl,
R4 and R5 independently of one another are selected from the group consisting of H, halogen, CN, alkyl, fluorinated or part-fluorinated alkyl, unsaturated alkyl, and alkoxy, and
R3 and R6 independently of one another are a substituted or unsubstituted homocyclic 6-membered ring or a substituted or unsubstituted heterocyclic 5-membered ring or 6-membered ring.

2. Chemical compound according to Claim 1, where X1 and X2 are S or X1 and X2 are O, and/or where at least one H atom in the homocyclic 6-membered ring and/or in the heterocyclic 5-membered ring or 6-membered ring R1 is substituted by F or CF3, preferably by F.

3. Chemical compound according to Claim 1 or 2, where R3 and R4 and/or R5 and R6 in each case together form a heterocyclic 5-membered ring or 6-membered ring having at least one heteroatom selected from O, S or N, preferably O or S, where preferably the heterocyclic 5-membered ring or 6-membered ring is unsubstituted, or form a homocyclic 6-membered ring.

4. Chemical compound according to any of the preceding claims, where R1 is a homocyclic 6-membered ring with the condition that R1 is C₆HₙF₅₋ₙ, where n = 0, 1, 2, 3, 4.

5. Chemical compound according to any of the preceding claims, where R1 is selected from the group consisting of: 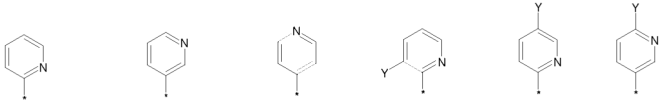 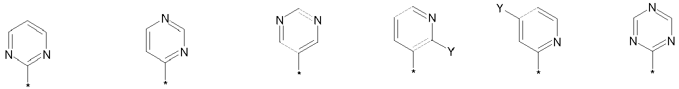 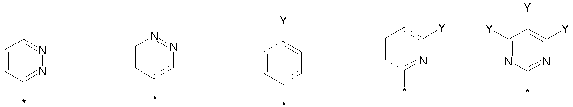 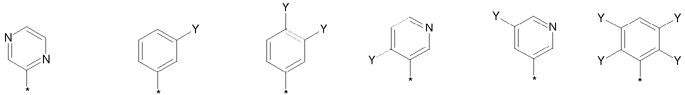 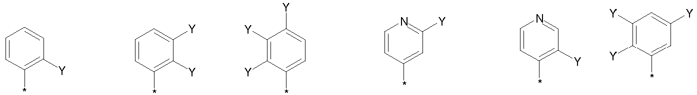 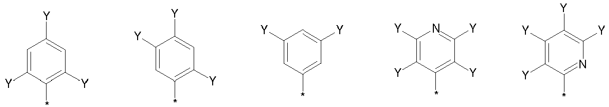 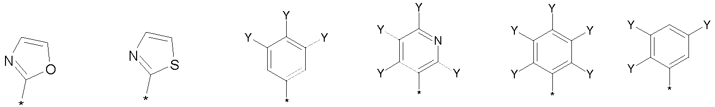 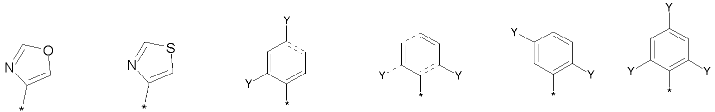 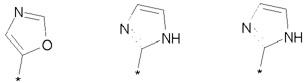 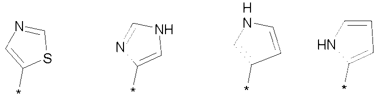 where * denotes the attachment to the compound of the general formula I, where Y independently at each occurrence is selected from the group consisting of Cl, CN, F, and CF3, preferably Y is F, and where H atoms are substituted or unsubstituted.

6. Chemical compound according to any of the preceding claims, where R3 and R6 independently of one another are selected from the group consisting of 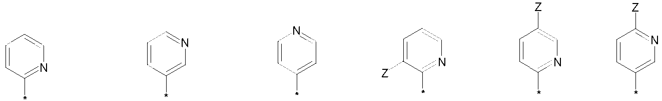 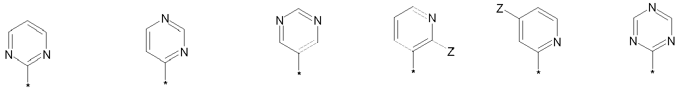 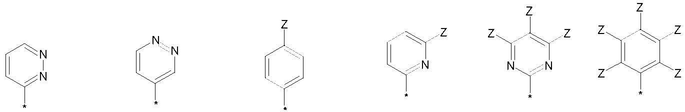 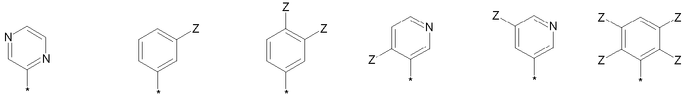 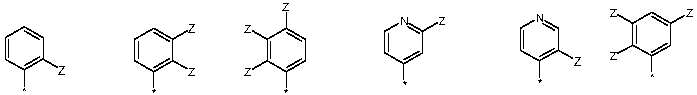 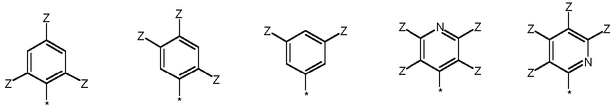 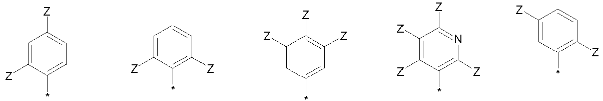 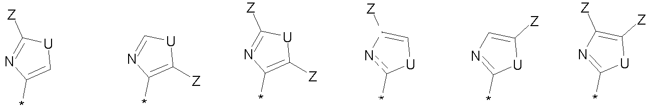 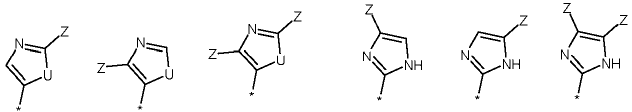 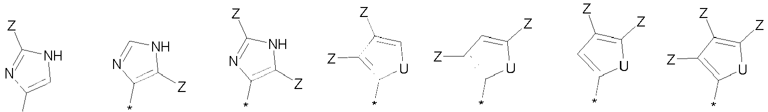 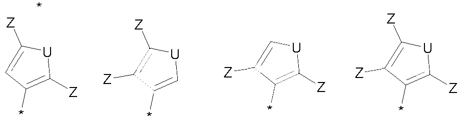
where * denotes the attachment to the compound of the general formula I,
where U is selected from the group consisting of O, S, and NR19, where R19 is selected from the group consisting of H, halogen, alkyl, fluorinated alkyl, part-fluorinated alkyl, alkoxy, alkenyl, aryl, and heteroaryl, preferably U is O or S, and where Z independently of one another is selected from the group consisting of H, halogen, preferably F, CF3, CN, alkyl, fluorinated alkyl, part-fluorinated alkyl, alkenyl, alkoxy, N-alkyl, Nalkyl2, aryl, and heteroaryl,
where preferably R3 and R6 are identical.

7. Chemical compound according to any of the preceding claims, where R3 and/or R6 are additionally fused, and/or R1 is a monocyclic 5-membered ring or 6-membered ring.

8. Chemical compound according to any of the preceding claims, where R2 and R7 independently of one another are selected from the group consisting of H, halogen, CN, and C1-C4 alkyl, preferably R2 and R7 are H, and/or R4 and R5 independently of one another are selected from the group consisting of H, halogen, CN, and C1-C4 alkyl, preferably R4 and R5 are H.

9. Chemical compound according to any of the preceding claims, where R1 is a heterocyclic 5-membered ring or 6-membered ring having at least one sp2-hybridized N atom with a free electron pair in the ring system, preferably R1 is selected from the group consisting of substituted or unsubstituted imidazole, pyrazole, triazole, tetrazole, pyridine, pyrimidine, pyrazine, pyridazine, triazine, oxazole, isoxazole, thiazole, and isothiazole.

10. Chemical compound according to any of the preceding claims, where the compound is selected from the group consisting of:

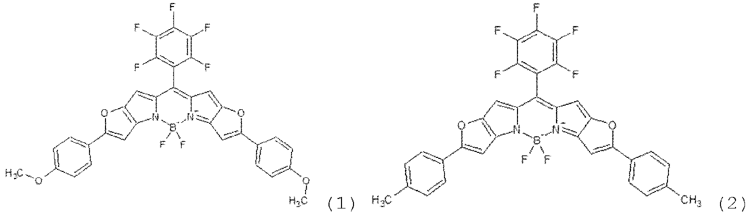

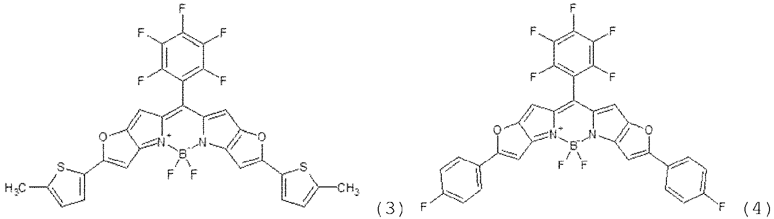

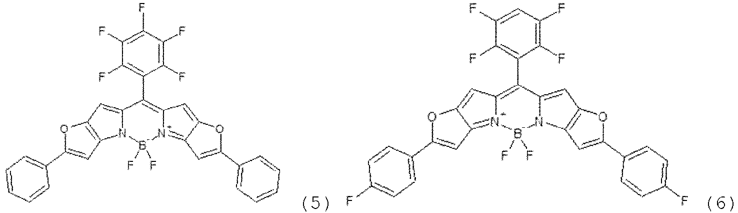

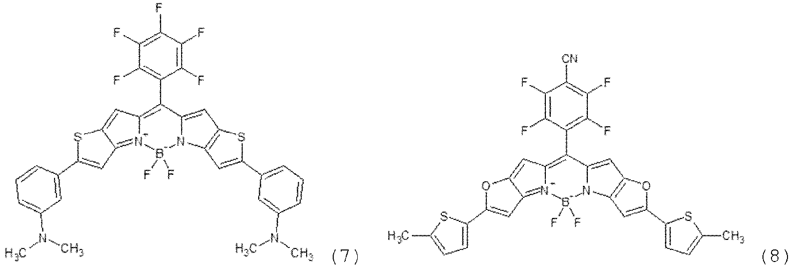

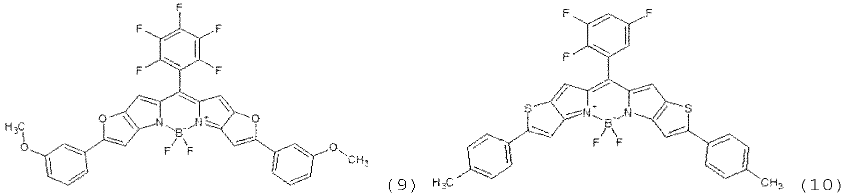

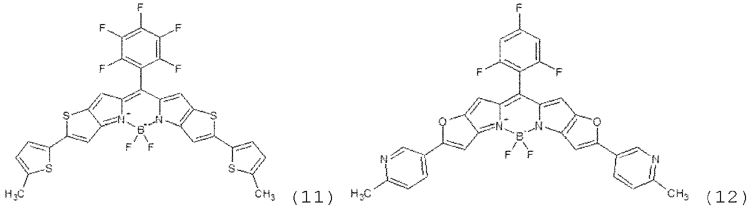

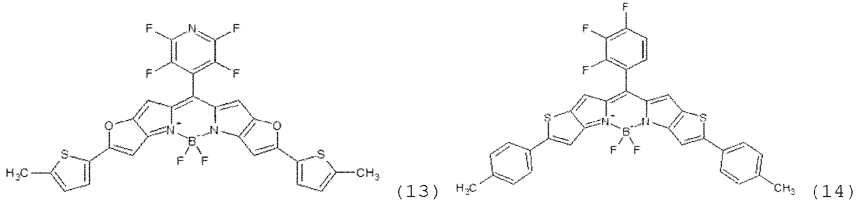

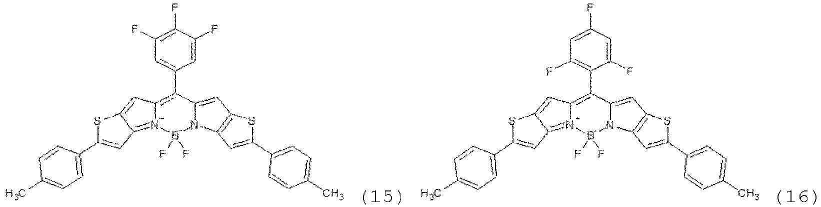

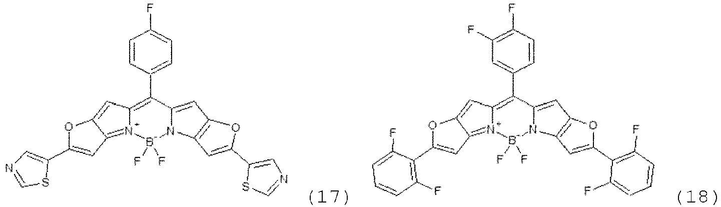

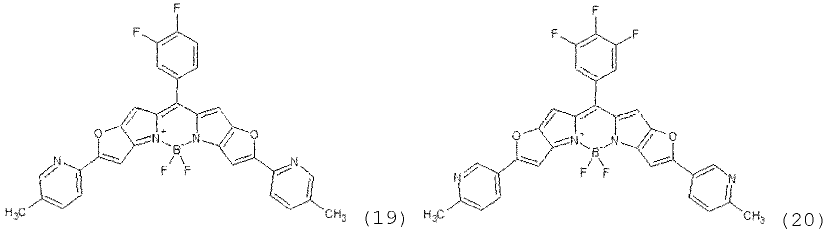

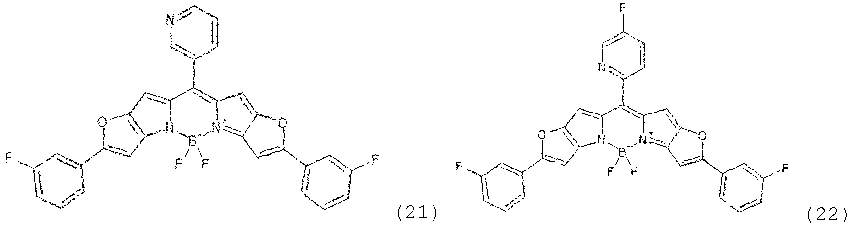

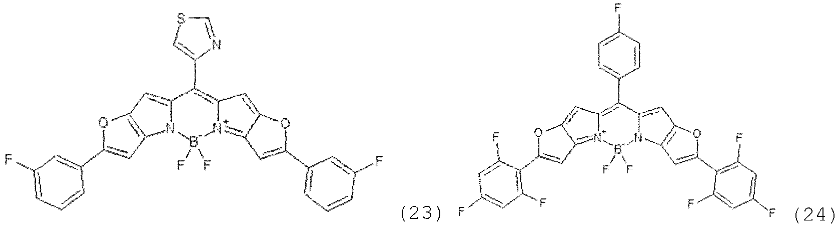

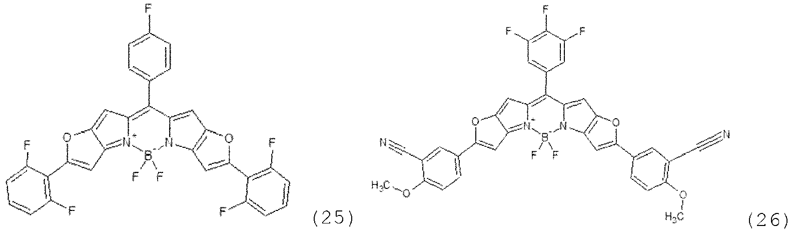

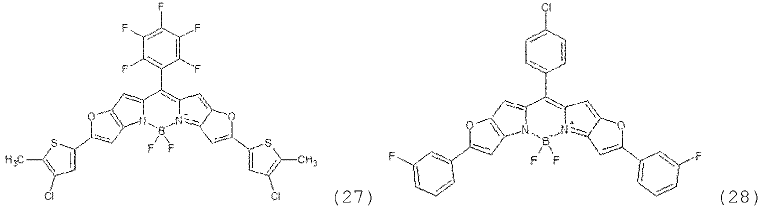

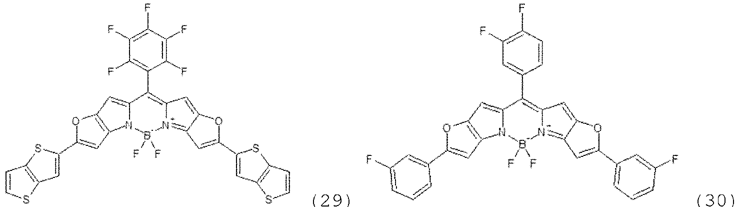

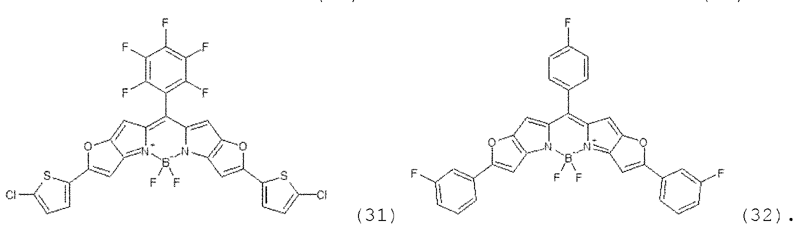

11. Chemical compound according to any of the preceding claims, where all the H atoms in R1 are substituted by a halogen or CN, preferably all the H atoms are substituted by F.

12. Chemical compound according to any of the preceding claims, where the compound has a molar weight of 300-1500 g/mol.

13. Use of at least one compound according to any of Claims 1 to 12 in an optoelectronic component, preferably an organic optoelectronic component, especially preferably an organic solar cell, an OLED, an OFET, or an organic photodetector.

14. Optoelectronic component having a layer system, where at least one layer of the layer system comprises a compound according to any of Claims 1 to 12, where the optoelectronic component is preferably an organic optoelectronic component, especially preferably an organic solar cell, an OFET, an OLED, or an organic photodetector.

15. Optoelectronic component according to Claim 14, where the optoelectronic component has a layer system with at least one photoactive layer, preferably a light-absorbing photoactive layer, where the at least one photoactive layer comprises the at least one compound according to any of Claims 1 to 12.

## Revendications

1. Composé chimique selon la formule générale I, 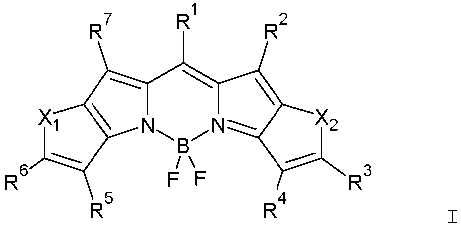
X1 et X2 représentant indépendamment l'un de l'autre O, S ou N-R8, R8 étant choisi dans le groupe constitué de H, alkyle, aryle et hétéroaryle,
R1 étant un cycle à 6 éléments homocyclique substitué, au moins un atome d'hydrogène étant substitué par un substituant attracteur d'électrons choisi dans le groupe constitué de F, Cl, CN, CF3, et COR8 avec R8 étant un alkyle en C1-C4, ou étant un cycle à 5 ou 6 éléments hétérocyclique substitué ou non substitué, le cycle à 5 ou 6 éléments hétérocyclique comportant au moins un atome d'azote soumis à une hybridation sp2 avec une paire d'électrons libres et/ou comportant au moins un hétéroatome choisi parmi O, S, ou N, au moins un atome d'hydrogène dans le cycle à 5 ou 6 éléments hétérocyclique substitué étant substitué par un substituant attracteur d'électrons choisi dans le groupe constitué de F, Cl, CN, CF3 et COR9, R9 étant un alkyle en C1-C4,
R2 et R7 étant choisis indépendamment l'un de l'autre dans le groupe constitué de H, halogène, CN, alkyle, alkyle fluoré ou partiellement fluoré et alkyle insaturé, R4 et R5 étant choisis indépendamment l'un de l'autre dans le groupe constitué de H, halogène, CN, alkyle, alkyle fluoré ou partiellement fluoré, alkyle insaturé et alcoxy, et
R3 et R6 étant indépendamment l'un de l'autre un cycle à 6 éléments homocyclique substitué ou non substitué ou un cycle à 5 éléments ou à 6 éléments hétérocyclique substitué ou non substitué.

2. Composé chimique selon la revendication 1, X1 et X2 étant S ou X1 et X2 étant O, et/ou au moins un atome d'hydrogène dans le cycle à 6 éléments homocyclique et/ou dans le cycle à 5 éléments hétérocyclique ou le cycle à 6 éléments hétérocyclique R1 étant substitué par F ou CF3, de manière préférée par F.

3. Composé chimique selon la revendication 1 ou 2, R3 et R4 et/ou R5 et R6 formant chacun ensemble un cycle à 5 éléments ou à 6 éléments hétérocyclique avec au moins un hétéroatome choisi parmi O, S ou N, de manière préférée O ou S, le cycle à 5 éléments ou à 6 éléments hétérocyclique étant de manière préférée non substitué, ou formant un cycle à 6 éléments homocyclique.

4. Composé chimique selon l'une des revendications précédentes, R1 étant un cycle à 6 éléments homocyclique avec la condition que R1 est C₆HₙF₅₋ₙ avec n = 0, 1, 2, 3, 4.

5. Composé chimique selon l'une des revendications précédentes, R1 étant choisi dans le groupe constitué de : 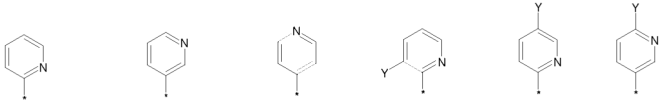 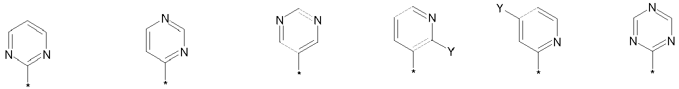 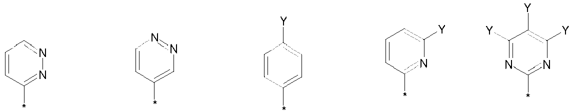 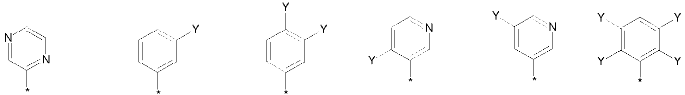 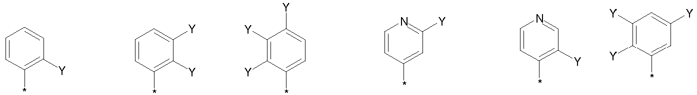 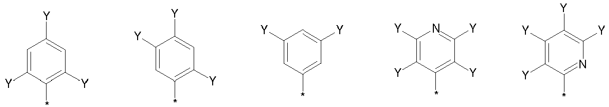 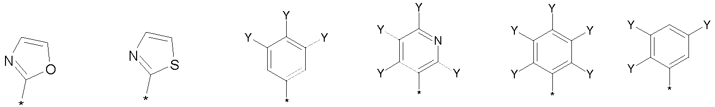 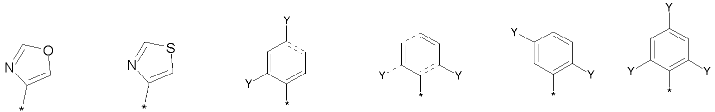 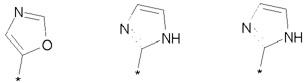 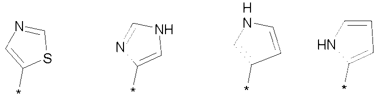 * désignant la fixation au composé de la formule générale I, Y étant choisi indépendamment dans le groupe constitué de Cl, CN, F et CF3, Y étant de manière préférée F, et les atomes d'hydrogène étant substitués ou non substitués.

6. Composé chimique selon l'une des revendications précédentes, R3 et R6 étant choisis indépendamment l'un de l'autre dans le groupe constitué de 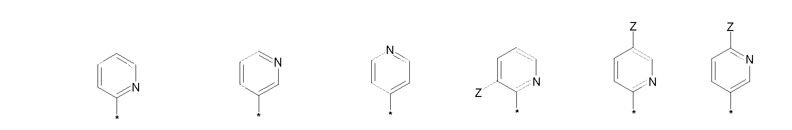 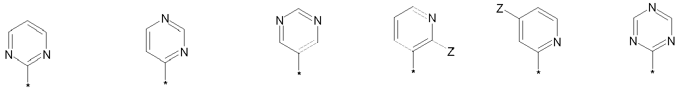 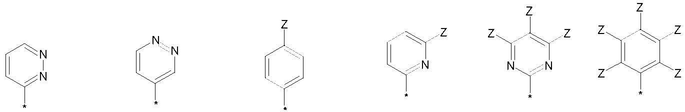 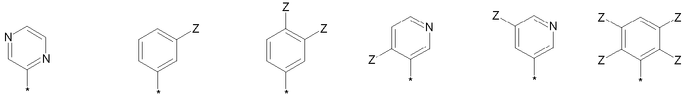 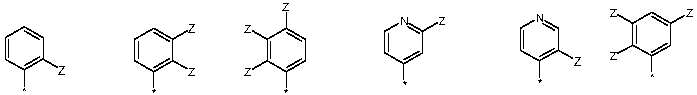 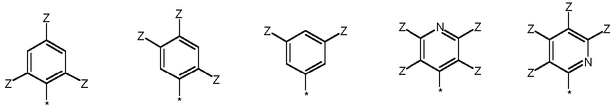 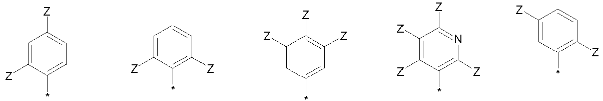 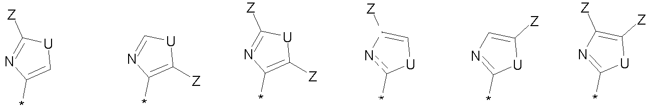 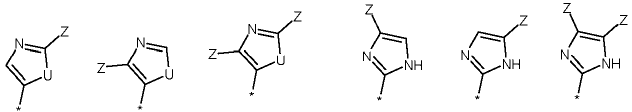 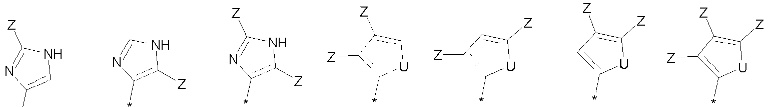 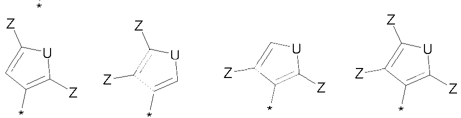
* désignant la fixation au composé de la formule générale I,
U étant choisi dans le groupe constitué de O, S et NR19, R19 étant choisi dans le groupe constitué de H, halogène, alkyle, alkyle fluoré, alkyle partiellement fluoré, alcoxy, alcényle, aryle et hétéroaryle, U étant de manière préférée O ou S, et Z étant choisi indépendamment dans le groupe constitué de H, halogène, de manière préférée F, CF3, CN, alkyle, alkyle fluoré, alkyle partiellement fluoré, alcényle, alcoxy, n-alkyle, Nalkyl2, aryle et hétéroaryle,
R3 et R6 étant de manière préférée identiques.

7. Composé chimique selon l'une des revendications précédentes, R3 et/ou R6 étant en outre annelés, et/ou R1 étant un cycle à 5 ou 6 éléments monocyclique.

8. Composé chimique selon l'une des revendications précédentes, R2 et R7 étant choisis indépendamment dans le groupe constitué de H, halogène, CN et alkyle en C1-C4, de manière préférée R2 et R7 étant H, et/ou R4 et R5 étant choisis indépendamment l'un de l'autre dans le groupe constitué de H, halogène, CN, et alkyle en C1-C4, de manière préférée R4 et R5 étant H.

9. Composé chimique selon l'une des revendications précédentes, R1 étant un cycle à 5 ou 6 éléments hétérocyclique avec au moins un atome d'azote soumis à une hybridation sp2 avec une paire d'électrons libres dans le système cyclique, de manière préférée R1 étant choisi dans le groupe constitué de imidazole, pyrazole, triazole, tétrazole, pyridine, pyrimidine, pyrazine, pyridazine, triazine, oxazole, isoxazole, thiazole et isothiazole substitués ou non substitués.

10. Composé chimique selon l'une des revendications précédentes, le composé étant choisi dans le groupe constitué de :

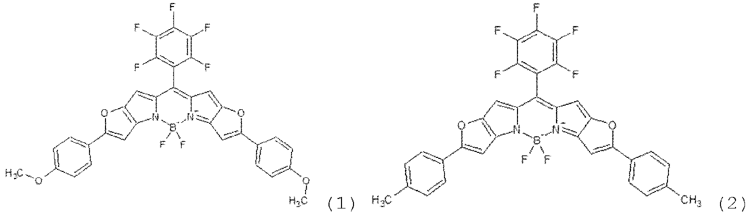

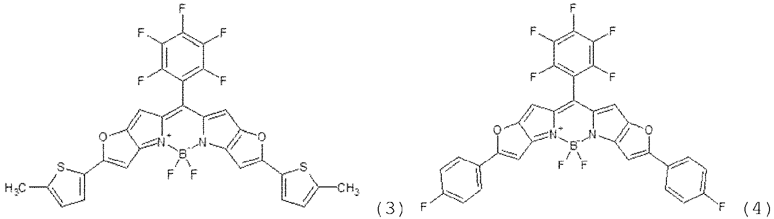

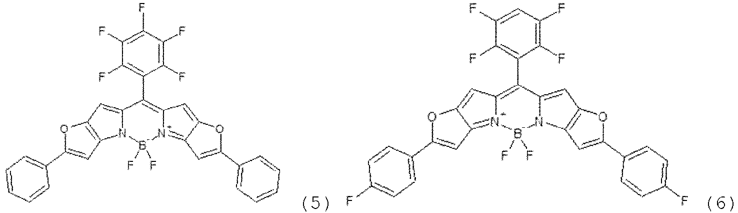

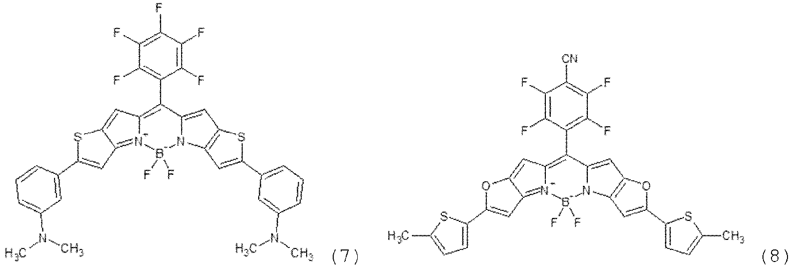

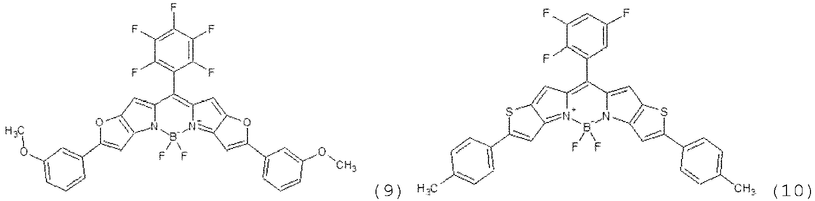

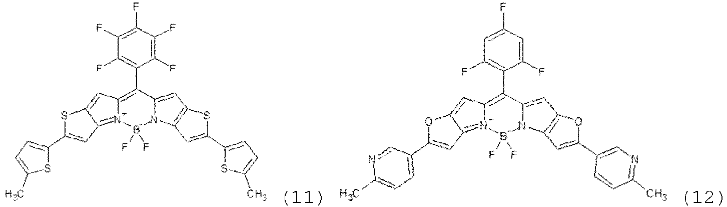

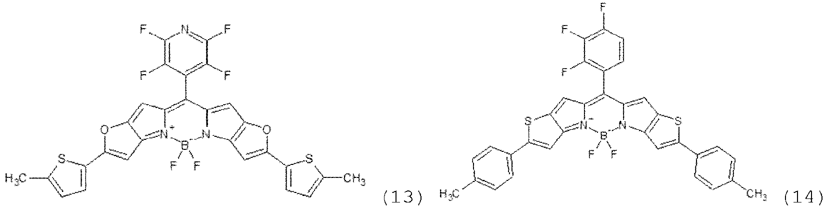

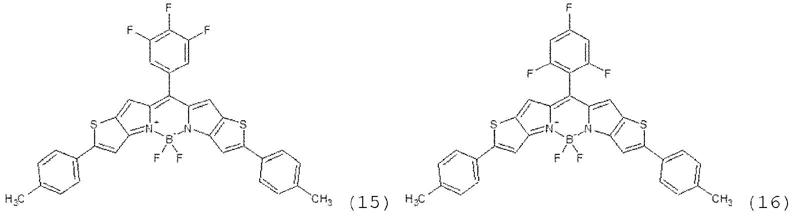

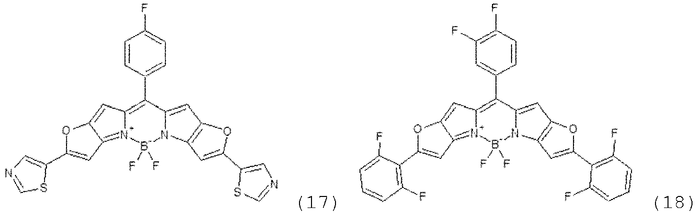

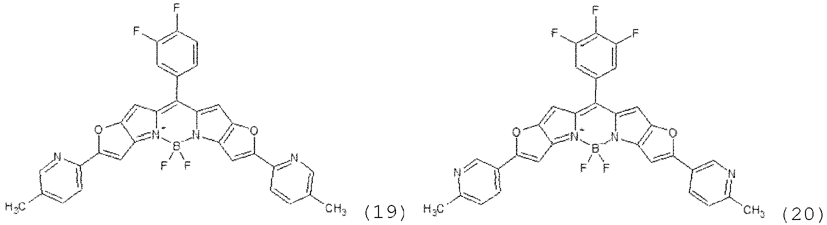

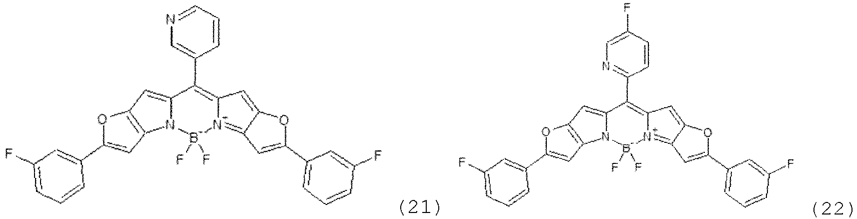

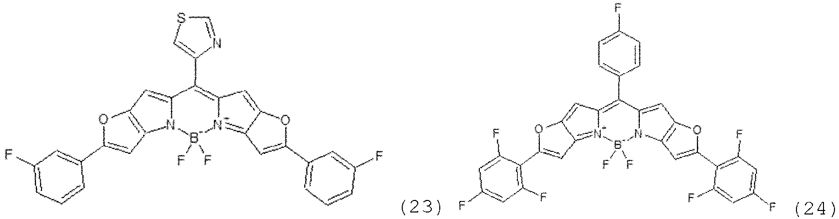

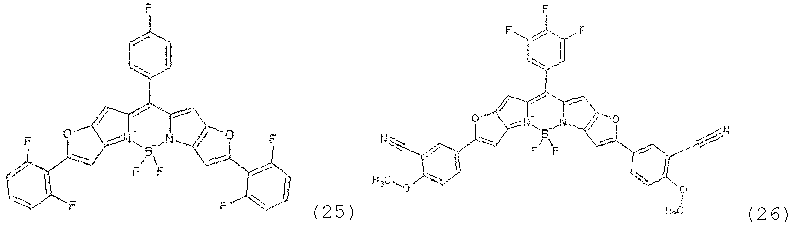

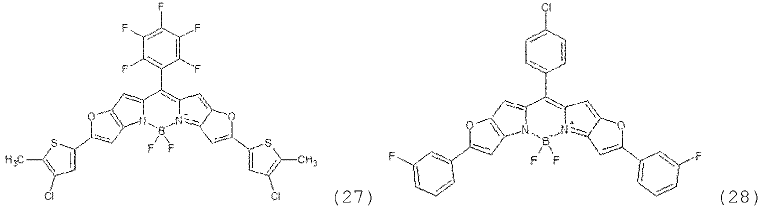

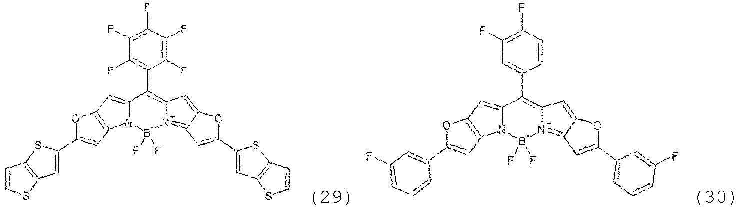

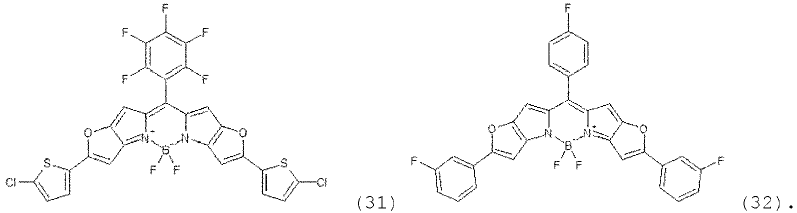

11. Composé chimique selon l'une des revendications précédentes, tous les atomes d'hydrogène dans R1 étant substitués par un halogène ou CN, de manière préférée tous les atomes d'hydrogène étant substitués par F.

12. Composé chimique selon l'une des revendications précédentes, le composé présentant un poids molaire de 300-1500 g/mol.

13. Utilisation d'au moins un composé selon l'une des revendications 1 à 12 dans un composant optoélectronique, de manière préférée un composant optoélectronique organique, de manière particulièrement préférée une cellule solaire organique, une OLED, un OFET ou un photodétecteur organique.

14. Composant optoélectronique avec un système de couches, au moins une couche du système de couches comportant un composé selon l'une des revendications 1 à 12, le composant optoélectronique étant de manière préférée un composant optoélectronique organique, de manière particulièrement préférée une cellule solaire organique, un OFET, une OLED ou un photodétecteur organique.

15. Composant optoélectronique selon la revendication 14, le composant optoélectronique comportant un système de couches avec au moins une couche photoactive, de manière préférée une couche photoactive absorbant la lumière, l'au moins une couche photoactive comportant l'au moins un composé selon l'une des revendications 1 à 12.
